# EUROPEAN PATENT APPLICATION

(11) **EP 4 746 122 A1**
(43) Date of publication of application: **20.05.2026**
(21) Application number: 24857687.8
(22) Date of filing: 06.03.2024
(51) Int. Cl.: H01M 10/613, H01M 10/615, H01M 10/627

(54) **ENERGY STORAGE DEVICE, PHOTOVOLTAIC-ENERGY STORAGE SYSTEM, AND CHARGING NETWORK**

(30) Priority: 25.08.2023 CN 202311086505
(71) Applicant: Huawei Digital Power Technologies Co., Ltd., Shenzhen, Guangdong 518043 (CN)
(72) Inventor: LI, Malin, Shenzhen, Guangdong 518043 (CN); LI, Quanming, Shenzhen, Guangdong 518043 (CN)
(74) Representative: Gill Jennings & Every LLP
(86) International application number: PCT/CN2024/080377
(87) International publication number: WO 2025/044133

(57) **Abstract**

This application provides an energy storage device, a photovoltaic energy storage system, and a charging network, and relates to the field of energy technologies. The energy storage device includes a heat management module, a battery module, a power module, and a heat sink module. The heat management module includes a housing, and a valve body assembly, a first evaporator, and a condenser that are disposed in the housing. The housing includes a plurality of coolant interfaces. Two coolant ports of the first evaporator are connected to the valve body assembly, and two coolant ports of the condenser are connected between the valve body assembly and one coolant interface. The battery module includes a first heat exchange plate, the power module includes a second heat exchange plate, and the heat sink module includes a heat sink. The first heat exchange plate, the second heat exchange plate, and the heat sink are connected to the valve body assembly through corresponding coolant interfaces. The energy storage device can efficiently regulate and control a temperature of a battery, thereby improving operating reliability of a photovoltaic energy storage system and a charging network in which the energy storage device is used.

## Description

### CROSS-REFERENCE TO RELATED APPLICATIONS

This application claims priority to Chinese Patent Application No. 202311086505.X, filed with the China National Intellectual Property Administration on August 25, 2023 and entitled "ENERGY STORAGE DEVICE, PHOTOVOLTAIC ENERGY STORAGE SYSTEM, AND CHARGING NETWORK", which is incorporated herein by reference in its entirety.

### TECHNICAL FIELD

This application relates to the field of energy technologies, and in particular, to an energy storage device, a photovoltaic energy storage system, and a charging network.

### BACKGROUND

With continuous development and wide application of clean energy, an energy storage device that can store electric energy starts to be widely used in a plurality of fields. Currently, there are more large energy storage devices of a cabinet level or a container level, to accommodate more batteries, so as to improve an electric energy storage capability of the energy storage device.

A plurality of batteries in the energy storage device are connected in series and parallel, and are disposed in a box of the energy storage device, so that the box effectively protects the batteries. During actual use, it needs to be ensured that the battery is in a normal temperature range, so as to ensure charging and discharging performance and use safety of the battery. In view of this, a heat dissipation system is usually disposed for a battery in the energy storage device, to regulate and control a temperature of the battery. However, efficiency of a heat dissipation system using a conventional air cooling manner is low, and the heat dissipation system cannot meet a requirement of a current energy storage device for efficiency of regulating and controlling a temperature of a battery.

### SUMMARY

This application provides an energy storage device capable of efficiently regulating and controlling of a temperature of a battery, a photovoltaic energy storage system, and a charging network.

According to a first aspect, this application provides an energy storage device. The energy storage device may include a heat management module, a battery module, a power module, and a heat sink module. The heat management module includes a housing, and a valve body assembly, a first evaporator, and a condenser that are disposed in the housing. The housing includes a plurality of coolant interfaces. Two coolant ports of the first evaporator are connected to the valve body assembly, and two coolant ports of the condenser are connected between the valve body assembly and one coolant interface. Therefore, coolant paths between the evaporator and another module, and between the condenser and another module may be connected or disconnected via the valve body assembly according to a specific operating mode requirement of the energy storage device. The battery module includes a first heat exchange plate, and the first heat exchange plate is connected to the valve body assembly through two coolant interfaces. In addition, the power module includes a second heat exchange plate, and the second heat exchange plate is connected to the valve body assembly through two coolant interfaces. It should be noted that, in this application, the two coolant interfaces connected to the second heat exchange plate are different from the two coolant interfaces connected to the first heat exchange plate, or the second heat exchange plate and the first heat exchange plate are connected in series between two coolant interfaces. The heat sink module includes a heat sink, the heat sink is connected to the valve body assembly through two coolant interfaces, the two coolant interfaces connected to the heat sink are different from the two coolant interfaces connected to the first heat exchange plate, and are different from the two coolant interfaces connected to the second heat exchange plate, so that the first heat sink, the first heat exchange plate, and the second heat exchange plate are all connected to a coolant circulation loop of the heat management module through coolant interfaces. In the energy storage device provided in this application, structures of the heat management module are integrated into one housing, so that an integration level of the heat management module can be effectively improved. This facilitates a connection between the heat management module and another module, and reduces a pipeline for connecting the heat management module to the another module, thereby helping reduce costs of the energy storage device. In addition, in an operating process of the energy storage device, a corresponding coolant interface and a coolant path between the corresponding coolant interface and the evaporator or condenser may be connected or disconnected via the valve body assembly, to perform, in any mode, heat exchange with the first heat exchange plate by circulating a coolant, so that efficiency of regulating and controlling a temperature of the first heat exchange plate can be effectively improved, and efficiency of regulating and controlling a temperature of a battery in the battery module can be further improved. This helps improve operating reliability of the energy storage device.

In a possible implementation of this application, a heat management system further includes a first throttle valve, and the first throttle valve is disposed in the housing. The energy storage device further includes a compressor. The compressor may be disposed in the housing. This helps improve an integration level of the energy storage device. Alternatively, the compressor may be disposed outside the housing. The housing further includes two refrigerant interfaces, and the compressor is connected between the two refrigerant interfaces. This improves flexibility of a disposing position of the compressor. In addition, the compressor, the first evaporator, the first throttle valve, and the condenser are sequentially connected to form a refrigerant circulation loop. The refrigerant circulation loop may exchange heat with the first heat exchange plate by exchanging heat with a coolant flowing through the first evaporator or the condenser, to regulate and control the temperature of the battery.

In a possible implementation of this application, the heat management module further includes a dehumidification module, and the dehumidification module is disposed in the housing, or the dehumidification module is disposed outside the housing. The dehumidification module includes a second evaporator and a second throttle valve. The compressor, the second evaporator, the second throttle valve, and the condenser are sequentially connected to form another refrigerant circulation loop in the energy storage device. Because a temperature of the second evaporator is low when a refrigerant circulates in the circulation loop, water vapor in air condenses into water drops when ambient humidity is high and the temperature of the second evaporator is lower than a dew point temperature of the air, and the water drops are discharged through a drainpipe, so as to reduce humidity in the energy storage device. In addition, because the temperature of the second evaporator is low, the second evaporator may further reduce a temperature of air in the energy storage device, so that the battery is in a low temperature environment.

In a possible implementation of this application, the energy storage device further includes a bypass valve, and the bypass valve and the compressor are disposed in parallel. In this way, when the compressor is in a heating state, the bypass valve is in an on state to reduce pressure of the compressor, to heat the battery through heat generated by the compressor. When the compressor is in a refrigerating state, the bypass valve is in an off state. When the heat generated by the compressor can meet a heating requirement of the battery, a heating component in the energy storage device may be removed. This helps improve energy efficiency of the energy storage device.

In a possible implementation of this application, the valve body assembly is connected between the first heat exchange plate and the first evaporator, and is configured to connect or disconnect a path between the first heat exchange plate and the first evaporator. In this case, when the energy storage device operates in a high-temperature mode, the valve body assembly may connect the path between the first heat exchange plate and the first evaporator, to cool the first heat exchange plate via the first evaporator, so as to dissipate heat for the battery.

In a possible implementation of this application, the valve body assembly is further connected between the first heat exchange plate and the heat sink, and is configured to connect or disconnect a path between the first heat exchange plate and the heat sink. In this case, when the energy storage device operates in a temperate-temperature mode, the valve body assembly may connect the path between the first heat exchange plate and the heat sink, to cool the first heat exchange plate via the heat sink, so as to dissipate heat for the battery.

In a possible implementation of this application, the valve body assembly is further connected between the first heat exchange plate and the second heat exchange plate, and is configured to connect or disconnect a path between the first heat exchange plate and the second heat exchange plate. When the energy storage device operates in a low-temperature mode, the valve body assembly may connect the path between the first heat exchange plate and the second heat exchange plate, to heat the first heat exchange plate through heat generated by a power circuit, so as to recycle heat.

In a possible implementation of this application, the valve body assembly is further connected between the first heat exchange plate and the condenser, and is configured to connect or disconnect a path between the first heat exchange plate and the condenser. In this case, the path between the first heat exchange plate and the condenser may be connected via the valve body assembly, to heat the first heat exchange plate through heat generated by the condenser, so that the energy storage device operates in a heat pump mode.

In a possible implementation of this application, the valve body assembly is further connected between the second heat exchange plate and the heat sink, and is configured to connect or disconnect a path between the second heat exchange plate and the heat sink. When the valve body assembly connects the path between the second heat exchange plate and the heat sink, the second heat exchange plate may be cooled via the heat sink, to dissipate heat of the power circuit.

In a possible implementation of this application, the valve body assembly is further connected between the heat sink and the condenser, and is configured to connect or disconnect a path between the heat sink and the condenser. When the valve body assembly connects the path between the heat sink and the condenser, the condenser may be cooled via the heat sink.

In a possible implementation of this application, the heat management module further includes an electric heater, and the electric heater may be connected in series to a path connected to the first heat exchange plate. In this way, when the energy storage device operates in a low-temperature environment, the electric heater may be configured to heat a coolant flowing through the first heat exchange plate, so that the first heat exchange plate can be heated, thereby increasing the temperature of the battery.

In a possible implementation of this application, the valve body assembly may include one valve body, the valve body may include a plurality of valve interfaces, and each valve interface may be configured to connect to the first evaporator, the condenser, or at least one coolant interface. Therefore, a path between coolant interfaces or a path between each coolant interface and the first evaporator or the condenser may be connected or disconnected via the valve body, so that the energy storage device may operate in a plurality of different modes.

In a possible implementation of this application, the valve body assembly includes at least two valve bodies, each valve body includes a plurality of valve interfaces, and each valve interface is configured to connect to the first evaporator, the condenser, or at least one coolant interface. Therefore, a path between coolant interfaces or a path between each coolant interface and the first evaporator or the condenser may be connected or disconnected via the at least two valve bodies, so that the energy storage device may operate in a plurality of different modes.

According to a second aspect, this application further provides a photovoltaic energy storage system that may include power generation equipment, power conversion equipment, and the energy storage device according to the first aspect. The power conversion equipment is connected between the power generation equipment and the energy storage device. The power generation equipment is configured to store generated electric energy into a battery of the energy storage device via the power conversion equipment. The foregoing energy storage device is used, so that operating reliability of the photovoltaic energy storage system can be effectively improved.

According to a third aspect, this application further provides a charging network that may include a charging pile and the energy storage device according to the first aspect. The charging pile is electrically connected to the energy storage device, and the energy storage device is configured to supply electric energy to the charging pile. The foregoing energy storage device is used, so that operating reliability of the charging network can be effectively improved.

### BRIEF DESCRIPTION OF DRAWINGS

FIG. 1 is a structural block diagram of an energy storage device according to an embodiment of this application;
FIG. 2a is a brief diagram of a structure of an energy storage device according to an embodiment of this application;
FIG. 2b is a brief diagram of another structure of an energy storage device according to an embodiment of this application;
FIG. 3 is a diagram of a specific structure of an energy storage device according to an embodiment of this application;
FIG. 4 is a diagram of an operating mode of the energy storage device shown in FIG. 3;
FIG. 5 is a diagram of another operating mode of the energy storage device shown in FIG. 3;
FIG. 6 is a diagram of another operating mode of the energy storage device shown in FIG. 3;
FIG. 7 is a diagram of another operating mode of the energy storage device shown in FIG. 3;
FIG. 8 is a diagram of another operating mode of the energy storage device shown in FIG. 3;
FIG. 9 is a diagram of another specific structure of an energy storage device according to an embodiment of this application;
FIG. 10 is a diagram of another specific structure of an energy storage device according to an embodiment of this application;
FIG. 11 is a diagram of another specific structure of an energy storage device according to an embodiment of this application;
FIG. 12 is a diagram of another specific structure of an energy storage device according to an embodiment of this application;
FIG. 13 is a diagram of an operating mode of the energy storage device shown in FIG. 12;
FIG. 14 is a diagram of another operating mode of the energy storage device shown in FIG. 12;
FIG. 15 is a diagram of another operating mode of the energy storage device shown in FIG. 12;
FIG. 16 is a diagram of another specific structure of an energy storage device according to an embodiment of this application;
FIG. 17 is a diagram of an operating mode of the energy storage device shown in FIG. 16;
FIG. 18 is a diagram of another operating mode of the energy storage device shown in FIG. 16;
FIG. 19 is a diagram of another operating mode of the energy storage device shown in FIG. 16;
FIG. 20 is a diagram of another operating mode of the energy storage device shown in FIG. 16;
FIG. 21 is a diagram of another operating mode of the energy storage device shown in FIG. 16;
FIG. 22 is a diagram of another specific structure of an energy storage device according to an embodiment of this application;
FIG. 23 is a diagram of another specific structure of an energy storage device according to an embodiment of this application;
FIG. 24 is a diagram of another specific structure of an energy storage device according to an embodiment of this application;
FIG. 25 is a diagram of another specific structure of an energy storage device according to an embodiment of this application;
FIG. 26 is a diagram of another specific structure of an energy storage device according to an embodiment of this application;
FIG. 27 is a diagram of another specific structure of an energy storage device according to an embodiment of this application;
FIG. 28 is a diagram of another specific structure of an energy storage device according to an embodiment of this application;
FIG. 29 is a diagram of another specific structure of an energy storage device according to an embodiment of this application;
FIG. 30 is a diagram of an operating mode of the energy storage device shown in FIG. 29;
FIG. 31 is a diagram of another operating mode of the energy storage device shown in FIG. 29;
FIG. 32 is a diagram of another operating mode of the energy storage device shown in FIG. 29;
FIG. 33a is a diagram of another operating mode of the energy storage device shown in FIG. 29;
FIG. 33b is a diagram of another operating mode of the energy storage device shown in FIG. 29;
FIG. 34 is a diagram of another operating mode of the energy storage device shown in FIG. 29;
FIG. 35 is a diagram of another specific structure of an energy storage device according to an embodiment of this application;
FIG. 36 is a diagram of another specific structure of an energy storage device according to an embodiment of this application;
FIG. 37 is a diagram of another specific structure of an energy storage device according to an embodiment of this application;
FIG. 38 is a diagram of another specific structure of an energy storage device according to an embodiment of this application;
FIG. 39 is a diagram of an operating mode of the energy storage device shown in FIG. 38;
FIG. 40 is a diagram of another operating mode of the energy storage device shown in FIG. 38;
FIG. 41 is a diagram of another operating mode of the energy storage device shown in FIG. 38;
FIG. 42a is a diagram of another operating mode of the energy storage device shown in FIG. 38;
FIG. 42b is a diagram of another operating mode of the energy storage device shown in FIG. 38;
FIG. 43 is a diagram of another operating mode of the energy storage device shown in FIG. 38;
FIG. 44 is a diagram of another specific structure of an energy storage device according to an embodiment of this application;
FIG. 45 is a diagram of another specific structure of an energy storage device according to an embodiment of this application;
FIG. 46 is a diagram of another specific structure of an energy storage device according to an embodiment of this application;
FIG. 47 is a diagram of another specific structure of an energy storage device according to an embodiment of this application;
FIG. 48 is a diagram of an operating mode of the energy storage device shown in FIG. 47;
FIG. 49 is a diagram of another operating mode of the energy storage device shown in FIG. 47;
FIG. 50 is a diagram of another operating mode of the energy storage device shown in FIG. 47;
FIG. 51a is a diagram of another operating mode of the energy storage device shown in FIG. 47;
FIG. 51b is a diagram of another operating mode of the energy storage device shown in FIG. 47;
FIG. 52 is a diagram of another operating mode of the energy storage device shown in FIG. 47;
FIG. 53 is a diagram of another specific structure of an energy storage device according to an embodiment of this application;
FIG. 54 is a diagram of another specific structure of an energy storage device according to an embodiment of this application;
FIG. 55 is a diagram of another specific structure of an energy storage device according to an embodiment of this application;
FIG. 56 is a diagram of another specific structure of an energy storage device according to an embodiment of this application;
FIG. 57 is a diagram of another specific structure of an energy storage device according to an embodiment of this application;
FIG. 58 is a diagram of another specific structure of an energy storage device according to an embodiment of this application;
FIG. 59 is a diagram of another specific structure of an energy storage device according to an embodiment of this application;
FIG. 60 is a diagram of a structure of a photovoltaic energy storage system according to an embodiment of this application; and
FIG. 61 is a diagram of a structure of a charging network according to an embodiment of this application.

### DESCRIPTION OF EMBODIMENTS

To make the objectives, technical solutions, and advantages of this application clearer, the following further describes embodiments of this application in detail with reference to the accompanying drawings. However, example implementations can be implemented in a plurality of forms, and this application should not be construed as being limited to the implementations described herein. Identical reference numerals in the accompanying drawings denote identical or similar structures. Therefore, repeated description thereof is omitted. Expressions of positions and directions in embodiments of this application are described by using the accompanying drawings as an example. However, changes may also be made as required, and all the changes fall within the protection scope of this application. The accompanying drawings in embodiments of this application are merely used to illustrate a relative position relationship and do not represent an actual scale.

It should be noted that specific details are set forth in the following descriptions for ease of understanding this application. However, embodiments of this application can be implemented in a plurality of manners different from those described herein, and a person skilled in the art can perform similar promotion without departing from the connotation of embodiments of this application. Therefore, this application is not limited to specific implementations disclosed below.

To facilitate understanding of an energy storage device provided in embodiments of this application, the following first describes an application scenario for the energy storage device. The energy storage device provided in embodiments of this application may be used in but is not limited to five types of industrial and commercial energy storage scenarios such as a small industrial and commercial industry (for example, a small factory), a medium industrial and commercial industry, a large industrial and commercial industry, a station of integration of PV + ESS + charger, and a small or medium microgrid (for example, an island), and three types of power station scenarios such as a wind/solar energy storage power station, a grid energy storage power station, and a large microgrid, to store and release electric energy.

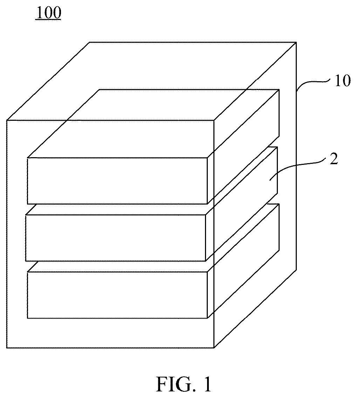

Currently, according to different power consumption requirements of application scenarios, energy storage devices can be classified into module-level energy storage devices, cabinet-level energy storage devices, and container-level energy storage devices. FIG. 1 is a structural block diagram of an energy storage device 100 according to an embodiment of this application. The energy storage device 100 may include a box 10 and a battery module 2 disposed in the box. A battery in the battery module 2 is a basic unit for the energy storage device to store and release electric energy. In charging and discharging processes of the battery, much heat is generated. To ensure charging and discharging performance and use safety of the battery, the battery usually needs to be cooled.

Currently, energy storage devices dissipate heat for batteries mainly in two manners: air cooling and liquid cooling. Because the air cooling mainly relies on air flow to take away heat from a surface of a battery, heat dissipation efficiency of the air cooling is low. In a working condition in which an ambient temperature is high or a battery generates much heat, air cooling heat dissipation cannot meet a heat dissipation requirement of the battery. Liquid cooling heat dissipation mainly relies on a coolant (for example, water) circulating in a coolant pipe to dissipate heat for a battery, and heat dissipation efficiency of the liquid cooling heat dissipation is high. Therefore, currently, more energy storage devices dissipate heat for batteries in the liquid cooling manner.

In view of this, an energy storage device provided in embodiments of this application may dissipate heat for a battery in a liquid cooling heat dissipation manner in a plurality of operating modes, to efficiently regulate and control a temperature of the battery. This helps improve operating energy efficiency of the energy storage device. To make the objectives, technical solutions, and advantages of this application clearer, the following further describes this application in detail with reference to the accompanying drawings and specific embodiments.

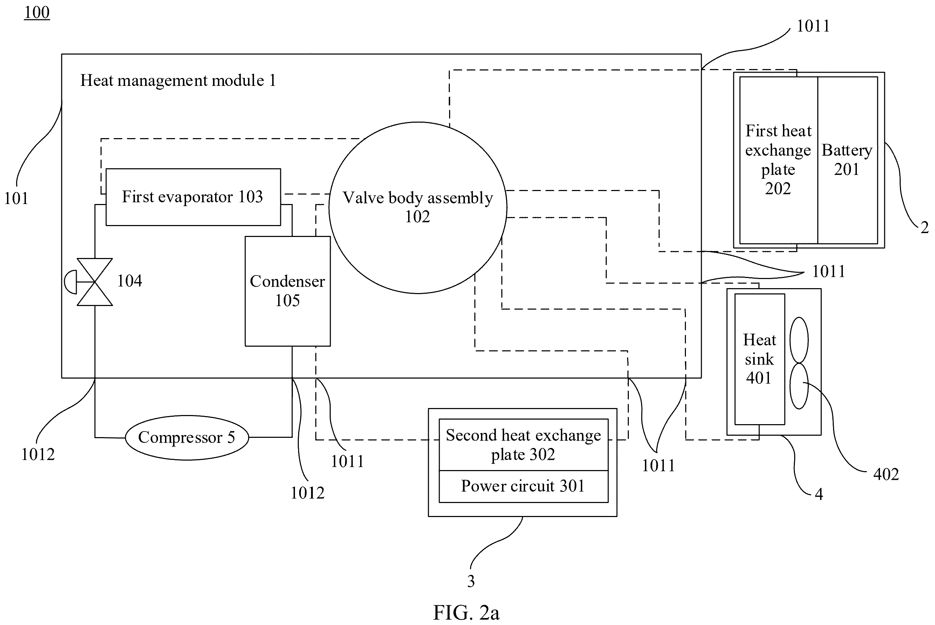

FIG. 2a is a brief diagram of a structure of an energy storage device according to an embodiment of this application. In this application, an energy storage device 100 may include a heat management module 1, a battery module 2, a power module 3, and a heat sink module 4. The heat management module 1 includes a housing 101 and a valve body assembly 102, a first evaporator 103, and a condenser 105 that are disposed in the housing 101. The housing 101 includes a plurality of coolant interfaces 1011. The coolant interface 1011 may be configured to connect to a coolant pipe. The coolant pipe is a pipe used for circulation of a coolant, where the coolant may be but is not limited to water, glycol, or the like.

In the energy storage device 100 provided in this embodiment of this application, two coolant ports of the first evaporator 103 are connected to the valve body assembly 102, and two coolant ports of the condenser 105 are connected between the valve body assembly 102 and one coolant interface 1011. In this case, the valve body assembly 102 may be configured to connect or disconnect coolant paths between the first evaporator 103 and the condenser 105, and other structures.

The battery module 2 includes a battery 201 and a first heat exchange plate 202. The battery 201 is in thermal contact with the first heat exchange plate 202, and the first heat exchange plate 202 is connected to the valve body assembly 102 through two coolant interfaces 1011. During specific implementation, a liquid inlet and a liquid outlet of the first heat exchange plate 202 each are connected to the valve body assembly 102 through one coolant interface 1011. In this case, the valve body assembly 102 may be configured to connect or disconnect a coolant path between the first heat exchange plate 202 and another structure.

It should be noted that, in the energy storage device provided in this embodiment of this application, the first heat exchange plate 202 may be a cooling plate, or may be another type of heat exchanger like an immersion heat exchanger.

The power module 3 includes a power circuit 301 and a second heat exchange plate 302. The power circuit 301 may include a power conversion system (power conversion system, PCS). The power conversion system is connected to the battery 201, and is configured to control a charging or discharging function of the battery 201. The power conversion system may be specifically a direct current-alternating current converter, or may be a direct current-direct current converter. To be specific, the power conversion system may include a direct current-alternating current conversion device, or may include a direct current-direct current conversion device, a control unit, and the like. In specific application, a specific type of the power conversion system may be properly selected according to an actual requirement. This is not limited in this application. In addition, in this embodiment of this application, the power circuit 301 may further include a direct current to direct current (direct current, DCDC) converter and the like.

It should be noted that, in the energy storage device provided in this embodiment of this application, the second heat exchange plate 302 may be a cooling plate, or may be another type of heat exchanger like an immersion heat exchanger. In addition, when both the first heat exchange plate 202 and the second heat exchange plate 302 are immersion evaporators, the first heat exchange plate 202 and the second heat exchange plate 302 may also be disposed in an integrated manner, that is, the battery 201 and the power circuit 301 may be immersed in a same heat exchanger.

The second heat exchange plate 302 is in thermal contact with the power circuit 301, to dissipate heat for the power circuit 301 through circulation of a coolant in the second heat exchange plate 302. When the second heat exchange plate 302 is connected to the heat management module 1, the second heat exchange plate 302 is connected to the valve body assembly 102 through two coolant interfaces 1011. Specifically, a liquid inlet and a liquid outlet of the second heat exchange plate 302 each are connected to the valve body assembly 102 through one coolant interface 1011. In this case, the valve body assembly 102 may be configured to connect or disconnect a coolant path between the second heat exchange plate 302 and another structure. It should be noted that, in the energy storage device 100 shown in FIG. 2a, the two coolant interfaces connected to the second heat exchange plate 302 are different from the two coolant interfaces connected to the first heat exchange plate 202. Therefore, when the second heat exchange plate 302 is connected to the heat management module 1 through the two coolant interfaces 1011, the first heat exchange plate 202 is connected to the heat management module 1 through other two coolant interfaces 1011, to improve flexibility of disposing positions of the first heat exchange plate 202 and the second heat exchange plate 302.

Because the power circuit 301 generates a large amount of heat during operating, when a temperature of the battery 201 is low, the valve body assembly 102 may connect a path between the first heat exchange plate 202 and the second heat exchange plate 302, therefore, the heat generated by the power circuit 301 can be transferred to a surface of the battery 201 through a coolant path between the first heat exchange plate 202 and the second heat exchange plate 302, so that waste heat generated by the power circuit 301 can be properly used, to efficiently use heat.

The heat sink module 4 includes a heat sink 401, and the heat sink 401 is also connected to the valve body assembly 102 through two coolant interfaces 1011. During specific implementation, a liquid inlet and a liquid outlet of the heat sink 401 each are connected to the valve body assembly 102 through one coolant interface 1011. In this case, the valve body assembly 102 may be configured to connect or disconnect a coolant path between the heat sink 401 and another structure. It should be noted that, in the energy storage device 100 shown in FIG. 2a, the two coolant interfaces connected to the heat sink 401 are different from the two coolant interfaces connected to the first heat exchange plate 202, and are different from the two coolant interfaces connected to the second heat exchange plate 302, to improve flexibility of disposing positions of the heat sink 401, the first heat exchange plate 202, and the second heat exchange plate 302.

In this embodiment of this application, when the valve body assembly 102 connects a path between the heat sink 401 and the first heat exchange plate 202, heat of the first heat exchange plate 202 may be transferred to the heat sink 401 through a coolant pipe, so that the heat sink 401 dissipates heat for the battery. When the valve body assembly 102 connects a path between the heat sink 401 and the second heat exchange plate 302, heat of the second heat exchange plate 302 may be transferred to the heat sink 401 through a coolant pipe, so that the heat sink 401 dissipates heat for the power circuit 301, and the power circuit 301 can be in a normal operating temperature range.

In addition, the heat sink module 4 may further include a fan 402. The fan 402 is disposed close to the heat sink 401. The fan 402 may be configured to accelerate a circulation speed of air flowing through the heat sink 401, to improve heat dissipation performance of the heat sink 401.

In the energy storage device 100 shown in FIG. 2a, the heat management module 1 further includes a first throttle valve 104, and the first throttle valve 104 is disposed in the housing 101. In addition, the housing 101 further includes two refrigerant interfaces 1012, and the refrigerant interface 1012 may be configured to connect to a refrigerant pipe. The refrigerant pipe is a pipe used for circulation of a refrigerant, where the refrigerant may be but is not limited to Freon, a liquid ammonia compound, or the like.

In the energy storage device 100 shown in FIG. 2a, the energy storage device 100 further includes a compressor 5. The compressor 5 is disposed outside the housing 101 of the heat management module 1, the compressor 5 is connected between the two refrigerant interfaces 1012, and the compressor 5, the condenser 105, the first throttle valve 104, and the first evaporator 103 are sequentially connected through a refrigerant pipe to form a refrigerant circulation loop.

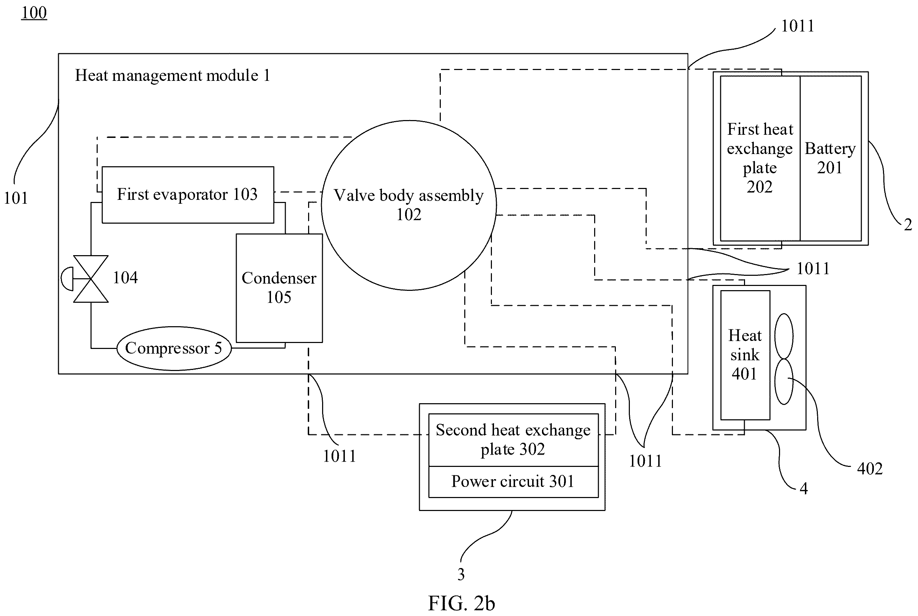

In addition, refer to FIG. 2b. FIG. 2b is a brief diagram of another structure of the energy storage device 100 according to this application. In FIG. 2b, the compressor 5 may be accommodated in the housing 101 of the heat management module 1, and the compressor 5, the condenser 105, the first throttle valve 104, and the first evaporator 103 are still sequentially communicated through the refrigerant pipe to form the refrigerant circulation loop. This helps improve an integration level of the energy storage device 100. Another structure of the energy storage device 100 shown in FIG. 2b may be disposed with reference to the energy storage device 100 shown in FIG. 2a. Details are not described herein again.

Because the energy storage device 100 provided in embodiments of this application has both a loop formed by connecting through a refrigerant pipe and a loop formed by connecting through a coolant pipe, in the accompanying drawings of embodiments of this application, to facilitate differentiation between different pipes, a dashed line is used to indicate a coolant pipe, and a solid line is used to indicate a refrigerant pipe.

In the energy storage device 100 provided in this embodiment of this application, structures of the heat management module 1 are integrated into one housing 101, so that an integration level of the heat management module 1 can be effectively improved. This facilitates a connection between the heat management module 1 and another module, and reduces a pipeline for connecting the heat management module 1 to the another module, thereby helping reduce costs of the energy storage device 100. In addition, in an operating process of the energy storage device 100, connected and disconnected states of different coolant interfaces 1011 may be effectively regulated and controlled via the valve body assembly 102, so that a status of connection between different modules can be flexibly adjusted, and when the energy storage device 100 operates in modes, the temperature of the battery 201 can be regulated and controlled through circulating heat exchange of a coolant between modules communicated through a coolant pipe. This can effectively improve efficiency of regulating and controlling the temperature of the battery 201, thereby helping improve operating energy efficiency of the energy storage device 100.

The foregoing describes a basic design principle of a heat dissipation system architecture of the energy storage device 100 provided in this application. The following describes a specific implementation of the energy storage device 100 and operating modes of the energy storage device 100 in different working conditions with reference to specific embodiments, to facilitate understanding of a manner of regulating and controlling a temperature of the battery 201 in the energy storage device 100.

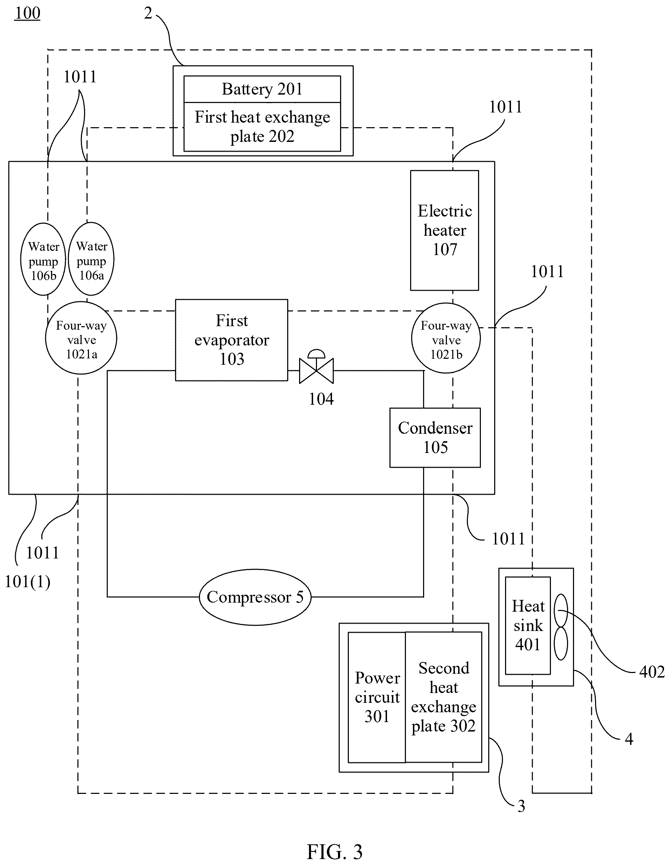

First, refer to FIG. 3. FIG. 3 is a diagram of a specific structure of an energy storage device 100 according to an embodiment of this application. In the energy storage device 100, a valve body assembly 102 of a heat management module 1 includes two four-way valves, and each four-way valve includes four valve interfaces. For ease of differentiation, the two four-way valves may be denoted as a four-way valve 1021a and a four-way valve 1021b respectively. A first evaporator 103 is connected between the four-way valve 1021a and the four-way valve 1021b, and a condenser 105 is connected between the four-way valve 1021b and one coolant interface 1011. Other valve interfaces of the four-way valve 1021a and other valve interfaces of the four-way valve 1021b each are connected to one coolant interface 1011. It should be noted that the two four-way valves are connected to the first evaporator 103 and the condenser 105 through coolant pipes. In this case, the two four-way valves may be configured to connect or disconnect a path between a first heat exchange plate 202, a second heat exchange plate 302, a heat sink 401, the condenser 105, and the first evaporator 103.

In addition, in the embodiment provided in FIG. 3 of this application, the heat management module 1 further includes two water pumps: a water pump 106a and a water pump 106b. The two water pumps may be disposed in a housing 101. The water pump 106a is connected between the first heat exchange plate 202 and the four-way valve 1021a, and is configured to accelerate a circulation speed of a coolant flowing through the first heat exchange plate 202, thereby improving heat exchange efficiency of the first heat exchange plate 202. The water pump 106b is disposed at one end of the heat sink 401, and is configured to accelerate a circulation speed of a coolant flowing through the heat sink 401, thereby improving heat dissipation efficiency of the heat sink 401. It may be understood that, in actual application, disposing positions of the water pump 106a and the water pump 106b may be flexibly set, provided that the water pump 106a can accelerate the circulation speed of the coolant flowing through the first heat exchange plate 202 and the water pump 106b can accelerate the circulation speed of the coolant flowing through the heat sink 401. However, in some possible embodiments, when the water pump 106a and the water pump 106b are located in a same circulation path, one water pump may be selectively removed, to reduce a quantity of used water pumps. Details are not described herein.

As shown in FIG. 3, the heat management module 1 further includes an electric heater 107. The electric heater 107 may be configured to heat the coolant flowing through the first heat exchange plate 202, to improve a temperature a surface of a battery 201. During specific disposing, the electric heater 107 may be connected in series to a path connected to the first heat exchange plate 202. In this case, the electric heater 107 may be disposed at various positions. For example, as shown in FIG. 3, the electric heater 107 may be connected in series to the four-way valve 1021a and a path connected to the first heat exchange plate 202. In another possible embodiment, the electric heater 107 may alternatively be disposed in another position, provided that the electric heater 107 can be communicated with the first heat exchange plate 202.

It should be noted that, in this embodiment of this application, the electric heater 107 may be disposed in the housing 101, to improve an integration level of the heat management module 1. Alternatively, the electric heater 107 may be an independent module disposed outside the housing 101, to improve flexibility of a disposing position of the electric heater 107.

In actual application of the energy storage device 100 provided in this application, different coolant interfaces may be connected or disconnected via the valve body assembly 102, so that the energy storage device 100 can operate in a corresponding operating mode. The following describes several operating modes of the energy storage device 100 provided in FIG. 3 by using examples with reference to the accompanying drawings.

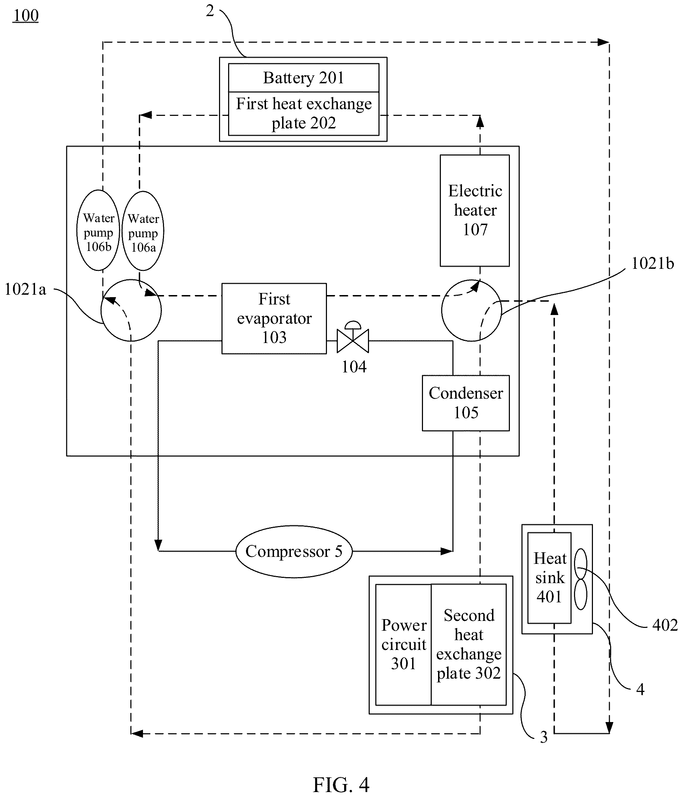

FIG. 4 shows an operating mode of the energy storage device 100 corresponding to a case in which an ambient temperature is high (for example, in case of a high temperature in summer). FIG. 4 shows three circulation loops. The following separately describes the three circulation loops.

A first circulation loop includes a compressor 5, the condenser 105, a first throttle valve 104, and the first evaporator 103 that are sequentially communicated through a refrigerant pipe. In this case, the first circulation loop is a refrigerant circulation loop. In this case, when a refrigerant flows in the circulation loop, the first evaporator 103 may be at a low temperature.

In a second circulation loop, the four-way valve 1021a and the second four-way valve 1021a connect a path between the first heat exchange plate 202 and the first evaporator 103, so that the first heat exchange plate 202, the water pump 106a, the first evaporator 103, and the electric heater 107 are sequentially communicated through a coolant channel. Because a temperature of the first evaporator 103 is low in this case, the first heat exchange plate 202 may be cooled by exchanging heat between a coolant flowing in the circulation loop and the first evaporator 103, to dissipate heat for the battery 201.

In a third circulation loop, the four-way valve 1021a and the four-way valve 1021b connect a path between the second heat exchange plate 302 and the heat sink 401, so that the second heat exchange plate 302, the water pump 106b, the heat sink 401, and the condenser 105 are sequentially communicated through a coolant channel. In this case, when a coolant flows in the circulation loop, the heat sink 401 may cool the coolant, to cool the second heat exchange plate 302, so as to dissipate heat for the power circuit 301. In addition, because the condenser 105 is also connected in series in the circulation loop, the heat sink 401 may also be configured to cool the condenser 105.

It should be noted that, in the operating mode shown in FIG. 4, the electric heater 107 is in an off state.

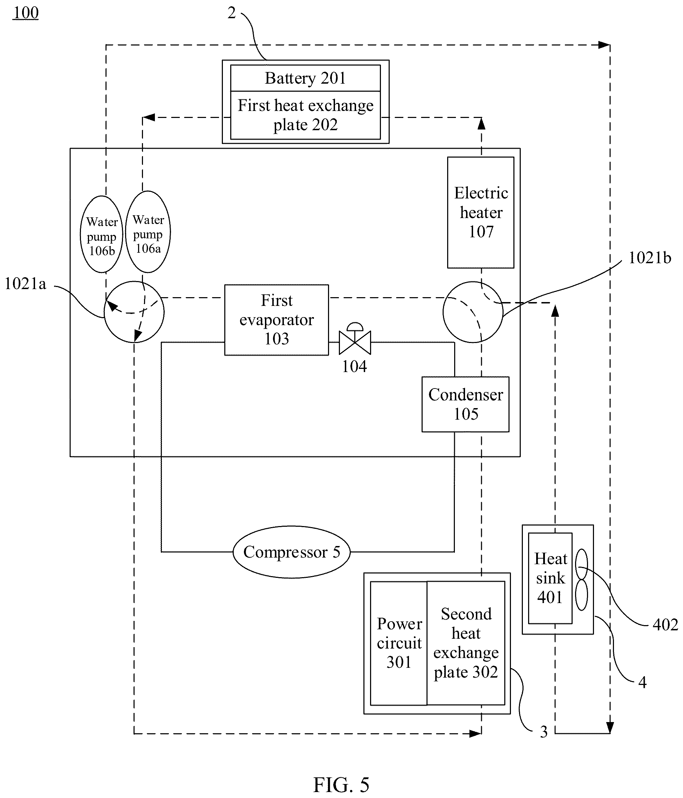

In addition, refer to FIG. 5. FIG. 5 shows an operating mode of the energy storage device 100 corresponding to a case in which an ambient temperature is temperate (for example, in case of spring or autumn).

In this operating mode, the four-way valve 1021a and the four-way valve 1021b connect a coolant path between the first heat exchange plate 202, the second heat exchange plate 302, and the heat sink 401, so that the first heat exchange plate 202, the water pump 106a, the second heat exchange plate 302, the first evaporator 103, the water pump 106b, the heat sink 401, and the electric heater 107 are sequentially communicated through a coolant channel to form a circulation loop. In this case, when a coolant flows in the circulation loop, the heat sink 401 may cool the first heat exchange plate 202 and the second heat exchange plate 302, to dissipate heat for the battery 201 and the power circuit 301.

It should be noted that, in the operating mode shown in FIG. 5, the electric heater 107 is in an off state. In addition, when the ambient temperature is temperate, heat dissipation requirements of the battery 201 and the power circuit 301 can be met only via the heat sink 401. Therefore, in this operating mode, the compressor 5, the first evaporator 103, and the condenser 105 are all in an off state.

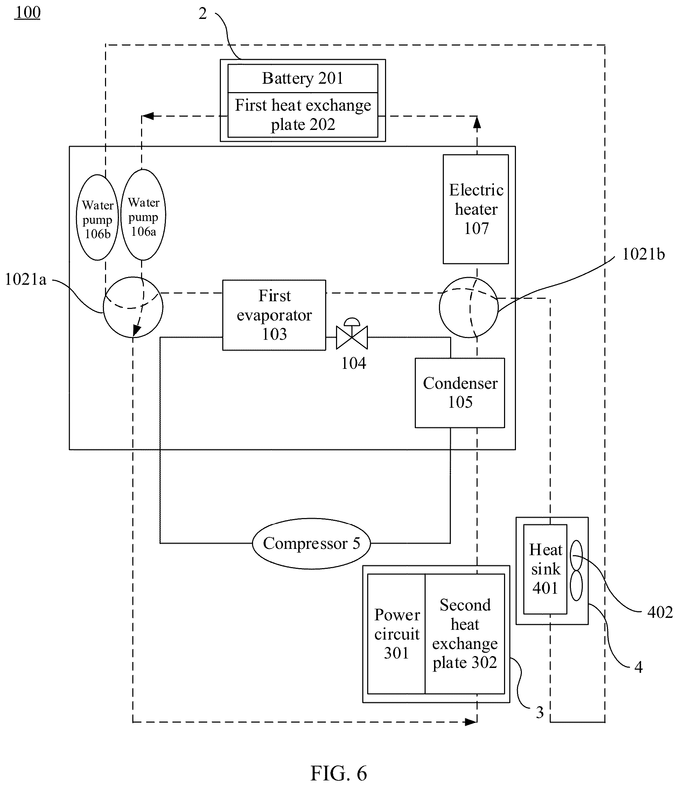

FIG. 6 shows an operating mode of the energy storage device 100 corresponding to a case in which an ambient temperature is low (for example, in case of a low temperature in winter).

In an operating process of the energy storage device 100, the power circuit 301 always generates a large amount of heat. However, in case of a low temperature in winter, to ensure charging and discharging performance of a battery 201, the battery 201 needs to be heated. In view of this, it may be considered that the heat generated by the power circuit 301 is used for heating the battery 201. During specific implementation, as shown in FIG. 6, the four-way valve 1021a and the four-way valve 1021b connect a path between the first heat exchange plate 202 and the second heat exchange plate 302, so that the first heat exchange plate 202, the water pump 106a, the second heat exchange plate 302, the condenser 105, and the electric heater 107 are sequentially communicated through a coolant channel to form a circulation loop. In this case, when a coolant flows in the circulation loop, heat generated by the power circuit 301 may be transferred to the first heat exchange plate 202, to heat the battery 201, so as to efficiently use the heat. In this operating mode, the electric heater 107 may be turned on or off as required. Details are not described herein.

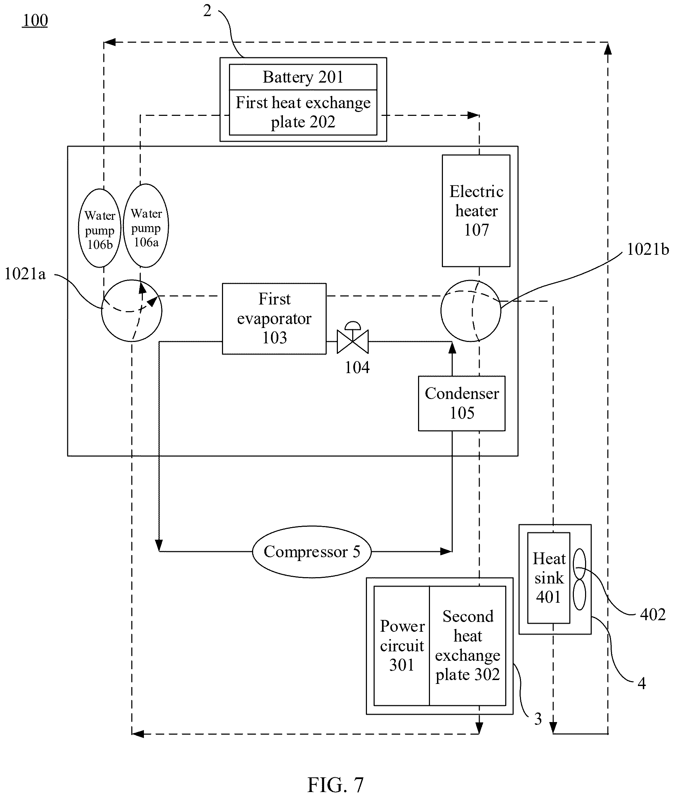

In the operating mode shown in FIG. 6, the compressor 5, the first evaporator 103, and the condenser 105 are all in an off state. In actual application, as shown in FIG. 7, both the first throttle valve 104 and the compressor 5 may be set to an on state as required, that is, the condenser 105 has a high temperature according to a working principle of a heat pump, so that the condenser 105 can heat a coolant flowing in a circulation loop formed by sequentially communicating the first heat exchange plate 202, the electric heater 107, the condenser 105, the second heat exchange plate 302, and the water pump 106a through a coolant channel, and the condenser 105 provides heat energy for the first heat exchange plate 202.

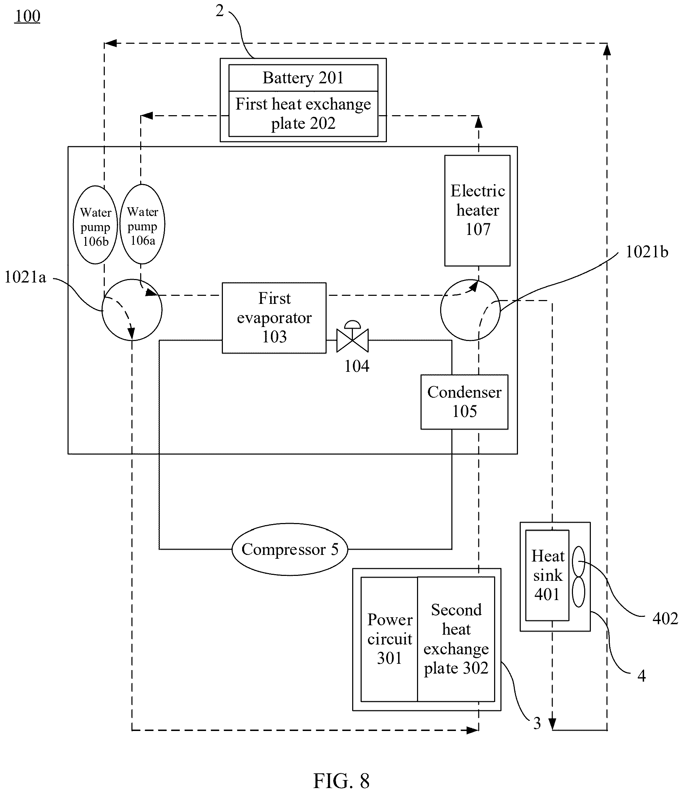

FIG. 8 shows an operating mode of the energy storage device 100 corresponding to a case in which an ambient temperature is low (for example, in case of a low temperature in winter) and neither heat generated by a power circuit 301 nor heat generated by the condenser 105 in a heat pump mode can meet a heating requirement of the battery. In this mode, the electric heater 107 is turned on, and the first heat exchange plate 202, the water pump 106a, the first evaporator 103, and the electric heater 107 are sequentially communicated through a coolant pipe to form a circulation loop, so that the electric heater 107 heats a coolant flowing in the circulation loop, to heat the battery 201.

It should be noted that, in the operating mode shown in FIG. 8, the compressor 5, the first evaporator 103, and the condenser 105 are all in an off state.

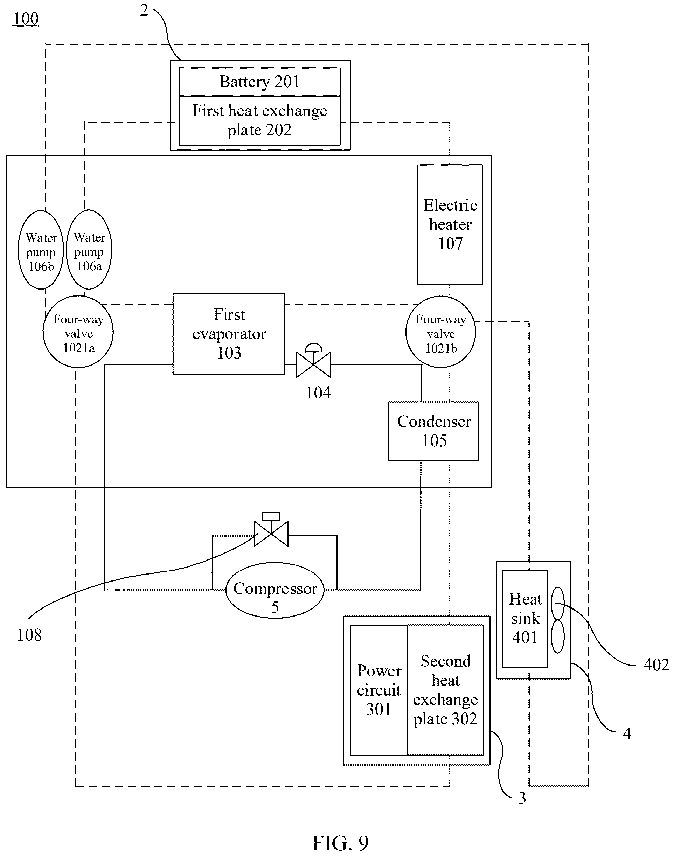

When the energy storage device 100 operates in a working condition with a low ambient temperature, in addition to heating the battery via the electric heater 107, another possible manner may be used. For example, refer to FIG. 9. FIG. 9 is a diagram of another specific structure of an energy storage device 100 according to an embodiment of this application. Compared with the energy storage device 100 shown in FIG. 3, in the energy storage device 100 in FIG. 9, a bypass valve 108 is added to a compressor 5. The bypass valve 108 and the compressor 5 are disposed in parallel. The bypass valve 108 may be, for example, a solenoid valve. In this way, when the compressor 5 is in a heating state, the bypass valve 108 is in an on state, to reduce pressure of the compressor 5, so as to heat a battery 201 through heat generated by the compressor 5. When the compressor 5 is in a refrigerating state, the bypass valve 108 is in an off state. It may be understood that, when the heat generated by the compressor 5 can meet a heating requirement of the battery, an electric heater 107 in the energy storage device 100 may be removed. This helps improve energy efficiency of the energy storage device 100.

For another possible operating mode of the energy storage device 100 provided in FIG. 9, refer to FIG. 4 to FIG. 8. Details are not described herein again.

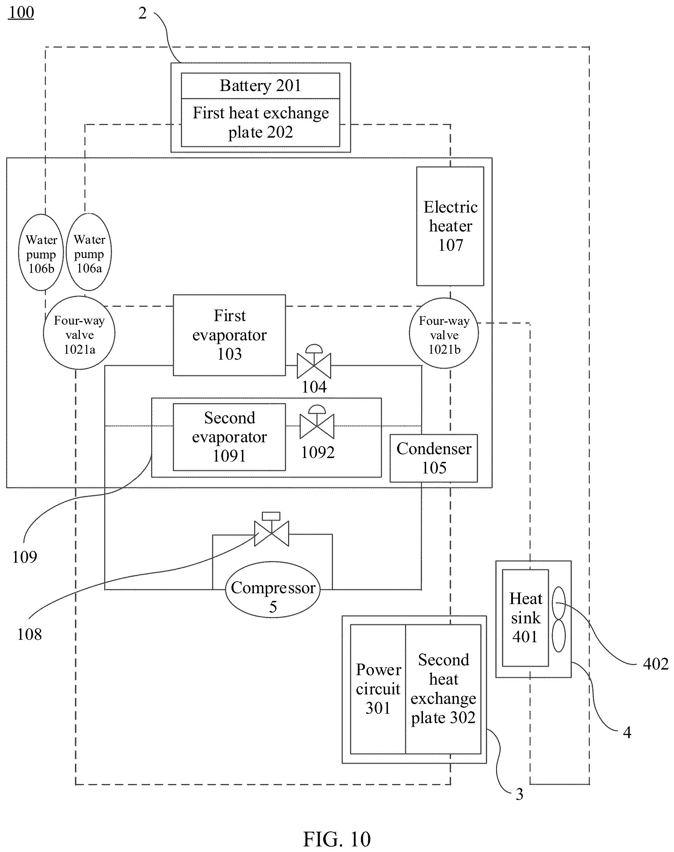

Because water vapor is generated during heat exchanging between modules of the energy storage device 100, it is difficult for the energy storage device 100 based on liquid cooling heat dissipation to discharge the water vapor. Water vapor that exists in the energy storage device 100 for a long time causes corrosion to the battery 201 and a related electronic component, and even an unfavorable condition like a short circuit is caused, thereby affecting safety and a service life of the energy storage device 100. To improve operating safety of the energy storage device 100, a dehumidification module 109 may be disposed in the energy storage device 100. During specific implementation, refer to FIG. 10. FIG. 10 is a diagram of another specific structure of an energy storage device 100 according to an embodiment of this application. As shown in FIG. 10, a heat management module 1 further includes a dehumidification module 109, and the dehumidification module 109 may be located in a housing 101. In some other possible embodiments, the dehumidification module 109 may alternatively be located outside the housing 101. In addition, the dehumidification module 109 includes a second evaporator 1091 and a second throttle valve 1092 that are communicated through a refrigerant pipe.

Still refer to FIG. 10. In the energy storage device 100, a compressor 5, the dehumidification module 109, and a condenser 105 are sequentially communicated through a refrigerant pipe to form a dehumidification circulation loop. Because a temperature of the second evaporator 1091 is low when a refrigerant circulates in the circulation loop formed by the compressor 5, the second evaporator 1091, the second throttle valve 1092, and the condenser 105, water vapor in air condenses into water drops when ambient humidity is high and the temperature of the second evaporator 1091 is lower than a dew point temperature of the air, and the water drops are discharged through a drainpipe, so as to reduce humidity in the energy storage device 100.

Because the temperature of the second evaporator 1091 is low, the second evaporator 1091 may further reduce a temperature of air in the energy storage device 100, so that a battery 201 is in a low temperature environment. In addition, the dehumidification module 109 may further include a fan (not shown in FIG. 10). The fan may be disposed near the second evaporator 1091, to accelerate a circulation speed of air flowing through the second evaporator 1091, so as to reduce the temperature of the second evaporator 1091. This helps improve dehumidification effect of the dehumidification module 109.

In the energy storage device 100 provided in FIG. 10, a circulation loop formed by a first heat exchange plate 202 and a heat sink 401 can effectively reduce a temperature of a surface of the battery 201. In addition, the temperature of the second evaporator 1091 in the dehumidification module 109 is low. Therefore, the temperature of the air in the energy storage device 100 can be further effectively reduced, thereby effectively improving heat dissipation effect on the battery 201. In addition, the second evaporator 1091 in the dehumidification module 109 can further condense water vapor in the energy storage device 100, so that humidity of the air in the energy storage device 100 can be reduced, and the battery 201 can operate in a dry environment. This helps ensure reliability and a service life of the battery 201.

It may be understood that, in the embodiment provided in FIG. 10, a combination of the second evaporator 1091 and the second throttle valve 1092 and a combination of a first evaporator 103 and a first throttle valve 104 are disposed in parallel, so that the two combinations do not affect each other. Specifically, during dehumidification, the second throttle valve 1092 may be turned on and the first throttle valve 104 may be turned off, so that the refrigerant may circulate in a circulation loop formed by the compressor 5, the condenser 105, the second throttle valve 1092, and the second evaporator 1091, and the second evaporator 1091 has a low temperature, to implement a dehumidification function. In addition, both the first throttle valve 104 and the second throttle valve 1092 may be turned on, that is, the refrigerant may circulate in a circulation loop formed by the compressor 5, the condenser 105, the first throttle valve 104, and the first evaporator 103, and may further circulate in the circulation loop formed by the compressor 5, the condenser 105, the second throttle valve 1092, and the second evaporator 1091. Therefore, both the first evaporator 103 and the second evaporator 1091 have a low temperature, that is, a function of cooling the battery 201 can be implemented via the first evaporator 103, and a dehumidification function can be implemented via the second evaporator 1091. Certainly, during specific implementation, the first throttle valve 104 may be turned on and the second throttle valve 1092 may be turned off, so that the refrigerant may circulate in the circulation loop formed by the compressor 5, the condenser 105, the first throttle valve 104, and the first evaporator 103, and the first evaporator 103 has a low temperature, to implement the function of cooling the battery 201.

In summary, in the energy storage device 100 provided in FIG. 10 of this application, the first evaporator 103 and the second evaporator 1091 in the heat management module 1 are decoupled from each other, so that mutual impact between the first evaporator 103 and the second evaporator 1091 can be avoided. In addition, the combination of the first evaporator 103 and the first throttle valve 104 and the combination of the second evaporator 1091 and the second throttle valve 1092 share the same condenser 105 and compressor 5, thereby effectively reducing a quantity of used parts and components. This helps reduce a size and costs of the heat management module 1, and facilitates implementation of an integrated design. Certainly, in another possible embodiment, the first evaporator 103 and the second evaporator 1091 may alternatively be disposed in series, so that the first evaporator 103 and the second evaporator 1091 may share one throttle valve. For example, only the first throttle valve 104 or the second throttle valve 1092 may be disposed, so that a quantity of used parts and components can be reduced. This helps reduce manufacturing costs.

For another possible operating mode of the energy storage device 100 provided in FIG. 10, refer to FIG. 4 to FIG. 9. Details are not described herein again.

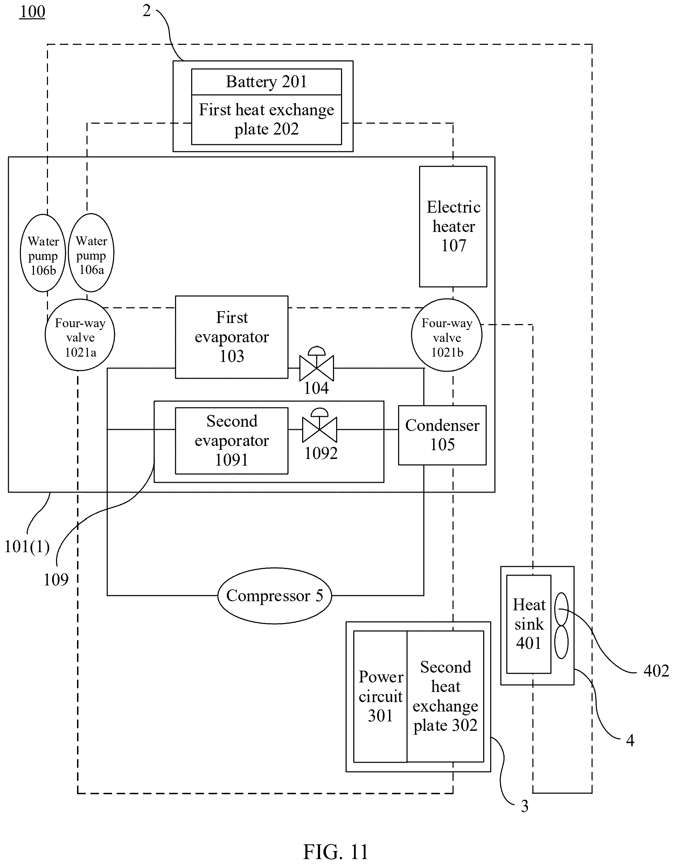

It should be noted that, in this embodiment of this application, the dehumidification module 109 is disposed without depending on bypass of the compressor 5, that is, the dehumidification module 109 and a bypass valve 108 at the compressor 5 may not be disposed together. For example, refer to FIG. 11. In an energy storage device 100 shown in FIG. 11, no bypass valve 108 is disposed at a compressor 5, and a dehumidification module 109 is disposed in a heat management module 1. This can still enable the energy storage device 100 to operate in a plurality of modes, to efficiently regulate and control a temperature of a battery 201. For an operating mode of the energy storage device 100 shown in FIG. 11, refer to FIG. 4 to FIG. 10. Details are not described herein again.

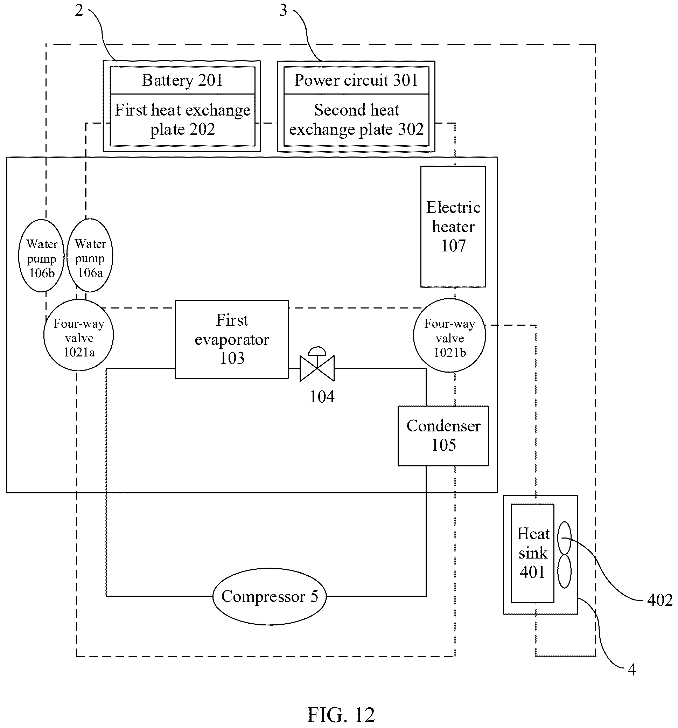

In the foregoing embodiments of this application, the first heat exchange plate 202 of the battery module 2 and the second heat exchange plate 302 of the power module 3 each may be connected to the heat management module 1 through two coolant interfaces 1011. However, in some other possible embodiments of this application, the first heat exchange plate 202 of the battery module 2 and the second heat exchange plate 302 of the power module 3 may be further connected in series between two coolant interfaces 1011. FIG. 12 is a diagram of another structure of an energy storage device according to an embodiment of this application. A combination formed by connecting a first heat exchange plate 202 and a second heat exchange plate 302 in series is connected to two coolant interfaces 1011. This can facilitate cooling of a coolant flowing through the second heat exchange plate 302, thereby facilitating cooling of a power circuit 301, and improving operating reliability of the power circuit 301. In addition, it is further convenient to synchronously regulate and control temperatures of the power circuit 301 and a battery 201. This helps simplify a coolant circulation loop of the energy storage device 100. Another structure of the energy storage device 100 shown in FIG. 12 may be disposed with reference to FIG. 3. Details are not described herein again.

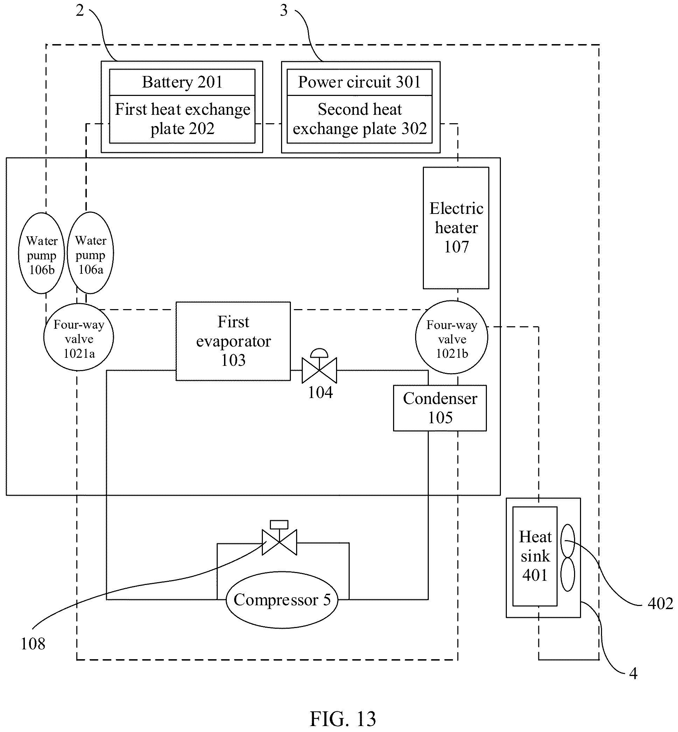

In addition, on the basis of the energy storage device 100 shown in FIG. 12, according to an actual application requirement, a bypass valve 108 may be disposed for a compressor 5 or a dehumidification module 109 may be added. For example, as shown in FIG. 13, compared with the energy storage device shown in FIG. 12, an energy storage device 100 shown in FIG. 13 further includes a bypass valve 108, and the bypass valve 108 and a compressor 5 are disposed in parallel.

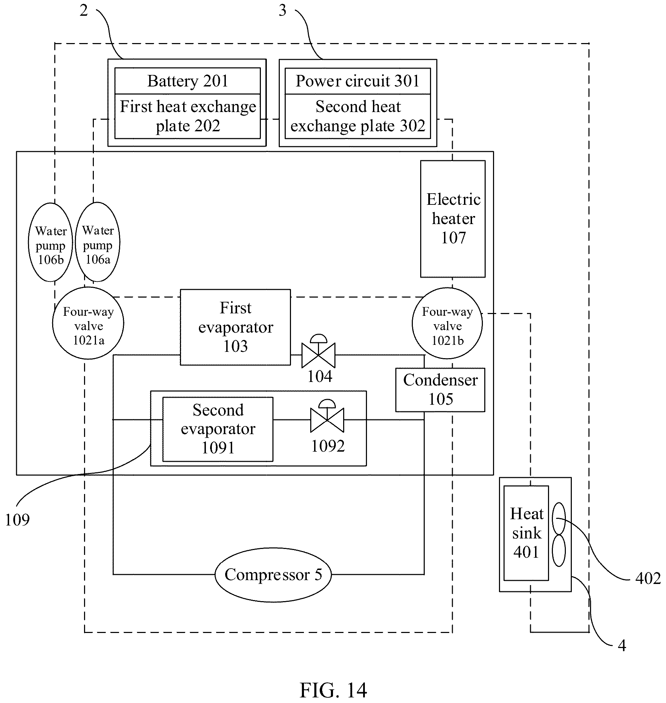

As shown in FIG. 14, compared with the energy storage device shown in FIG. 12, a heat management module 1 of an energy storage device 100 shown in FIG. 14 further includes a dehumidification module 109. The dehumidification module 109 may be disposed with reference to any one of the foregoing embodiments. Details are not described herein again.

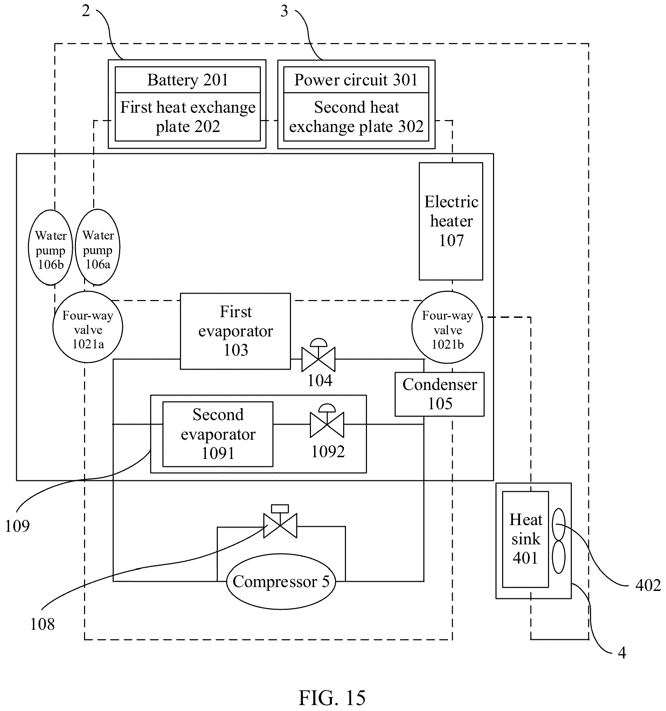

As shown in FIG. 15, compared with the energy storage device shown in FIG. 14, an energy storage device 100 shown in FIG. 15 further includes a bypass valve 108, and a heat management module 1 further includes a dehumidification module 109. The bypass valve 108 and the dehumidification module 109 may be disposed with reference to any one of the foregoing embodiments. Details are not described herein again.

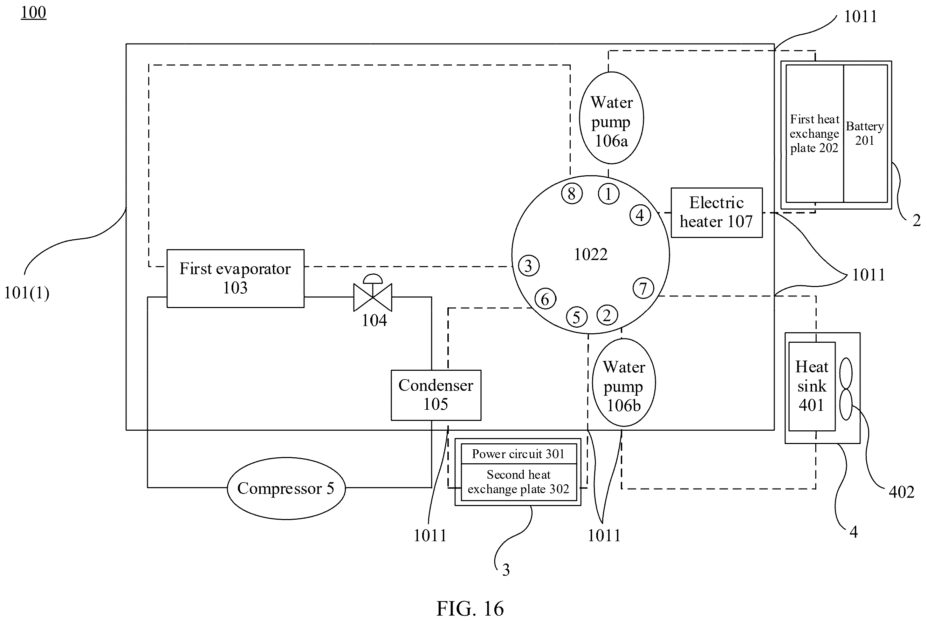

In the energy storage device 100 provided in embodiments of this application, in addition to the foregoing two four-way valves, a function of the valve body assembly 102 in the heat management module 1 may be implemented in another possible manner. For example, FIG. 16 is a diagram of another specific structure of an energy storage device 100 according to an embodiment of this application. In the energy storage device 100, a valve body assembly 102 of a heat management module 1 includes an eight-way valve 1022, and the eight-way valve 1022 includes eight valve interfaces. Each valve interface may be configured to connect to or disconnect from a first evaporator 103, a condenser 105, or at least one coolant interface 1011.

In actual application, a status of connection between different modules may be effectively adjusted via the valve body assembly 102 according to an actual requirement, so that the energy storage device 100 shown in FIG. 16 can operate in a corresponding operating mode.

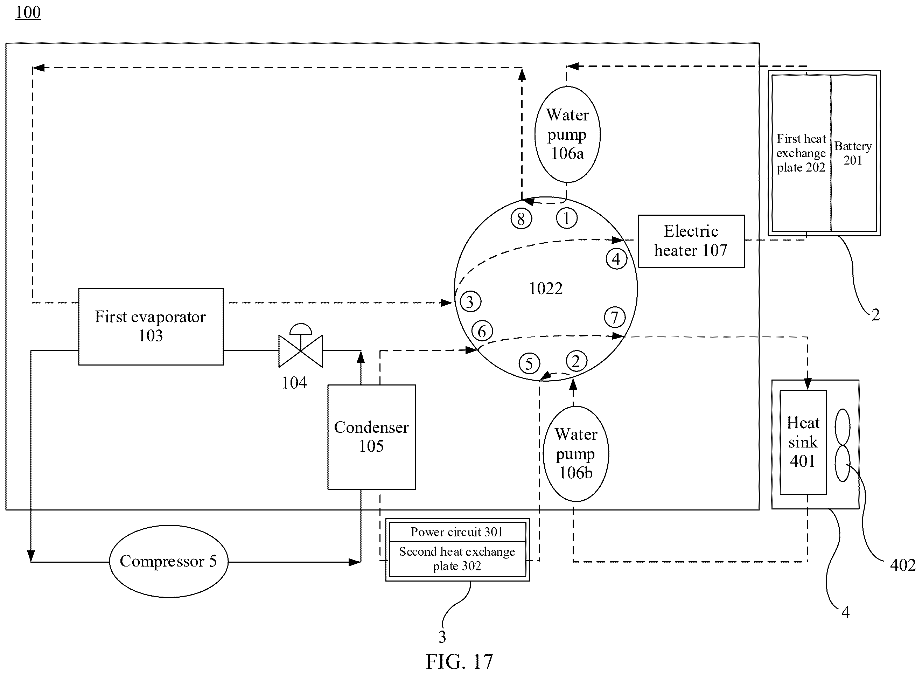

For example, when an ambient temperature is high (for example, in case of a high temperature and high humidity in summer), refer to FIG. 17. FIG. 17 is a diagram of a circulation loop of the energy storage device 100 shown in FIG. 16 in this operating mode. FIG. 17 shows three circulation loops in this operating mode.

A first circulation loop includes a compressor 5, the condenser 105, a first throttle valve 104, and the first evaporator 103 that are sequentially communicated through a refrigerant pipe. In this case, the first circulation loop is a refrigerant circulation loop. In this case, when a refrigerant flows in the circulation loop, the first evaporator 103 may be at a low temperature.

In a second circulation path, the eight-way valve 1022 connects a path between a first heat exchange plate 202 and the first evaporator 103, so that the first heat exchange plate 202, a water pump 106a, the first evaporator 103, and an electric heater 107 are sequentially communicated through a coolant channel. Because a temperature of the first evaporator 103 is low in this case, the first heat exchange plate 202 may be cooled by exchanging heat between a coolant flowing in the circulation loop and the first evaporator 103, to dissipate heat for a battery.

In a third circulation path, the eight-way valve 1022 connects a path between a second heat exchange plate 302, the condenser 105, and a heat sink 401, so that the second heat exchange plate 302, the condenser 105, the heat sink 401, and a water pump 106b are sequentially communicated through a coolant channel. In this case, when a coolant flows in the circulation loop, the heat sink 401 may cool the second heat exchange plate 302, to cool the second heat exchange plate 302, so as to dissipate heat for a battery. In addition, because the condenser 105 is also connected in series in the circulation loop, the heat sink 401 may also be configured to cool the condenser 105.

It should be noted that, in the operating mode shown in FIG. 17, the electric heater 107 is in an off state.

In addition, the first heat exchange plate 202 may also be cooled via the heat sink 401. For example, a valve interface 7 of the eight-way valve 1022 may be connected to a valve interface 4, and a valve interface 1 may be connected to a valve interface 2, to connect a path between the first heat exchange plate 202 and the heat sink 401 via the eight-way valve 1022. In this case, a coolant may flow in a circulation loop in which the first heat exchange plate 202, the water pump 106a, the water pump 106b, and the heat sink 401 are sequentially communicated.

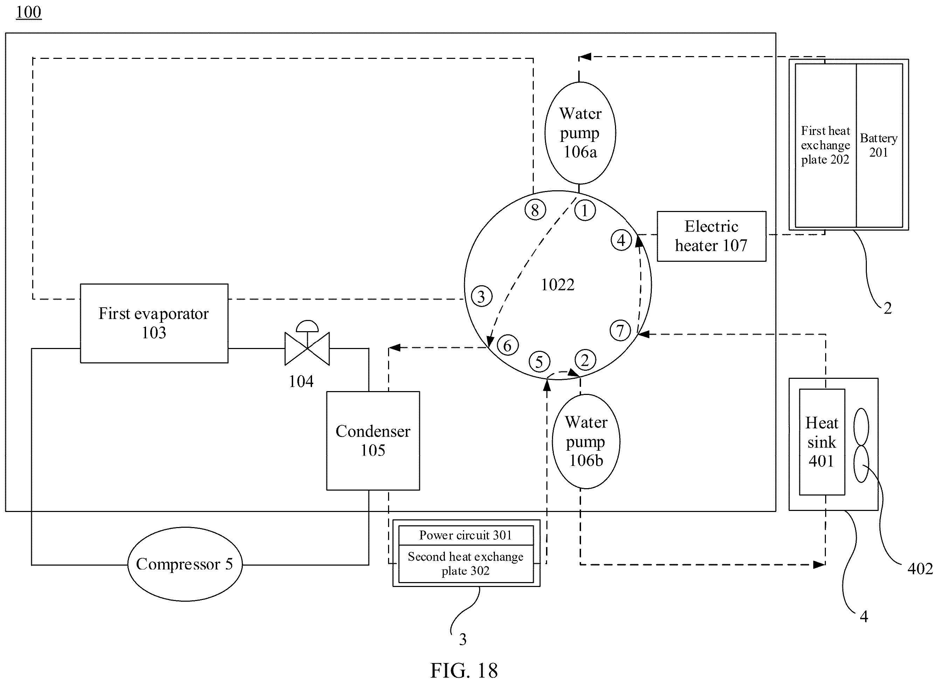

In addition, refer to FIG. 18. FIG. 18 shows an operating mode of the energy storage device 100 corresponding to a case in which an ambient temperature is temperate (for example, in case of spring or autumn).

Specifically, a circulation loop is shown in FIG. 18. The eight-way valve 1022 connects a path between the first heat exchange plate 202, the second heat exchange plate 302, the condenser 105, and the heat sink 401, so that the first heat exchange plate 202, the water pump 106a, the condenser 105, the second heat exchange plate 302, the water pump 106b, the heat sink 401, and the electric heater 107 are sequentially communicated through a coolant channel to form a circulation loop. In this case, when a coolant flows in the circulation loop, the heat sink 401 may cool the first heat exchange plate 202 and the second heat exchange plate 302, to dissipate heat for the battery 201 and a power circuit 301.

It should be noted that, in the operating mode shown in FIG. 18, the electric heater 107 is in an off state. In addition, when the ambient temperature is temperate, heat dissipation requirements of the battery 201 and the power circuit 301 can be met only via the heat sink 401. Therefore, in this operating mode, the compressor 5, the first evaporator 103, and the condenser 105 are all in an off state.

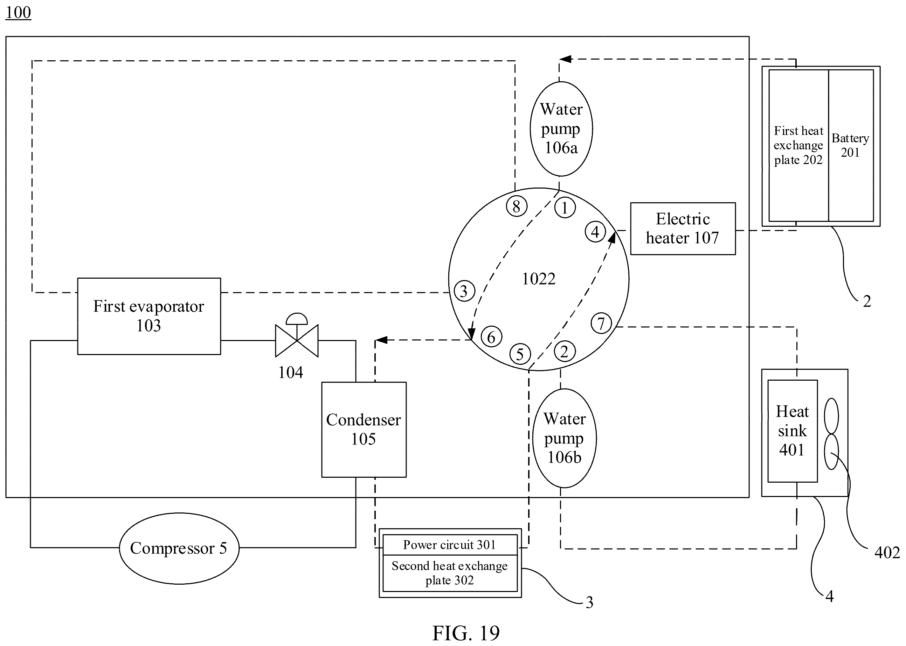

FIG. 19 shows an operating mode of the energy storage device corresponding to a case in which an ambient temperature is low (for example, in case of a low temperature in winter).

In FIG. 19, the eight-way valve 1022 connects a path between the first heat exchange plate 202 and the second heat exchange plate 302, so that the first heat exchange plate 202, the water pump 106a, the second heat exchange plate 302, and the electric heater 107 are sequentially communicated through a coolant channel to form a circulation loop. In this case, when a coolant flows in the circulation loop, heat generated by the power circuit 301 may be transferred to the first heat exchange plate 202, to heat the battery 201, so as to efficiently use the heat. In this operating mode, the electric heater 107 may be turned on or off as required. Details are not described herein.

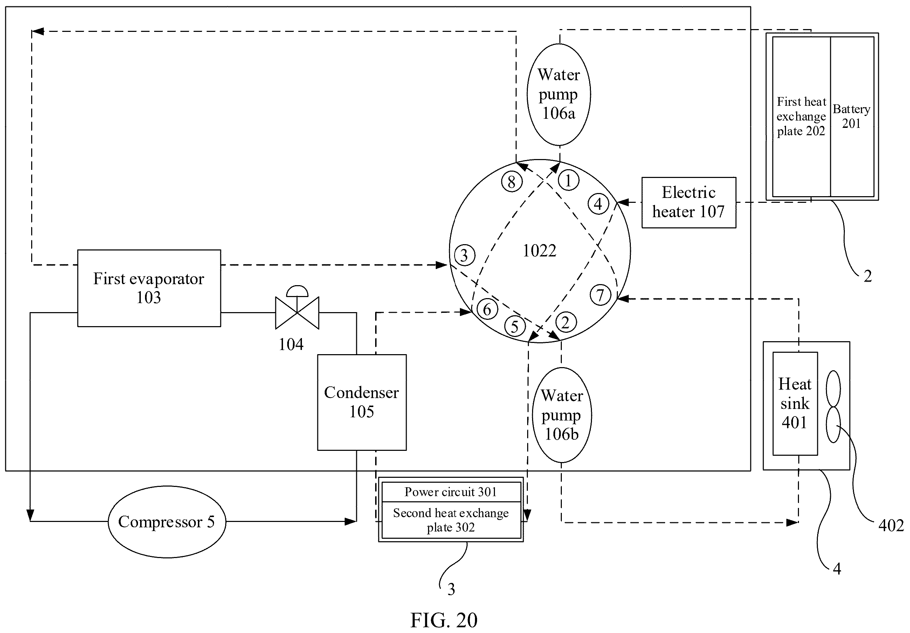

It should be noted that, in actual application, both the first throttle valve 104 and the compressor 5 may be set to an on state as required. As shown in FIG. 20, the condenser 105 has a high temperature according to a working principle of the heat pump, so that the condenser 105 provides heat energy for the first heat exchange plate 202. In addition, the electric heater 107 may also be turned on as required, to increase a temperature of the first heat exchange plate 202. It may be understood that, when the energy storage device 100 is deployed in a region with a low temperature, the electric heater 107 may be installed according to an actual requirement, or when the energy storage device 100 is deployed in a region with a high temperature, the electric heater 107 may not be disposed, to reduce deployment costs.

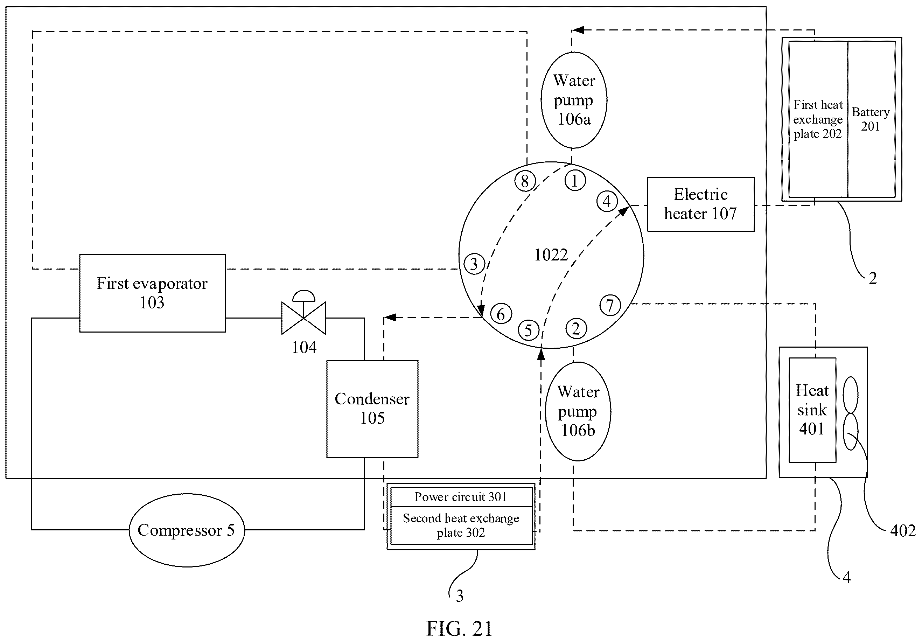

FIG. 21 shows an operating mode of the energy storage device 100 corresponding to a case in which an ambient temperature is low (for example, in case of a low temperature in winter) and neither heat generated by a power circuit 301 nor heat generated by the condenser 105 in a heat pump mode can meet a heating requirement of a battery 201. In this mode, an electric heater 107 is turned on, and a first heat exchange plate 202, a water pump 106a, the condenser 105, a second heat exchange plate 302, and the electric heater 107 are sequentially communicated through a coolant pipe to form a circulation loop, so that the electric heater 107 heats a coolant flowing in the circulation loop, to heat the battery 201. In addition, because the second heat exchange plate 302 is also connected in series to the foregoing path, heat generated by the second heat exchange plate 302 may also be transferred to the first heat exchange plate 202, to heat the battery 201.

It should be noted that, in the operating mode shown in FIG. 21, the compressor 5, the first evaporator 103, and the condenser 105 are all in an off state. In addition, in this mode, to heat the battery 201 via the electric heater 107, the valve interface 1 of the eight-way valve 1022 may be connected to a valve interface 6, and the valve interface 4 may be connected to a valve interface 5, so that the first heat exchange plate 202, the water pump 106a, the condenser 105, the second heat exchange plate 302, and the electric heater 107 are sequentially communicated through a coolant pipe to form a circulation loop. In this way, the first heat exchange plate 202 may be heated by both the second heat exchange plate 302 and the electric heater 107.

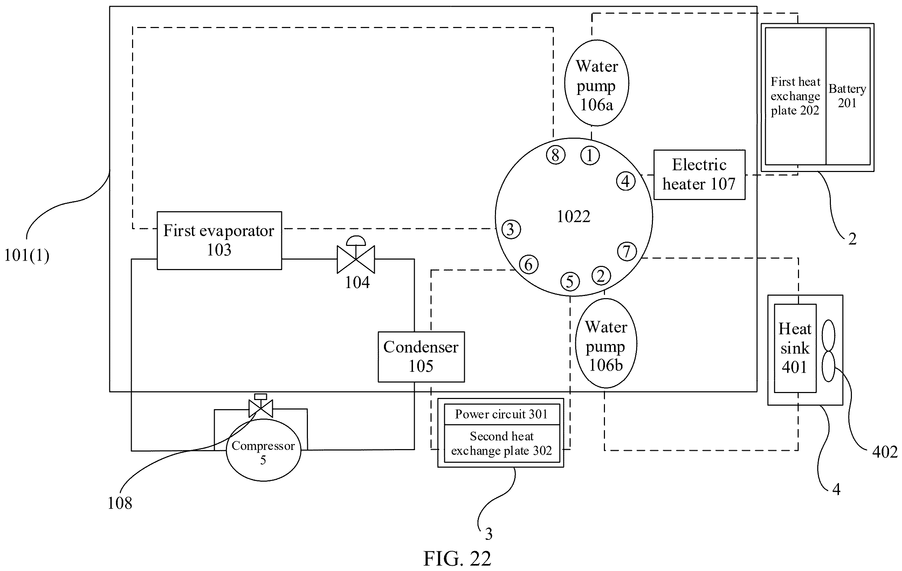

When the energy storage device 100 operates in a working condition with a low ambient temperature, in addition to heating the battery via the electric heater 107, another possible manner may be used. For example, refer to FIG. 22. FIG. 22 is a diagram of another specific structure of an energy storage device 100 according to an embodiment of this application. Compared with the energy storage device 100 shown in FIG. 16, in the energy storage device 100 in FIG. 22, a bypass valve 108 is added to a compressor 5. The bypass valve 108 and the compressor 5 are disposed in parallel. The bypass valve 108 may be, for example, a solenoid valve. In this way, when the compressor 5 operates in a heating state, the bypass valve 108 is turned on, to reduce pressure of the compressor 5, so as to heat a battery 201 through heat generated by the compressor 5. When the compressor operates in a refrigerating state, the bypass valve 108 is turned off. It may be understood that, when the heat generated by the compressor 5 can meet a heating requirement of the battery, an electric heater 107 in the energy storage device 100 may be removed. This helps improve energy efficiency of the energy storage device 100.

For another possible operating mode of the energy storage device 100 provided in FIG. 22, refer to FIG. 17 to FIG. 21. Details are not described herein again.

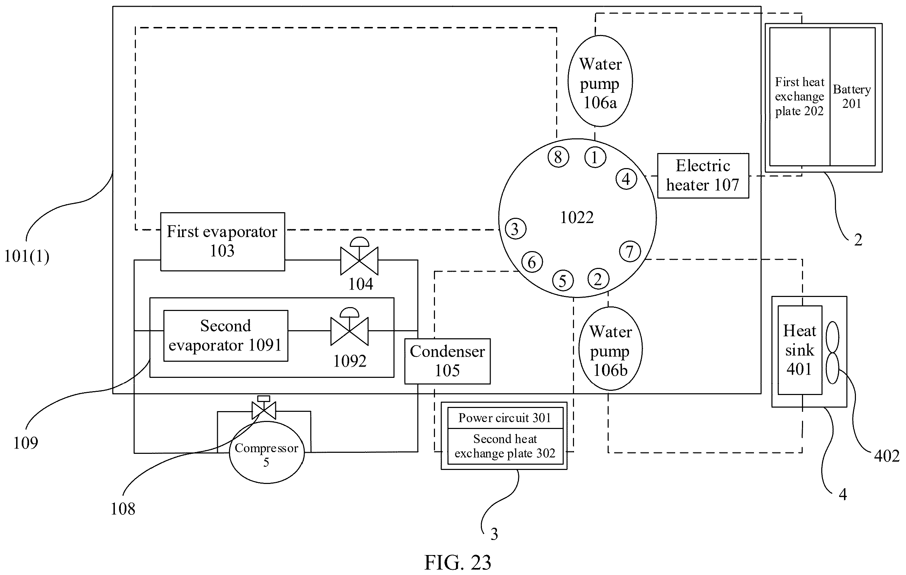

In addition, a dehumidification module 109 may be added on the basis of the energy storage device 100 shown in FIG. 22. Specifically, refer to FIG. 23. FIG. 23 is a diagram of another specific structure of an energy storage device 100 according to an embodiment of this application. As shown in FIG. 23, a heat management module 1 further includes a dehumidification module 109. The dehumidification module 109 may be disposed with reference to the dehumidification module 109 in any one of the foregoing embodiments. Details are not described herein again. In the energy storage device 100 shown in FIG. 23, a compressor 5, the dehumidification module 109, and a condenser 105 are sequentially communicated through a refrigerant pipe to form a dehumidification circulation loop. Because a temperature of a second evaporator 1091 is low when a refrigerant circulates in the circulation loop formed by the compressor 5, the dehumidification module 109, and the condenser 105, water vapor in air condenses into water drops when ambient humidity is high and the temperature of the second evaporator 1091 is lower than a dew point temperature of the air, and the water drops are discharged through a drainpipe, so as to reduce humidity in the energy storage device 100.

Because the temperature of the second evaporator 1091 is low, the second evaporator 1091 may further reduce a temperature of air in the energy storage device 100, so that a battery is in a low temperature environment. In addition, the dehumidification module 109 may further include a fan. The fan may be disposed near the second evaporator 1091, to accelerate a circulation speed of air flowing through the second evaporator 1091, so as to reduce the temperature of the second evaporator 1091. This helps improve dehumidification effect of the dehumidification module 109.

In the energy storage device 100 provided in FIG. 23, a circulation loop formed by a first heat exchange plate 202 and a heat sink 401 can effectively reduce a temperature of a surface of the battery 201. In addition, the temperature of the second evaporator 1091 in the dehumidification module 109 is low. Therefore, the temperature of the air in the energy storage device 100 can be further effectively reduced, thereby effectively improving heat dissipation effect on the battery. In addition, the second evaporator 1091 in the dehumidification module 109 can further condense water vapor in the energy storage device 100, so that humidity of the air in the energy storage device 100 can be reduced, and the battery can operate in a dry environment. This helps ensure reliability and a service life of the battery.

It may be understood that, in the embodiment provided in FIG. 23, a combination of the second evaporator 1091 and a second throttle valve 1092 and a combination of a first evaporator 103 and a first throttle valve 104 are disposed in parallel, so that the two combinations do not affect each other. Specifically, during dehumidification, the second throttle valve 1092 may be turned on and the first throttle valve 104 may be turned off, so that the refrigerant may circulate in a circulation loop formed by the compressor 5, the condenser 105, the second throttle valve 1092, and the second evaporator 1091, and the second evaporator 1091 has a low temperature, to implement a dehumidification function. In addition, both the first throttle valve 104 and the second throttle valve 1092 may be turned on, that is, the refrigerant may circulate in a circulation loop formed by the compressor 5, the condenser 105, the first throttle valve 104, and the first evaporator 103, and may further circulate in the circulation loop formed by the compressor 5, the condenser 105, the second throttle valve 1092, and the second evaporator 1091. Therefore, both the first evaporator 103 and the second evaporator 1091 have a low temperature, that is, a function of cooling the battery 201 can be implemented via the first evaporator 103, and a dehumidification function can be implemented via the second evaporator 1091. Certainly, during specific implementation, the first throttle valve 104 may be turned on and the second throttle valve 1092 may be turned off, so that the refrigerant may circulate in the circulation loop formed by the compressor 5, the condenser 105, the first throttle valve 104, and the first evaporator 103, and the first evaporator 103 has a low temperature, to implement the function of cooling the battery 201.

In summary, in the energy storage device 100 provided in FIG. 23 of this application, the first evaporator 103 and the second evaporator 1091 in the heat management module 1 are decoupled from each other, so that mutual impact between the first evaporator 103 and the second evaporator 1091 can be avoided. In addition, the combination of the first evaporator 103 and the first throttle valve 104 and the combination of the second evaporator 1091 and the second throttle valve 1092 share the same condenser 105 and compressor 5, thereby effectively reducing a quantity of used parts and components. This helps reduce a size and costs of an adjustment apparatus, and facilitates implementation of an integrated design. Certainly, in another possible embodiment, the first evaporator 103 and the second evaporator 1091 may alternatively be disposed in series, so that the first evaporator 103 and the second evaporator 1091 may share one throttle valve. For example, only the first throttle valve 104 or the second throttle valve 1092 may be disposed, so that a quantity of used parts and components can be reduced. This helps reduce manufacturing costs.

For another possible operating mode of the energy storage device 100 provided in FIG. 23, refer to FIG. 17 to FIG. 22. Details are not described herein again.

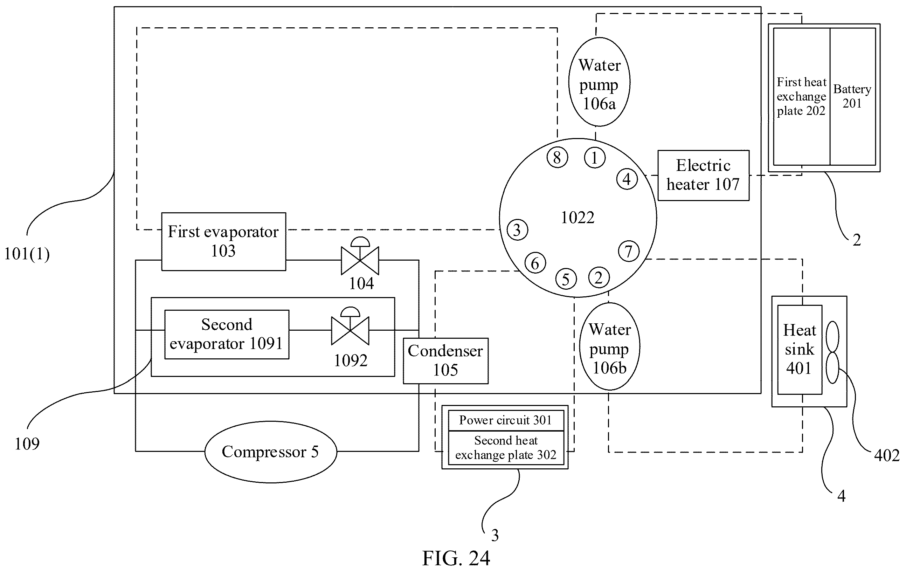

It should be noted that, in this embodiment of this application, the dehumidification module 109 is disposed without depending on bypass of the compressor 5, that is, the dehumidification module 109 and a bypass valve 108 at the compressor 5 may not be disposed together. For example, refer to FIG. 24. In an energy storage device 100 shown in FIG. 24, no bypass valve 108 is disposed at a compressor 5, and a dehumidification module 109 is disposed in a heat management system. This can still enable the energy storage device 100 to operate in a plurality of modes, to efficiently regulate and control a temperature of a battery 201. For each operating mode of the energy storage device 100 shown in FIG. 24, refer to FIG. 17 to FIG. 23. Details are not described herein again.

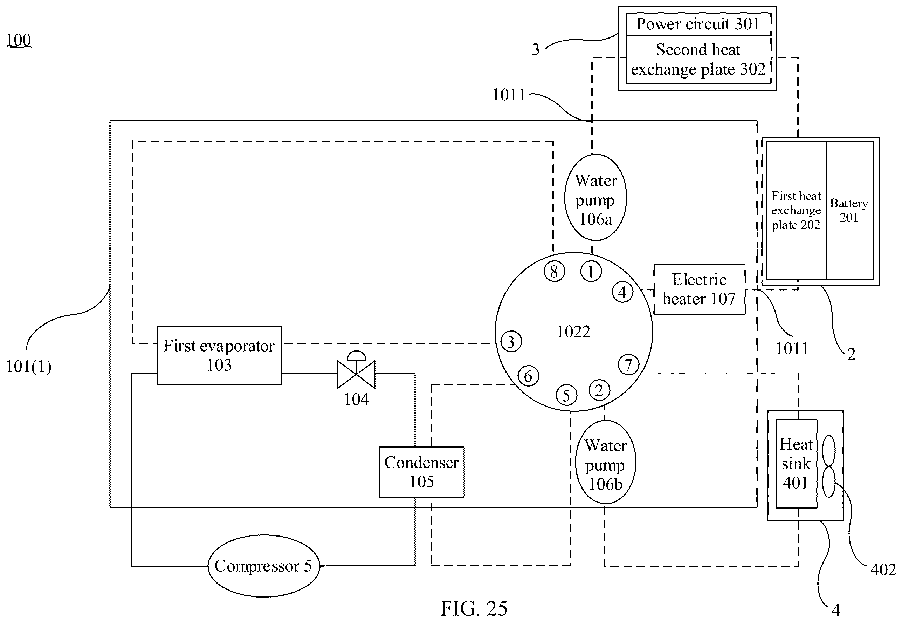

In the foregoing embodiments of this application, the first heat exchange plate 202 of the battery module 2 and the second heat exchange plate 302 of the power module 3 each may be connected to the heat management module 1 through two coolant interfaces. However, in some other possible embodiments of this application, the first heat exchange plate 202 of the battery module 2 and the second heat exchange plate 302 of the power module 3 may be further connected in series. FIG. 25 is a diagram of another structure of an energy storage device according to an embodiment of this application. A combination formed by connecting a first heat exchange plate 202 and a second heat exchange plate 302 in series is connected to two coolant interfaces 1011. This can facilitate cooling of a coolant flowing through the second heat exchange plate 302, thereby facilitating cooling of a power circuit 301, and improving operating reliability of the power circuit 301. In addition, it is further convenient to synchronously regulate and control temperatures of the power circuit 301 and a battery 201. This helps simplify a coolant circulation loop of the energy storage device 100. Another structure of the energy storage device 100 shown in FIG. 25 may be disposed with reference to FIG. 16. Details are not described herein again.

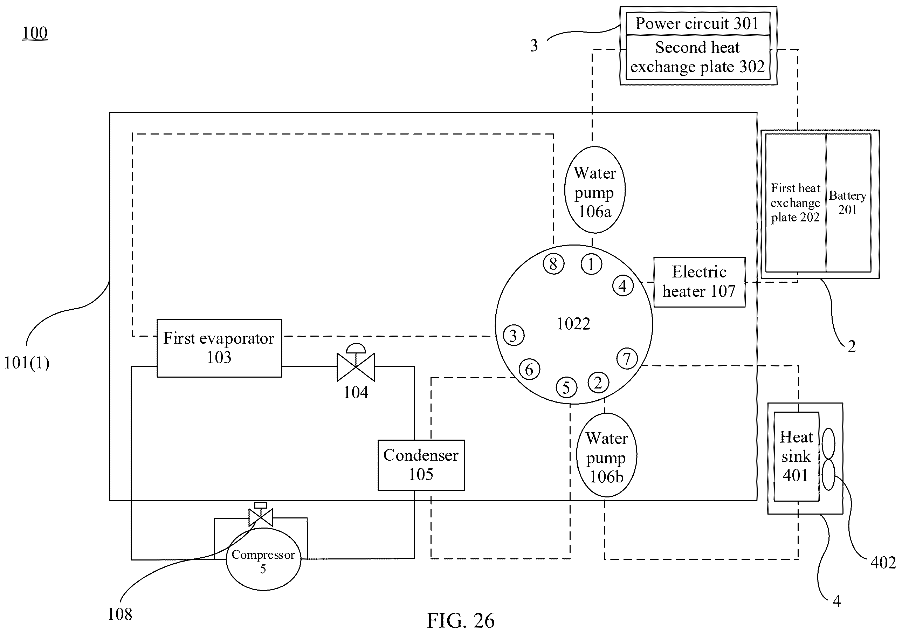

In addition, on the basis of the energy storage device 100 shown in FIG. 25, according to an actual application requirement, a bypass valve 108 may be disposed for a compressor 5 or a dehumidification module 109 may be added. For example, as shown in FIG. 26, compared with the energy storage device 100 shown in FIG. 25, an energy storage device 100 shown in FIG. 26 further includes a bypass valve 108, and the bypass valve 108 and a compressor 5 are disposed in parallel.

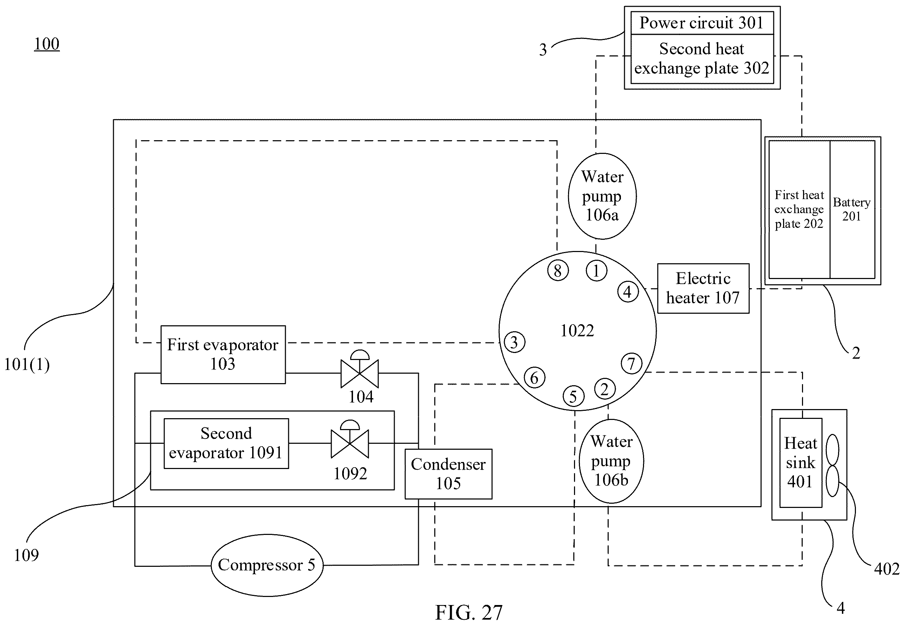

As shown in FIG. 27, compared with the energy storage device shown in FIG. 25, a heat management module 1 of an energy storage device 100 shown in FIG. 27 further includes a dehumidification module 109. The dehumidification module 109 may be disposed with reference to any one of the foregoing embodiments. Details are not described herein again.

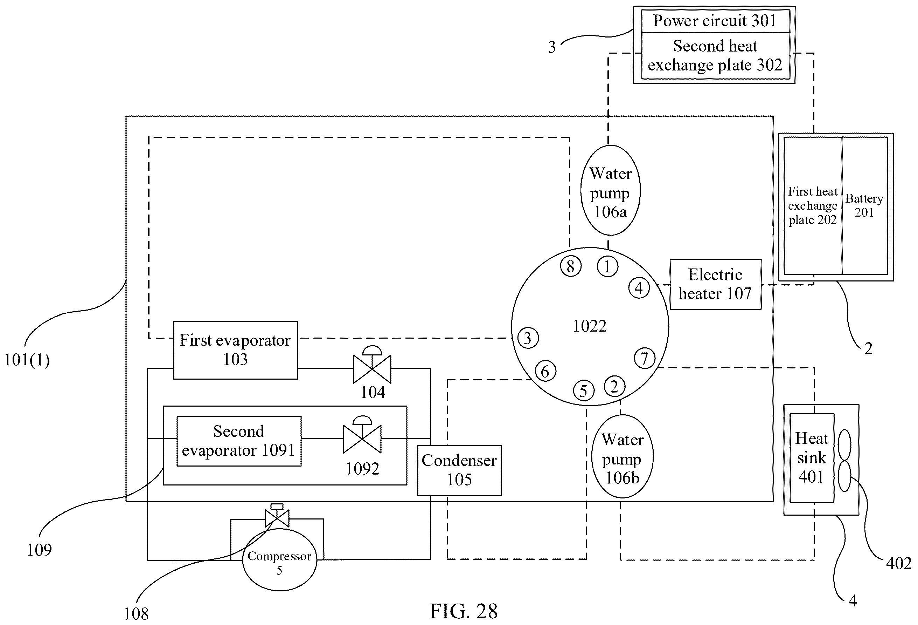

As shown in FIG. 28, compared with the energy storage device shown in FIG. 27, an energy storage device 100 shown in FIG. 28 further includes a bypass valve 108, and a heat management module 1 further includes a dehumidification module 109. The bypass valve 108 and the dehumidification module 109 may be disposed with reference to any one of the foregoing embodiments. Details are not described herein again.

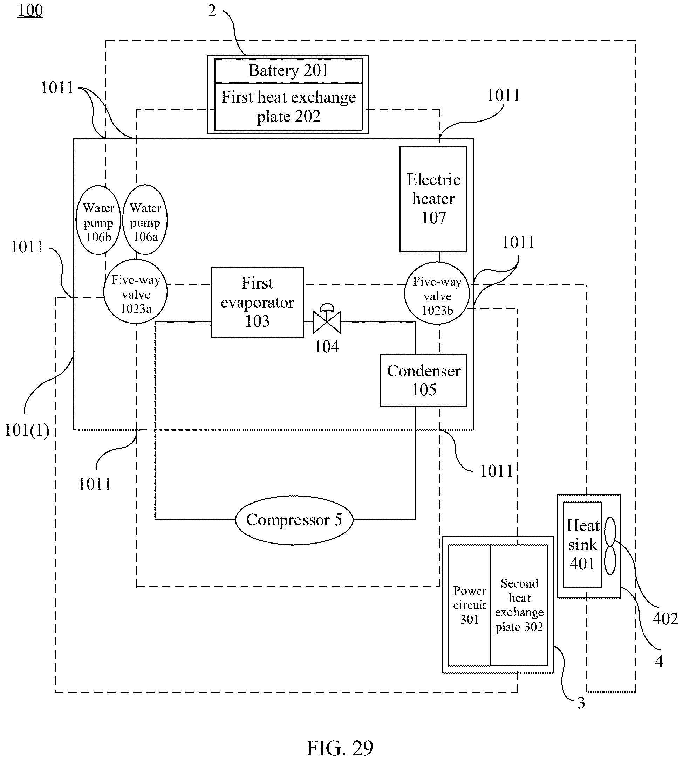

In the foregoing embodiments, a valve body assembly 102 is disposed as two four-way valves connected in series or disposed as one eight-way valve, so that the valve body assembly 102 includes eight valve interfaces configured to connect to a first evaporator 103, a condenser 105, or a coolant interface 1011. However, in actual application, a quantity of interfaces of the valve body assembly 102 may be further adjusted according to a specific requirement. For example, refer to FIG. 29. FIG. 29 is a diagram of another specific structure of an energy storage device 100 according to an embodiment of this application. A valve body assembly 102 of a heat management module 1 includes two five-way valves, and each five-way valve includes five valve interfaces. In this embodiment of this application, for ease of distinguishing, the two five-way valves may be denoted as a five-way valve 1023a and a five-way valve 1023b respectively. A first evaporator 103 is connected between the five-way valve 1023a and the five-way valve 1023b, a condenser 105 is connected between the five-way valve 1023b and one coolant interface 1011, and other valve interfaces of the two five-way valves each are connected to one coolant interface 1011. In this case, the five-way valve 1023a and the five-way valve 1023b may be configured to connect or disconnect a path between a first heat exchange plate 202, a second heat exchange plate 302, a heat sink 401, the condenser 105, and the first evaporator 103.

In actual application of the energy storage device 100 provided in FIG. 29, different coolant interfaces may be connected or disconnected via the two five-way valves, so that the energy storage device 100 can operate in a corresponding operating mode. The following describes several operating modes of the energy storage device 100 provided in FIG. 29 by using examples with reference to the accompanying drawings.

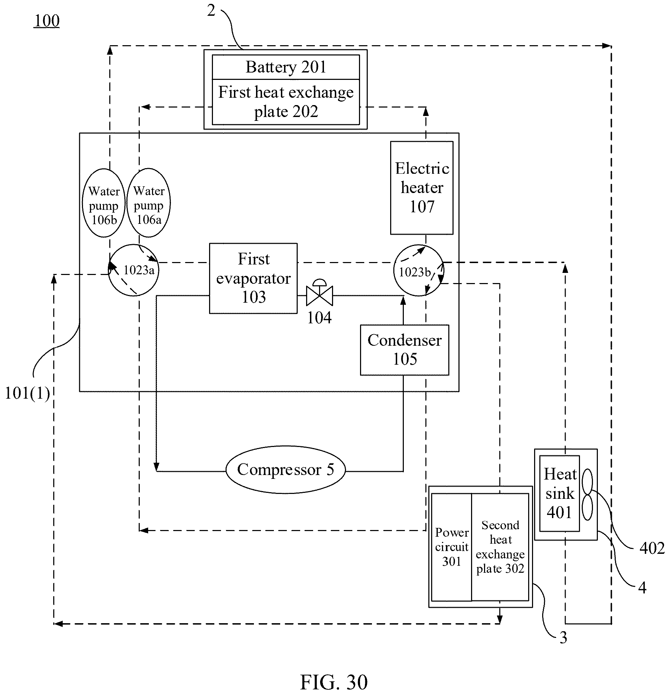

First, refer to FIG. 30, FIG. 30 shows an operating mode of the energy storage device 100 corresponding to a case in which an ambient temperature is high (for example, in case of a high temperature in summer). FIG. 30 shows four circulation loops.

A first circulation loop includes a compressor 5, the condenser 105, a first throttle valve 104, and the first evaporator 103 that are sequentially communicated through a refrigerant pipe. In this case, the first circulation loop is a refrigerant circulation loop. In this case, when a refrigerant flows in the circulation loop, the first evaporator 103 may be at a low temperature.

In a second circulation loop, the five-way valve 1023a and the five-way valve 1023b connect a path between the first heat exchange plate 202 and the first evaporator 103, so that the first heat exchange plate 202, a water pump 106a, the first evaporator 103, and an electric heater 107 are sequentially communicated through a coolant channel. Because a temperature of the first evaporator 103 is low in this case, the first heat exchange plate 202 may be cooled by exchanging heat between a coolant flowing in the circulation loop and the first evaporator 103, to dissipate heat for a battery 201.

In a third circulation loop, the five-way valve 1023a and the five-way valve 1023b connect a path between the second heat exchange plate 302 and the heat sink 401, so that the second heat exchange plate 302, a water pump 106b, the heat sink 401, and the condenser 105 are sequentially communicated through a coolant channel. In this case, when a coolant flows in the circulation loop, the heat sink 401 may cool the second heat exchange plate 302, to cool the second heat exchange plate 302, so as to dissipate heat for a power circuit 301.

In a fourth circulation loop, the five-way valve 1023a and the five-way valve 1023b connect a path between the condenser 105 and the heat sink 401, so that the condenser 105, the water pump 106b, and the heat sink 401 are sequentially communicated through a coolant channel. In this case, when a coolant flows in the circulation loop, the heat sink 401 may cool the condenser 105.

It should be noted that, in the operating mode shown in FIG. 30, the electric heater 107 is in an off state.

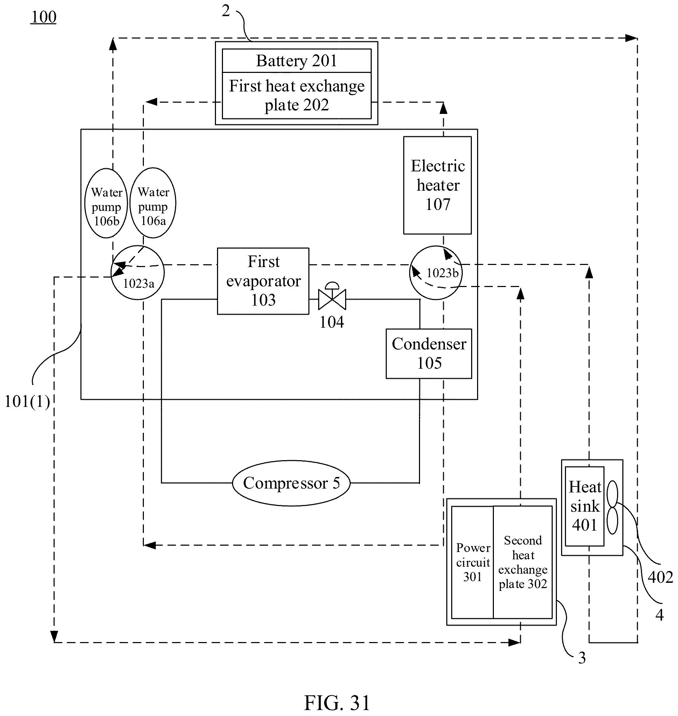

In addition, refer to FIG. 31. FIG. 31 shows an operating mode of the energy storage device 100 corresponding to a case in which an ambient temperature is temperate (for example, in case of spring or autumn).

In this operating mode, the five-way valve 1023a and the five-way valve 1023b connect a coolant path between the first heat exchange plate 202, the second heat exchange plate 302, and the heat sink 401, so that the first heat exchange plate 202, a water pump 106a, the second heat exchange plate 302, the first evaporator 103, a water pump 106b, the heat sink 401, and an electric heater 107 are sequentially communicated through a coolant channel to form a circulation loop. In this case, when a coolant flows in the circulation loop, the heat sink 401 may cool the first heat exchange plate 202 and the second heat exchange plate 302, to dissipate heat for a battery 201 and a power circuit 301.

It should be noted that, in the operating mode shown in FIG. 31, the electric heater 107 is in an off state. In addition, when the ambient temperature is temperate, heat dissipation requirements of the battery and the power circuit 301 can be met only via the heat sink 401. Therefore, in this operating mode, a compressor 5, the first evaporator 103, and the condenser 105 are all in an off state.

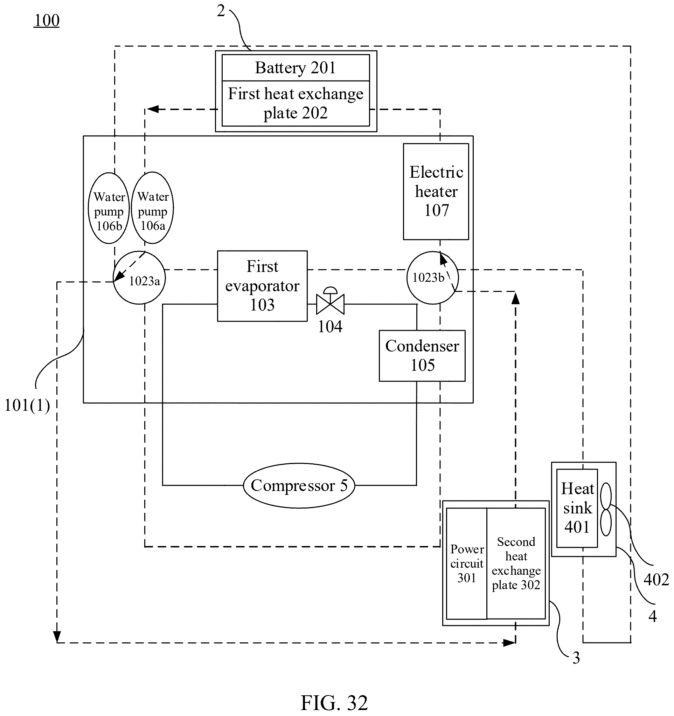

FIG. 32 shows an operating mode of the energy storage device 100 corresponding to a case in which an ambient temperature is low (for example, in case of a low temperature in winter).

In an operating process of the energy storage device 100, a power circuit 301 always generates a large amount of heat. However, in case of a low temperature in winter, to ensure charging and discharging performance of a battery, the battery needs to be heated. In view of this, it may be considered that the heat generated by the power circuit 301 is used for heating the battery. During specific implementation, as shown in FIG. 32, the five-way valve 1023a and the five-way valve 1023b connect a coolant path between the first heat exchange plate 202 and the second heat exchange plate 302, so that the first heat exchange plate 202, a water pump 106a, the second heat exchange plate 302, and an electric heater 107 are sequentially communicated through a coolant channel to form a circulation loop. In this case, when a coolant flows in the circulation loop, the heat generated by the power circuit 301 may be transferred to the first heat exchange plate 202, to heat the battery 201, so as to efficiently use the heat. In this operating mode, the electric heater 107 may be turned on or off as required. Details are not described herein.

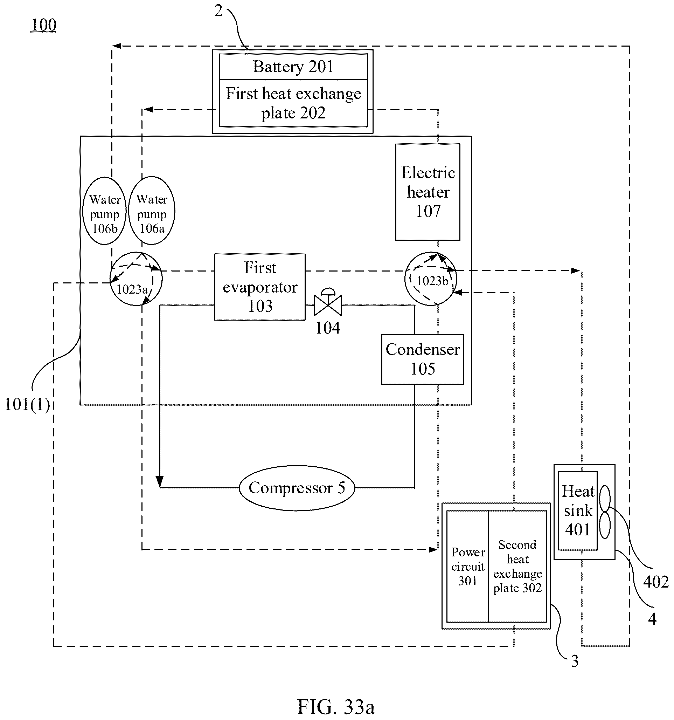

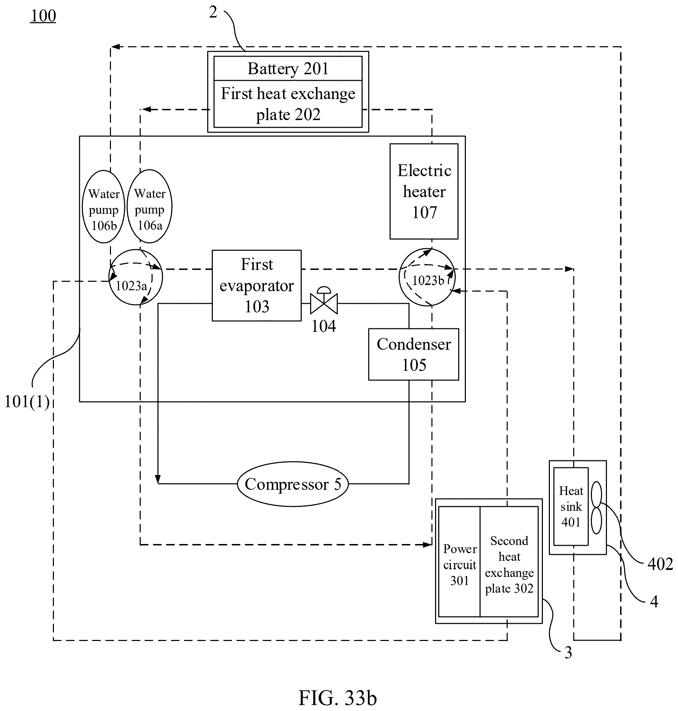

In the operating mode shown in FIG. 32, a compressor 5, the first evaporator 103, and the condenser 105 are all in an off state. In actual application, as shown in FIG. 33a and FIG. 33b, both a first throttle valve 104 and a compressor 5 may be set to an on state as required, that is, the condenser 105 has a high temperature according to a working principle of a heat pump, so that the condenser 105 can heat a coolant flowing in a circulation loop formed by sequentially communicating the first heat exchange plate 202, a water pump 106a, the condenser 105, and an electric heater 107 through a coolant channel, and the condenser 105 provides heat energy for the first heat exchange plate 202.

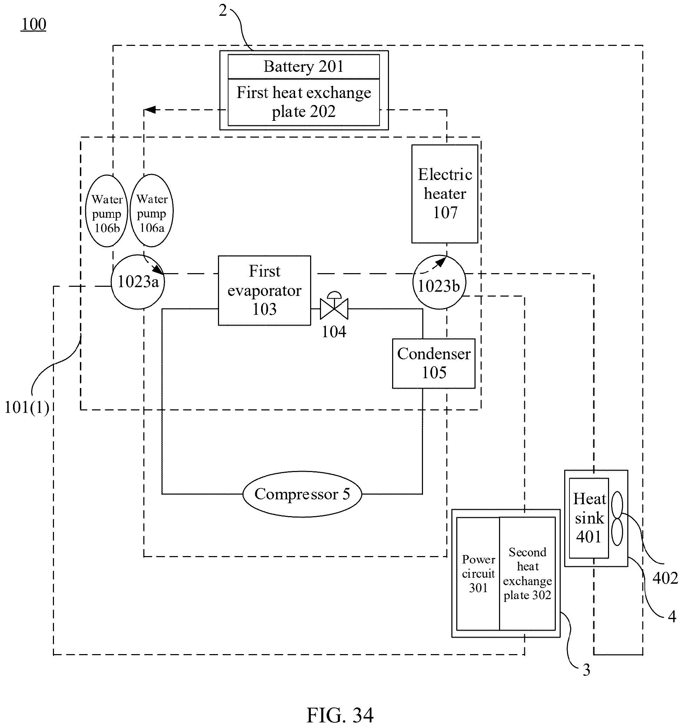

FIG. 34 shows an operating mode of the energy storage device 100 corresponding to a case in which an ambient temperature is low (for example, in case of a low temperature in winter) and neither heat generated by a power circuit 301 nor heat generated by the condenser 105 in a heat pump mode can meet a heating requirement of a battery. In this mode, an electric heater 107 is turned on, and the first heat exchange plate 202, a water pump 106a, the first evaporator 103, and the electric heater 107 are sequentially communicated through a coolant pipe to form a circulation loop, so that the electric heater 107 heats a coolant flowing in the circulation loop, to heat the battery 201.

It should be noted that, in the operating mode shown in FIG. 34, a compressor 5, the first evaporator 103, and the condenser 105 are all in an off state.

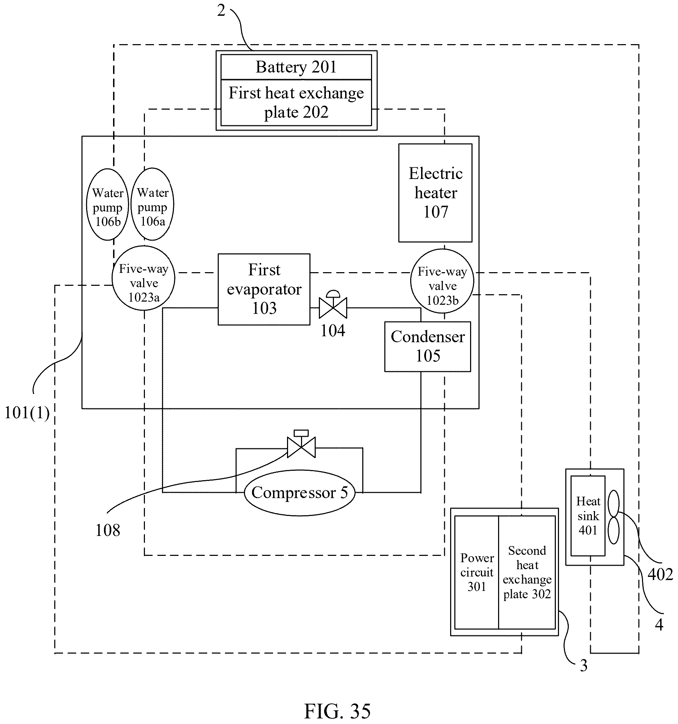

When the energy storage device 100 operates in a working condition with a low ambient temperature, in addition to heating the battery via the electric heater 107, another possible manner may be used. For example, refer to FIG. 35. FIG. 35 is a diagram of another specific structure of an energy storage device 100 according to an embodiment of this application. Compared with the energy storage device 100 shown in FIG. 29, in the energy storage device 100 in FIG. 35, a bypass valve 108 is added to a compressor 5. The bypass valve 108 and the compressor 5 are disposed in parallel. The bypass valve 108 may be, for example, a solenoid valve. In this way, when the compressor 5 operates in a heating state, the bypass valve 108 is turned on, to reduce pressure of the compressor 5, so as to heat a battery 201 through heat generated by the compressor 5. When the compressor operates in a refrigerating state, the bypass valve 108 is turned off. It may be understood that, when the heat generated by the compressor 5 can meet a heating requirement of the battery 201, an electric heater 107 in the energy storage device 100 may be removed. This helps improve energy efficiency of the energy storage device 100.

For another possible operating mode of the energy storage device 100 provided in FIG. 35, refer to FIG. 30 to FIG. 32, FIG. 33a and FIG. 33b, and FIG. 34. Details are not described herein again.

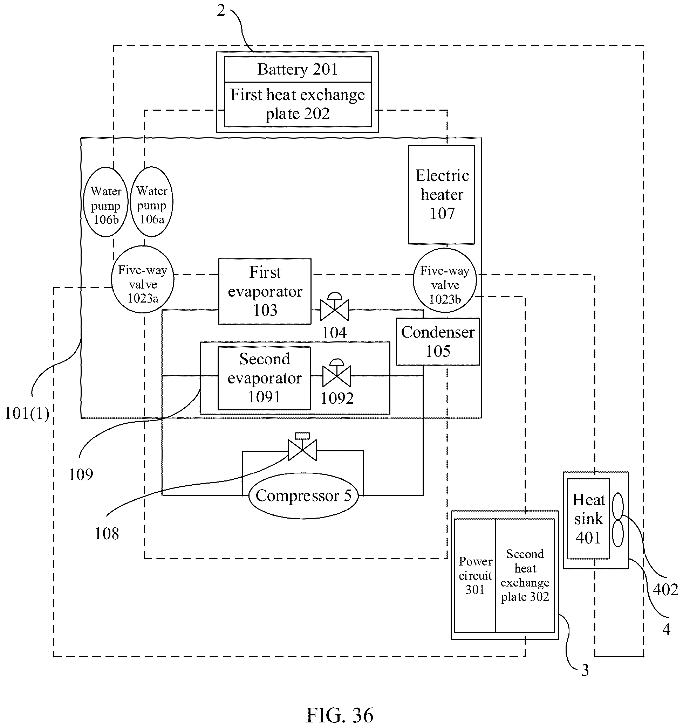

FIG. 36 is a diagram of another specific structure of an energy storage device 100 according to an embodiment of this application. Compared with the energy storage device 100 shown in FIG. 35, in the energy storage device 100 shown in FIG. 36, a dehumidification module 109 is further disposed in a heat management module 1. The dehumidification module 109 may be disposed with reference to the dehumidification module 109 in any one of the foregoing embodiments. Details are not described herein again. In the energy storage device 100 shown in FIG. 36, a compressor 5, the dehumidification module 109, and a condenser 105 are sequentially communicated through a refrigerant pipe to form a dehumidification circulation loop. Because a temperature of a second evaporator 1091 is low when a refrigerant circulates in the circulation loop formed by the compressor 5, the dehumidification module 109, and the condenser 105, water vapor in air condenses into water drops when ambient humidity is high and the temperature of the second evaporator 1091 is lower than a dew point temperature of the air, and the water drops are discharged through a drainpipe, so as to reduce humidity in the energy storage device 100.

Because the temperature of the second evaporator 1091 is low, the second evaporator 1091 may further reduce a temperature of air in the energy storage device 100, so that a battery is in a low temperature environment. In addition, the dehumidification module 109 may further include a fan. The fan may be disposed near the second evaporator 1091, to accelerate a circulation speed of air flowing through the second evaporator 1091, so as to reduce the temperature of the second evaporator 1091. This helps improve dehumidification effect of the dehumidification module 109.

In the energy storage device 100 provided in FIG. 36, a circulation loop formed by a first heat exchange plate 202 and a heat sink 401 can effectively reduce a temperature of a surface of the battery. In addition, the temperature of the second evaporator 1091 in the dehumidification module 109 is low. Therefore, the temperature of the air in the energy storage device 100 can be further effectively reduced, thereby effectively improving heat dissipation effect on the battery 201. In addition, the second evaporator 1091 in the dehumidification module 109 can further condense water vapor in the energy storage device 100, so that humidity of the air in the energy storage device 100 can be reduced, and the battery 201 can operate in a dry environment. This helps ensure reliability and a service life of the battery 201.

It may be understood that, in the embodiment provided in FIG. 36, a combination of the second evaporator 1091 and a second throttle valve 1092 and a combination of a first evaporator 103 and a first throttle valve 104 are disposed in parallel, so that the two combinations do not affect each other. Specifically, during dehumidification, the second throttle valve 1092 may be turned on and the first throttle valve 104 may be turned off, so that the refrigerant may circulate in a circulation loop formed by the compressor 5, the condenser 105, the second throttle valve 1092, and the second evaporator 1091, and the second evaporator 1091 has a low temperature, to implement a dehumidification function. In addition, both the first throttle valve 104 and the second throttle valve 1092 may be turned on, that is, the refrigerant may circulate in a circulation loop formed by the compressor 5, the condenser 105, the first throttle valve 104, and the first evaporator 103, and may further circulate in the circulation loop formed by the compressor 5, the condenser 105, the second throttle valve 1092, and the second evaporator 1091. Therefore, both the first evaporator 103 and the second evaporator 1091 have a low temperature, that is, a function of cooling the battery 201 can be implemented via the first evaporator 103, and a dehumidification function can be implemented via the second evaporator 1091. Certainly, during specific implementation, the first throttle valve 104 may be turned on and the second throttle valve 1092 may be turned off, so that the refrigerant may circulate in the circulation loop formed by the compressor 5, the condenser 105, the first throttle valve 104, and the first evaporator 103, and the first evaporator 103 has a low temperature, to implement the function of cooling the battery 201.

In summary, in the energy storage device 100 provided in FIG. 36 of this application, the first evaporator 103 and the second evaporator 1091 in the heat management module 1 are decoupled from each other, so that mutual impact between the first evaporator 103 and the second evaporator 1091 can be avoided. In addition, the combination of the first evaporator 103 and the first throttle valve 104 and the combination of the second evaporator 1091 and the second throttle valve 1092 share the same condenser 105 and compressor 5, thereby effectively reducing a quantity of used parts and components. This helps reduce a size and costs of an adjustment apparatus, and facilitates implementation of an integrated design. Certainly, in another possible embodiment, the first evaporator 103 and the second evaporator 1091 may alternatively be disposed in series, so that the first evaporator 103 and the second evaporator 1091 may share one throttle valve. For example, only the first throttle valve 104 or the second throttle valve 1092 may be disposed, so that a quantity of used parts and components can be reduced. This helps reduce manufacturing costs.

For another possible operating mode of the energy storage device 100 provided in FIG. 36, refer to FIG. 30 to FIG. 32, FIG. 33a and FIG. 33b, FIG. 34, and FIG. 35. Details are not described herein again.

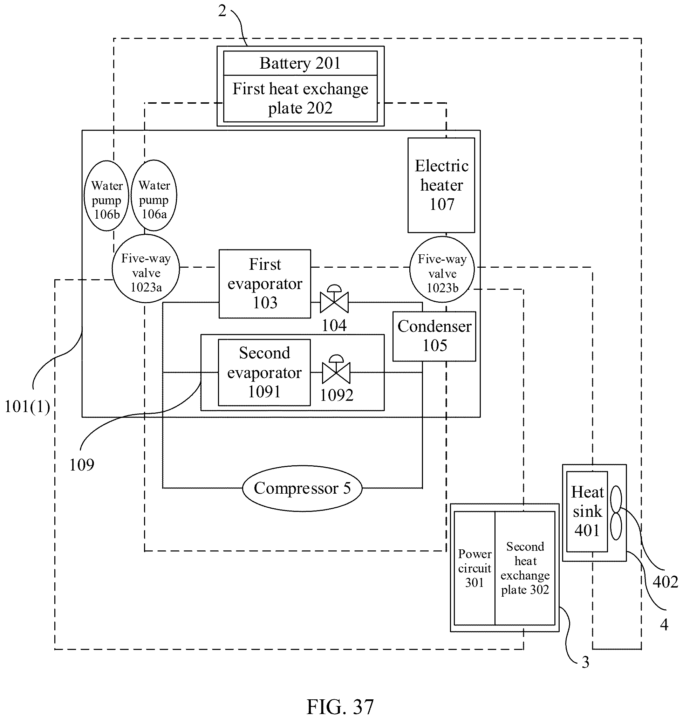

It should be noted that, in this embodiment of this application, the dehumidification module 109 is disposed without depending on bypass of the compressor 5, that is, the dehumidification module 109 and a bypass valve 108 at the compressor 5 may not be disposed together. For example, refer to FIG. 37. In an energy storage device 100 shown in FIG. 37, no bypass valve 108 is disposed at a compressor 5, and a dehumidification module 109 is disposed in a heat management system. This can still enable the energy storage device 100 to operate in a plurality of modes, to efficiently regulate and control a temperature of a battery. For an operating mode of the energy storage device 100 shown in FIG. 37, refer to FIG. 30 to FIG. 32, FIG. 33a and FIG. 33b, and FIG. 34 to FIG. 36. Details are not described herein again.

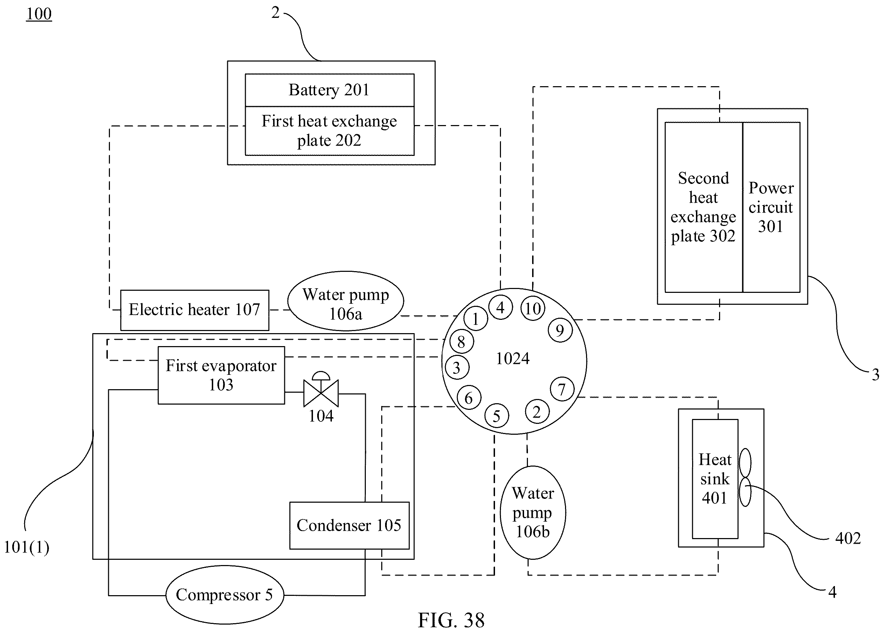

FIG. 38 is a diagram of another specific structure of an energy storage device 100 according to an embodiment of this application. In the energy storage device 100, a valve body assembly 102 is a 10-way valve 1024, and the 10-way valve 1024 may provide 10 valve interfaces for connecting or disconnecting a plurality of coolant interfaces. In actual application, a status of connection between different coolant interfaces may be effectively adjusted via the valve body assembly 102 according to an actual requirement, so that the energy storage device 100 shown in FIG. 34 can operate in a corresponding operating mode.

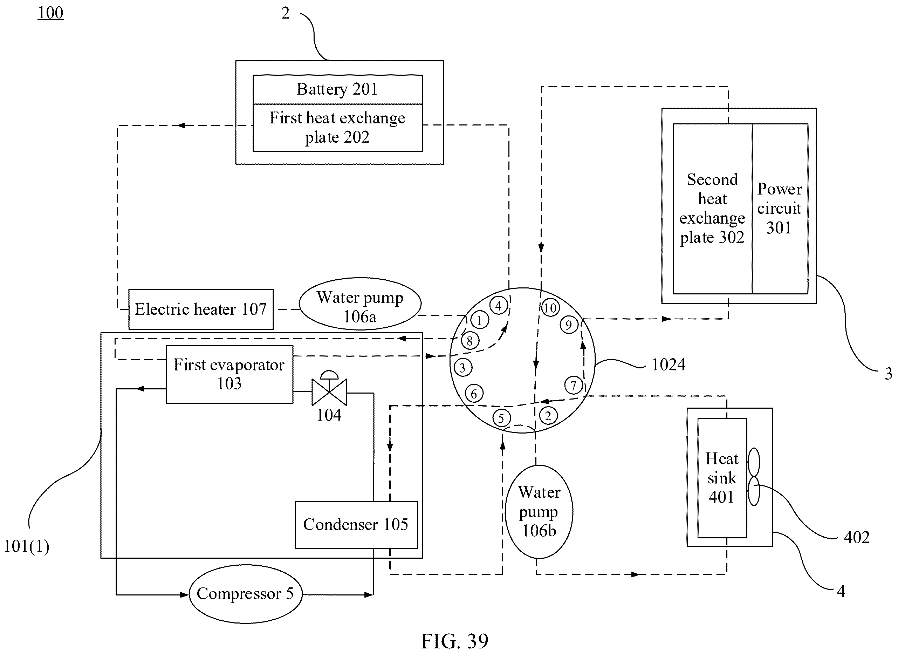

For example, when an ambient temperature is high (for example, in case of a high temperature and high humidity in summer), refer to FIG. 39. FIG. 39 is a diagram of a circulation loop of the energy storage device 100 shown in FIG. 38 in this operating mode. FIG. 39 shows four circulation loops in this operating mode.

A first circulation loop includes a compressor 5, a condenser 105, a first throttle valve 104, and a first evaporator 103 that are sequentially communicated through a refrigerant pipe. In this case, the first circulation loop is a refrigerant circulation loop. In this case, when a refrigerant flows in the circulation loop, the first evaporator 103 may be at a low temperature.

In a second circulation loop, the 10-way valve 1024 connects a coolant path between a first heat exchange plate 202 and the first evaporator 103, so that the first heat exchange plate 202, the first evaporator 103, a water pump 106a, and an electric heater 107 are sequentially communicated through a coolant channel. Because a temperature of the first evaporator 103 is low in this case, the first heat exchange plate 202 may be cooled by exchanging heat between a coolant flowing in the circulation loop and the first evaporator 103, to dissipate heat for a battery.

In a third circulation loop, the 10-way valve 1024 connects a coolant path between a second heat exchange plate 302 and a heat sink 401, so that the second heat exchange plate 302, a water pump 106b, the heat sink 401, and the condenser 105 are sequentially communicated through a coolant channel. In this case, when a coolant flows in the circulation loop, the heat sink 401 may cool the second heat exchange plate 302, to cool the second heat exchange plate 302, so as to dissipate heat for a power circuit 301.

In a fourth circulation loop, the 10-way valve 1024 connects a path between the condenser 105 and the heat sink 401, so that the condenser 105, the water pump 106b, and the heat sink 401 are sequentially communicated through a coolant channel. In this case, when a coolant flows in the circulation loop, the heat sink 401 may cool the condenser 105.

It should be noted that, in the operating mode shown in FIG. 39, the electric heater 107 is in an off state.

In addition, in another possible embodiment, the first heat exchange plate 202 may also be cooled via the heat sink 401. For example, an interface 7 of the 10-way valve 1024 may be connected to an interface 4, and an interface 1 may be connected to an interface 2. In this case, the first heat exchange plate 202, the electric heater 107, the water pump 106a, the water pump 106b, and the heat sink 401 are sequentially communicated through a coolant pipe to form a circulation loop, so that a coolant can circulate between the first heat exchange plate 202 and the heat sink 401, to dissipate heat for the first heat exchange plate 202 via the heat sink 401.

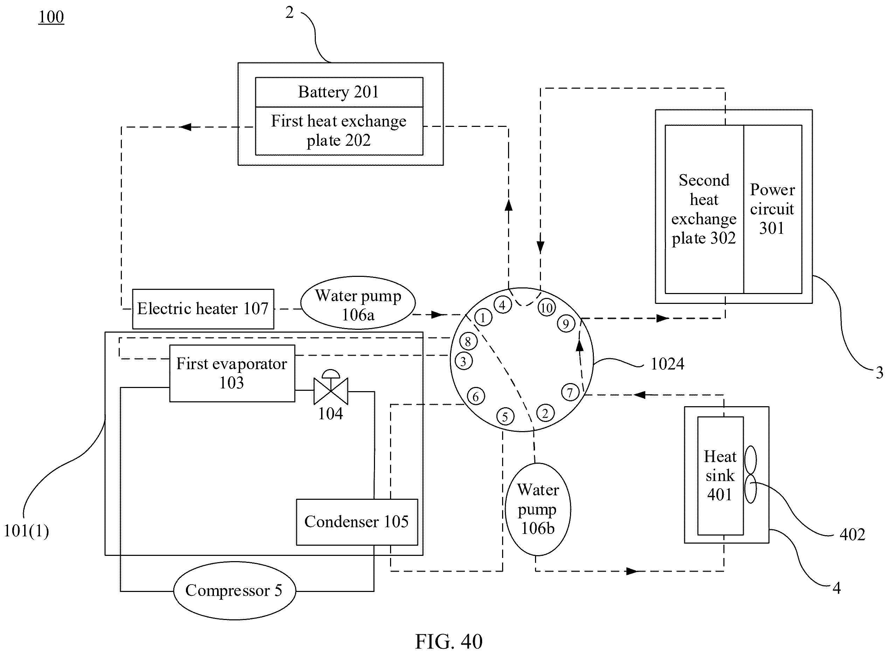

In addition, refer to FIG. 40. FIG. 40 shows an operating mode of the energy storage device 100 corresponding to a case in which an ambient temperature is temperate (for example, in case of spring or autumn).

In this operating mode, the 10-way valve 1024 connects a coolant path between a first heat exchange plate 202, a second heat exchange plate 302, and a heat sink 401, so that the first heat exchange plate 202, an electric heater 107, a water pump 106b, a water pump 106a, the heat sink 401, and the second heat exchange plate 302 are sequentially communicated through a coolant channel to form a circulation loop. In this case, when a coolant flows in the circulation loop, the heat sink 401 may cool the first heat exchange plate 202 and the second heat exchange plate 302, to dissipate heat for a battery and a power circuit 301.

It should be noted that, in the operating mode shown in FIG. 40, the electric heater 107 is in an off state. In addition, when the ambient temperature is temperate, heat dissipation requirements of the battery and the power circuit 301 can be met only via the heat sink 401. Therefore, in this operating mode, a compressor 5, a first evaporator 103, and a condenser 105 are all in an off state.

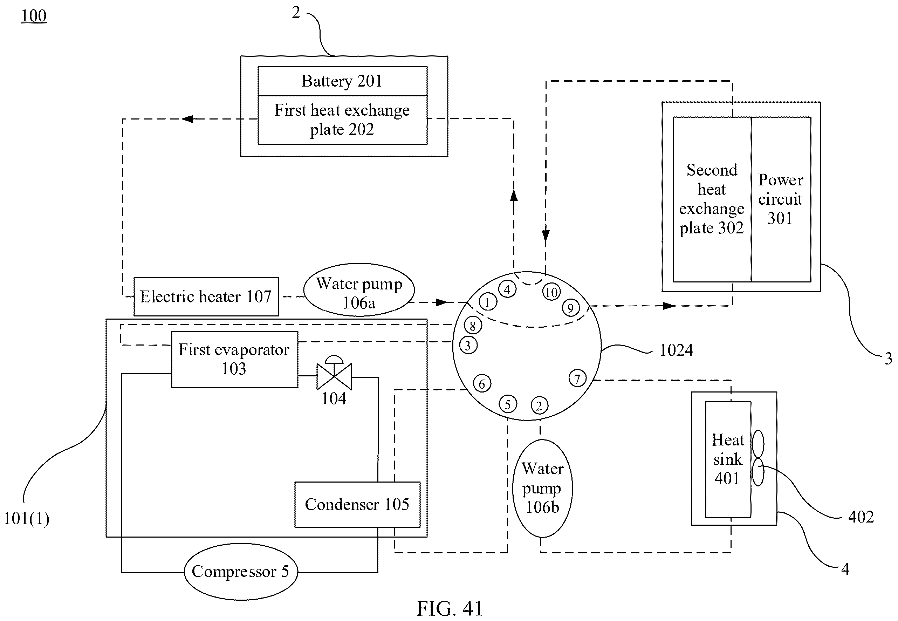

FIG. 41 shows an operating mode of the energy storage device corresponding to a case in which an ambient temperature is low (for example, in case of a low temperature in winter).

In an operating process of the energy storage device, a power circuit 301 always generates a large amount of heat. However, in case of a low temperature in winter, to ensure charging and discharging performance of a battery 201, the battery 201 needs to be heated. In view of this, it may be considered that the heat generated by the power circuit 301 is used for heating the battery 201. During specific implementation, as shown in FIG. 41, the 10-way valve 1024 connects a coolant path between a first heat exchange plate 202 and a second heat exchange plate 302, so that the first heat exchange plate 202, an electric heater 107, a water pump 106, and the second heat exchange plate 302 are sequentially communicated through a coolant channel to form a circulation loop. In this case, when a coolant flows in the circulation loop, the heat generated by the power circuit 301 may be transferred to the first heat exchange plate 202, to heat the battery 201, so as to efficiently use the heat. In this operating mode, the electric heater 107 may be turned on or off as required. Details are not described herein.

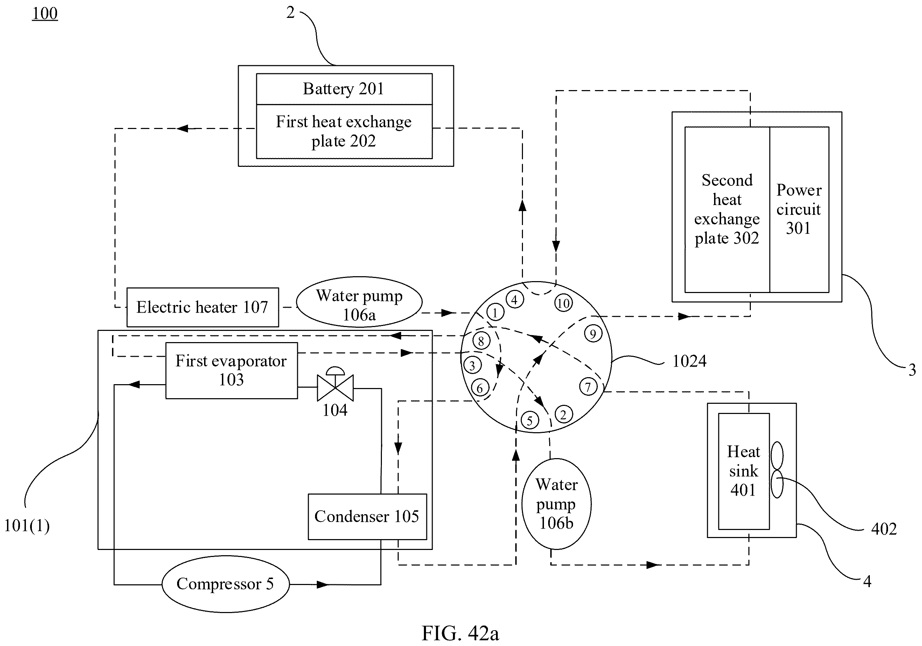

In the operating mode shown in FIG. 41, a compressor 5, a first evaporator 103, and a condenser 105 are all in an off state. In actual application, as shown in FIG. 42a, both a first throttle valve 104 and a compressor 5 may be set to an on state as required, that is, the condenser 105 has a high temperature according to a working principle of a heat pump, to heat a first heat exchange plate 202 via the condenser 105. During specific implementation, FIG. 42a shows three circulation loops.

A first circulation loop includes the compressor 5, the condenser 105, the first throttle valve 104, and a first evaporator 103 that are sequentially communicated through a refrigerant pipe. In this case, when a refrigerant flows in the circulation loop, the condenser 105 may have a high temperature.

In a second circulation loop, the 10-way valve 1024 connects a coolant path between the first heat exchange plate 202, the condenser 105, and a second heat exchange plate 302, so that the first heat exchange plate 202, an electric heater 107, a water pump 106a, the condenser 105, and the second heat exchange plate 302 are sequentially communicated through a coolant channel. In this case, when a coolant flows in the circulation loop, both heat generated by a power circuit 301 and heat generated by the condenser 105 may be transferred to the first heat exchange plate 202, to heat a battery.

In a third circulation loop, the 10-way valve 1024 connects a coolant path between the first evaporator 103 and the second heat exchange plate 302, so that the first evaporator 103, a heat sink 401, and a water pump 106b are sequentially communicated through a coolant channel. It may be understood that, in a heat pump mode, heat in an environment may be transferred to the condenser 105 via the first evaporator 103. Therefore, a temperature of the first evaporator 103 is low. To dissipate cold of the first evaporator 103, the temperature of the first evaporator 103 is increased. In one aspect, the electric heater 107 may be used to increase the temperature of the first evaporator 103. In another aspect, heat of the first evaporator 103 may be increased through heat exchange between the heat sink 401 and the first evaporator 103.

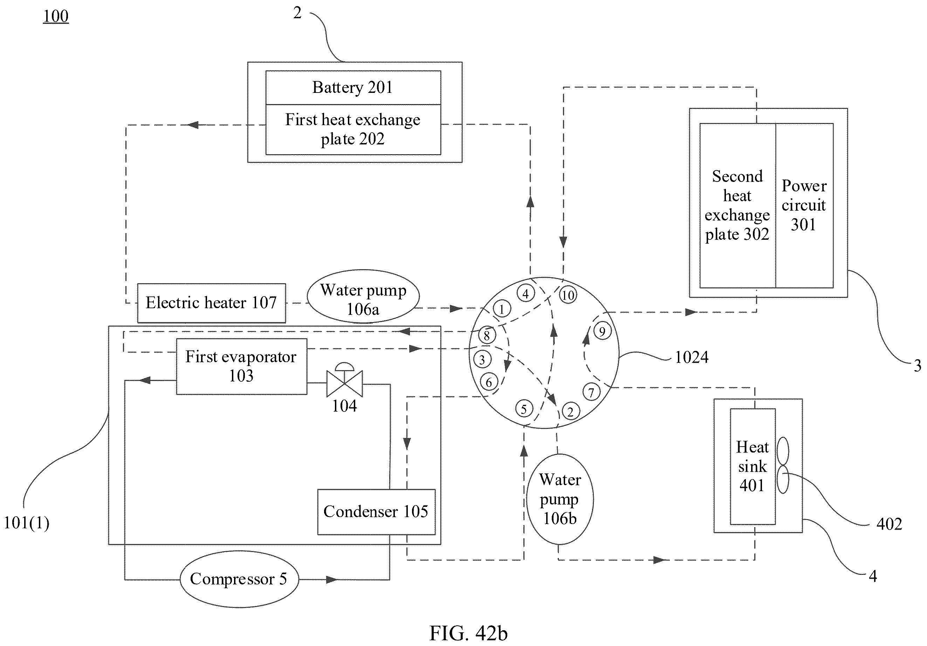

When an energy storage system 100 operates in the heat pump mode, another possible circulation loop may be further formed, provided that the first heat exchange plate 202 and the condenser 105 are connected in series. For example, refer to FIG. 42b. In FIG. 42b, a first heat exchange plate 202, an electric heater 107, a water pump 106a, and a condenser 105 are sequentially communicated through a coolant channel. In this case, when a coolant flows in the circulation loop, heat generated by the condenser 105 all may be transferred to the first heat exchange plate 202, to heat a battery.

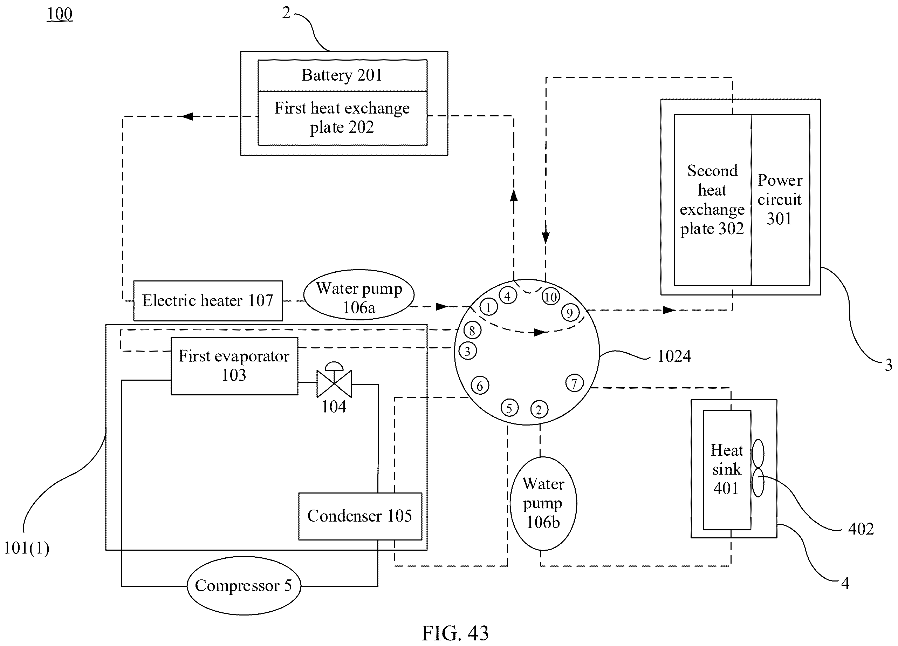

FIG. 43 shows an operating mode of the energy storage device 100 corresponding to a case in which an ambient temperature is low (for example, in case of a low temperature in winter) and neither heat generated by a power circuit 301 nor heat generated by a condenser 105 in a heat pump mode can meet a heating requirement of a battery 201. In this mode, an electric heater 107 is turned on, and a first heat exchange plate 202, the electric heater 107, a water pump 106a, and a second heat exchange plate 302 are sequentially communicated through a coolant pipe to form a circulation loop, so that the electric heater 107 and the second heat exchange plate 302 heat a coolant flowing in the circulation loop, to heat the battery 201.

It should be noted that, in the operating mode shown in FIG. 43, a compressor 5, a first evaporator 103, and the condenser 105 are all in an off state.

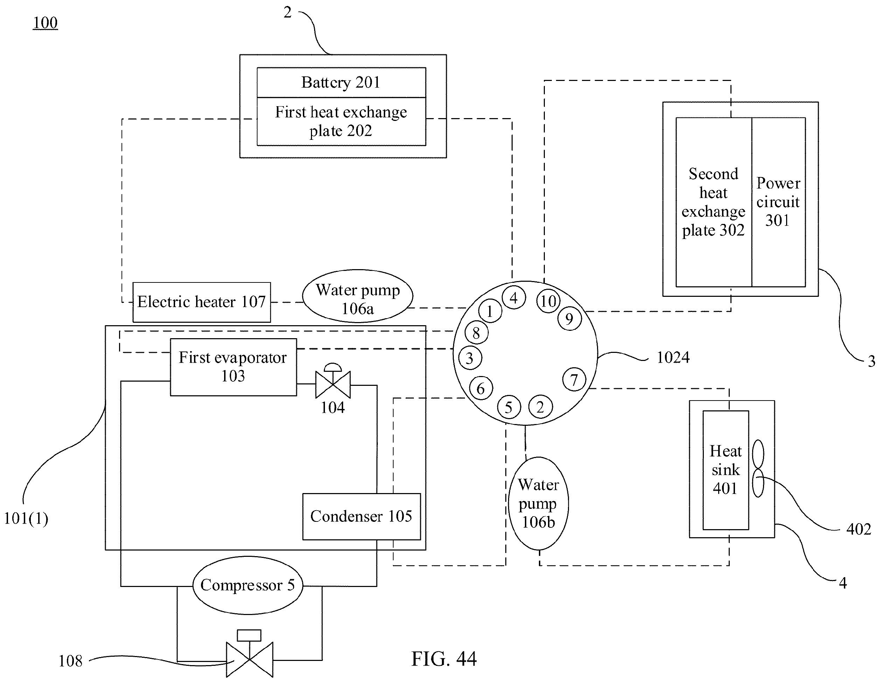

When the energy storage device 100 operates in a working condition with a low ambient temperature, in addition to heating the battery via the electric heater 107, another possible manner may be used. For example, refer to FIG. 44. FIG. 44 is a diagram of another specific structure of an energy storage device 100 according to an embodiment of this application. Compared with the energy storage device 100 shown in FIG. 38, in the energy storage device 100 in FIG. 44, a bypass valve 108 is added to a compressor 5. The bypass valve 108 and the compressor 5 are disposed in parallel. The bypass valve 108 may be, for example, a solenoid valve. In this way, when the compressor 5 operates in a heating state, the bypass valve 108 is turned on, to reduce pressure of the compressor 5, so as to heat a battery 201 through heat generated by the compressor 5. When the compressor operates in a refrigerating state, the bypass valve 108 is turned off. It may be understood that, when the heat generated by the compressor 5 can meet a heating requirement of the battery, an electric heater 107 in the energy storage device 100 may be removed. This helps improve energy efficiency of the energy storage device 100.

For another possible operating mode of the energy storage device 100 provided in FIG. 44, refer to FIG. 39 to FIG. 41, FIG. 42a, FIG. 42b, and FIG. 43. Details are not described herein again.

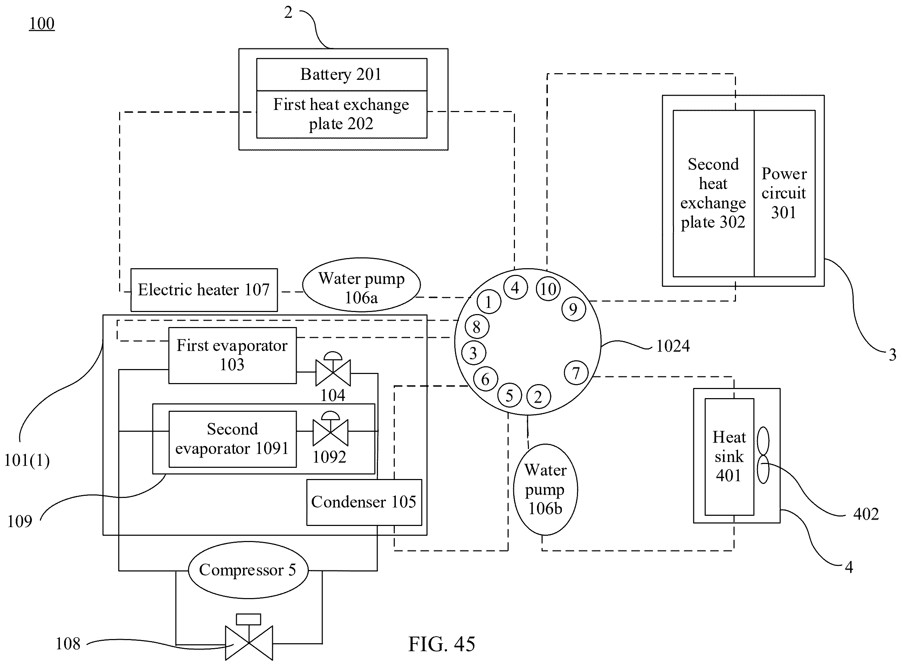

FIG. 45 is a diagram of another specific structure of an energy storage device 100 according to an embodiment of this application. Compared with the energy storage device 100 shown in FIG. 44, in the energy storage device 100 shown in FIG. 45, a dehumidification module 109 is further disposed in a heat management module 1. The dehumidification module 109 may be disposed with reference to the dehumidification module 109 in any one of the foregoing embodiments. Details are not described herein again.

In the energy storage device 100 shown in FIG. 45, a compressor 5, the dehumidification module 109, and a condenser 105 are sequentially communicated through a refrigerant pipe to form a dehumidification circulation loop. Because a temperature of a second evaporator 1091 is low when a refrigerant circulates in the circulation loop formed by the compressor 5, the dehumidification module 109, and the condenser 105, water vapor in air condenses into water drops when ambient humidity is high and the temperature of the second evaporator 1091 is lower than a dew point temperature of the air, and the water drops are discharged through a drainpipe, so as to reduce humidity in the energy storage device 100.

Because the temperature of the second evaporator 1091 is low, the second evaporator 1091 may further reduce a temperature of air in the energy storage device 100, so that a battery is in a low temperature environment. In addition, the dehumidification module 109 may further include a fan. The fan may be disposed near the second evaporator 1091, to accelerate a circulation speed of air flowing through the second evaporator 1091, so as to reduce the temperature of the second evaporator 1091. This helps improve dehumidification effect of the dehumidification module 109.

In the energy storage device 100 provided in FIG. 45, a circulation loop formed by a first heat exchange plate 202 and a heat sink 401 can effectively reduce a temperature of a surface of the battery. In addition, the temperature of the second evaporator 1091 in the dehumidification module 109 is low. Therefore, the temperature of the air in the energy storage device 100 can be further effectively reduced, thereby effectively improving heat dissipation effect on the battery 201. In addition, the second evaporator 1091 in the dehumidification module 109 can further condense water vapor in the energy storage device 100, so that humidity of the air in the energy storage device 100 can be reduced, and the battery 201 can operate in a dry environment. This helps ensure reliability and a service life of the battery 201.

It may be understood that, in the embodiment provided in FIG. 45, a combination of the second evaporator 1091 and a second throttle valve 1092 and a combination of a first evaporator 103 and a first throttle valve 104 are disposed in parallel, so that the two combinations do not affect each other. Specifically, during dehumidification, the second throttle valve 1092 may be turned on and the first throttle valve 104 may be turned off, so that the refrigerant may circulate in a circulation loop formed by the compressor 5, the condenser 105, the second throttle valve 1092, and the second evaporator 1091, and the second evaporator 1091 has a low temperature, to implement a dehumidification function. In addition, both the first throttle valve 104 and the second throttle valve 1092 may be turned on, that is, the refrigerant may circulate in a circulation loop formed by the compressor 5, the condenser 105, the first throttle valve 104, and the first evaporator 103, and may further circulate in the circulation loop formed by the compressor 5, the condenser 105, the second throttle valve 1092, and the second evaporator 1091. Therefore, both the first evaporator 103 and the second evaporator 1091 have a low temperature, that is, a function of cooling the battery can be implemented via the first evaporator 103, and a dehumidification function can be implemented via the second evaporator 1091. Certainly, during specific implementation, the first throttle valve 104 may be turned on and the second throttle valve 1092 may be turned off, so that the refrigerant may circulate in the circulation loop formed by the compressor 5, the condenser 105, the first throttle valve 104, and the first evaporator 103, and the first evaporator 103 has a low temperature, to implement the function of cooling the battery 201.

In summary, in the energy storage device 100 provided in FIG. 45 of this application, the first evaporator 103 and the second evaporator 1091 in the heat management module 1 are decoupled from each other, so that mutual impact between the first evaporator 103 and the second evaporator 1091 can be avoided. In addition, the combination of the first evaporator 103 and the first throttle valve 104 and the combination of the second evaporator 1091 and the second throttle valve 1092 share the same condenser 105 and compressor 5, thereby effectively reducing a quantity of used parts and components. This helps reduce a size and costs of an adjustment apparatus, and facilitates implementation of an integrated design. Certainly, in another possible embodiment, the first evaporator 103 and the second evaporator 1091 may alternatively be disposed in series, so that the first evaporator 103 and the second evaporator 1091 may share one throttle valve. For example, only the first throttle valve 104 or the second throttle valve 1092 may be disposed, so that a quantity of used parts and components can be reduced. This helps reduce manufacturing costs.

For another possible operating mode of the energy storage device 100 provided in FIG. 45, refer to FIG. 39 to FIG. 41, FIG. 42a, FIG. 42b, FIG. 43, and FIG. 44. Details are not described herein again.

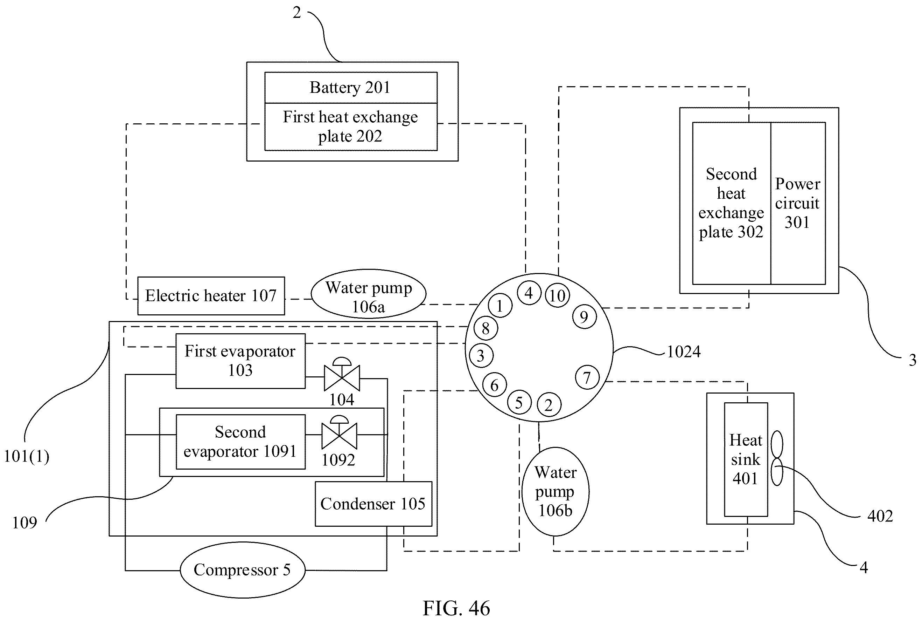

It should be noted that, in this embodiment of this application, the dehumidification module 109 is disposed without depending on bypass of the compressor 5, that is, the dehumidification module 109 and a bypass valve 108 at the compressor 5 may not be disposed together. For example, refer to FIG. 46. In an energy storage device 100 shown in FIG. 46, no bypass valve 108 is disposed at a compressor 5, and a dehumidification module 109 is disposed in a heat management system. This can still enable the energy storage device 100 to operate in a plurality of modes, to efficiently regulate and control a temperature of a battery. For an operating mode of the energy storage device 100 shown in FIG. 46, refer to FIG. 39 to FIG. 41, FIG. 42a, FIG. 42b, and FIG. 43 to FIG. 45. Details are not described herein again.

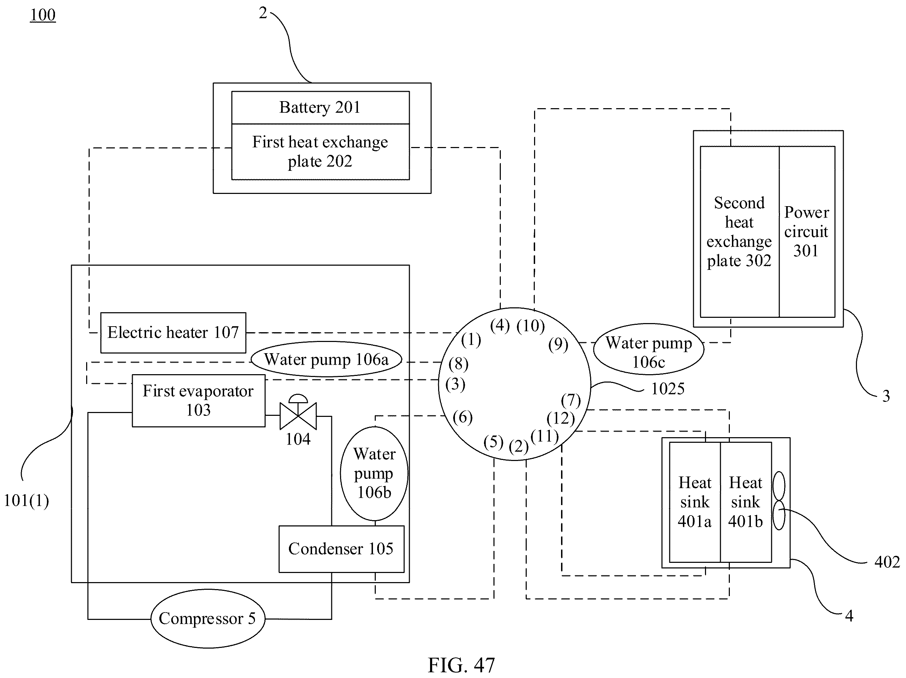

In this embodiment of this application, a valve body assembly may have more than 10 valve interfaces, to reserve a valve interface for connecting to another possible pipeline, thereby improving evolvability of the energy storage device 100. For example, refer to FIG. 47. FIG. 47 is a diagram of another specific structure of an energy storage device 100 according to an embodiment of this application. In the energy storage device 100, a valve body assembly 102 is a 12-way valve 1025, and the 12-way valve 1025 may provide 12 valve interfaces for connecting or disconnecting a plurality of coolant interfaces. In actual application, a status of connection between different coolant interfaces may be effectively adjusted via the valve body assembly 102 according to an actual requirement, so that the energy storage device 100 shown in FIG. 47 can operate in a corresponding operating mode.

In addition, a heat sink module 4 of the energy storage device 100 shown in FIG. 47 includes two heat sinks, and each heat sink may be connected between two coolant interfaces. For ease of distinguishing, the two heat sinks may be denoted as a heat sink 401a and a heat sink 401b respectively.

The following describes several operating modes of the energy storage device 100 shown in FIG. 47 by using examples.

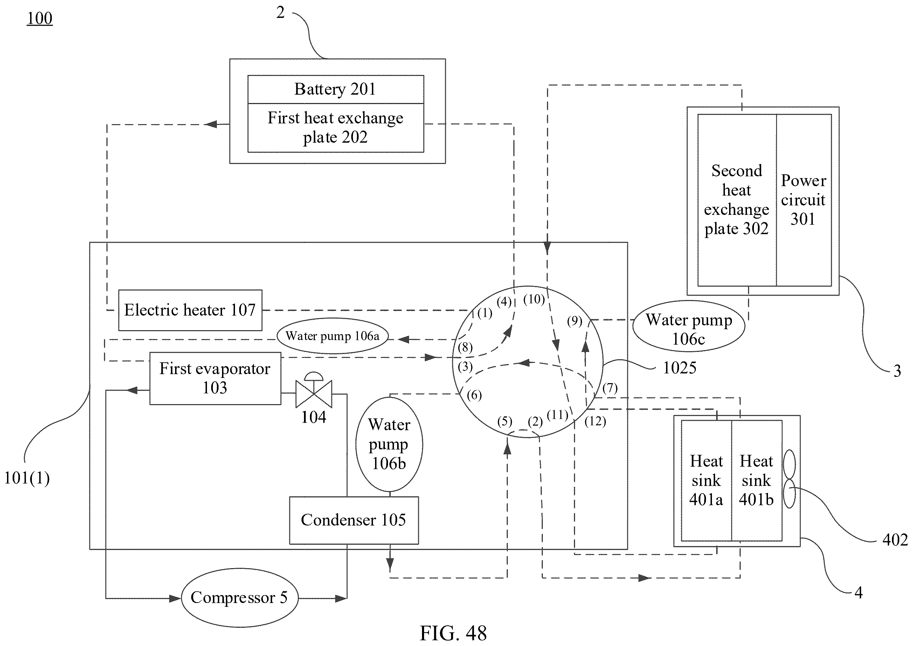

When an ambient temperature is high (for example, in case of a high temperature and high humidity in summer), refer to FIG. 48. FIG. 48 is a diagram of a circulation loop of the energy storage device 100 shown in FIG. 47 in this operating mode. FIG. 48 shows four circulation loops in this operating mode.

A first circulation loop includes a compressor 5, a condenser 105, a first throttle valve 104, and a first evaporator 103 that are sequentially communicated through a refrigerant pipe. In this case, the first circulation loop is a refrigerant circulation loop. In this case, when a refrigerant flows in the circulation loop, the first evaporator 103 may be at a low temperature.

In a second circulation loop, the 12-way valve 1025 connects a path between a first heat exchange plate 202 and the first evaporator 103, so that the first heat exchange plate 202, an electric heater 107, a water pump 106a, and the first evaporator 103 are sequentially communicated through a coolant channel. Because a temperature of the first evaporator 103 is low in this case, the first heat exchange plate 202 may be cooled by exchanging heat between a coolant flowing in the circulation loop and the first evaporator 103, to dissipate heat for a battery.

In a third circulation loop, the 12-way valve 1025 connects a coolant path between a second heat exchange plate 302 and the heat sink 401a. It may be understood that, to enable a coolant to flow between the second heat exchange plate 302 and the heat sink 401a, as shown in FIG. 48, a water pump 106c may be disposed in a path connecting the second heat exchange plate 302 to the heat sink 401a, so that the second heat exchange plate 302, the heat sink 401a, and the water pump 106c are sequentially communicated through a coolant channel. In this case, when a coolant flows in the circulation loop, the heat sink 401a may cool the second heat exchange plate 302, to cool the second heat exchange plate 302, so as to dissipate heat for a power circuit 301.

In a fourth circulation loop, the 12-way valve 1025 connects a path between the condenser 105 and the heat sink 401b, so that the condenser 105, a water pump 106b, and the heat sink 401 are sequentially communicated through a coolant channel. In this case, when a coolant flows in the circulation loop, the heat sink 401 may cool the condenser 105.

It should be noted that, in the operating mode shown in FIG. 48, the electric heater 107 is in an off state.

In addition, in another possible embodiment, the first heat exchange plate 202 may also be cooled via the heat sink 401a. For example, an interface 12 of the 12-way valve 1025 may be connected to an interface 4, and an interface 1 may be connected to an interface 11. In this case, the first heat exchange plate 202, the electric heater 107, and the heat sink 401a are sequentially communicated through a coolant pipe to form a circulation loop, so that a coolant can circulate between the first heat exchange plate 202 and the heat sink 401a, to dissipate heat for the first heat exchange plate 202 via the heat sink 401a.

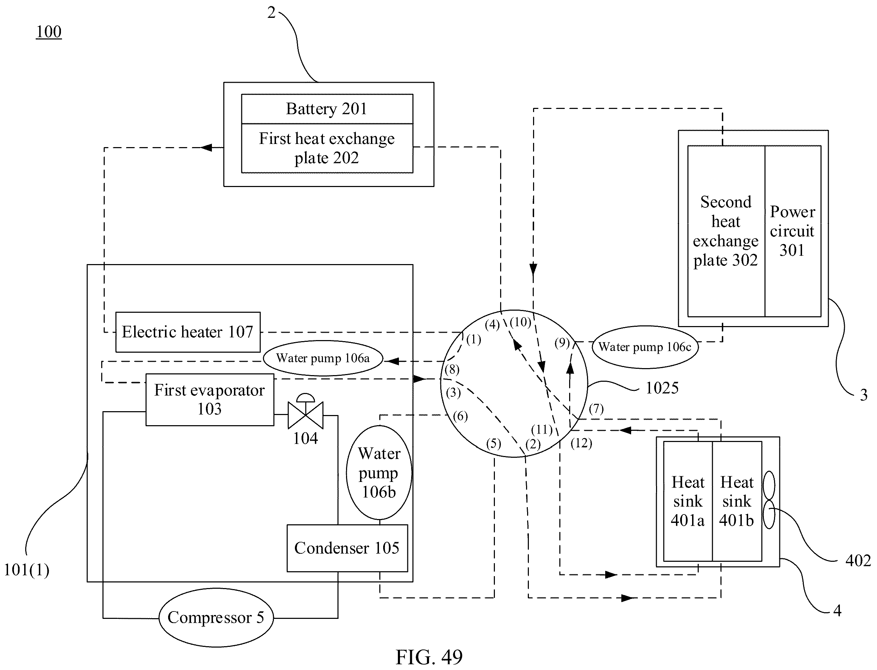

In addition, refer to FIG. 49. FIG. 49 shows an operating mode of the energy storage device 100 corresponding to a case in which an ambient temperature is temperate (for example, in case of spring or autumn).

In this operating mode, the 12-way valve 1025 connects a coolant path between a first heat exchange plate 202 and the heat sink 401b, so that the first heat exchange plate 202, an electric heater 107, a water pump 106a, and the heat sink 401b are sequentially communicated through a coolant channel to form a circulation loop. In this case, when a coolant flows in the circulation loop, the heat sink 401b may cool the first heat exchange plate 202, to dissipate heat for a battery 201.

In addition, the 12-way valve 1025 further connects a coolant path between a second heat exchange plate 302 and the heat sink 401a, so that the second heat exchange plate 302, the heat sink 401a, and a water pump 106c are sequentially communicated through a coolant channel to form a circulation loop. In this case, when a coolant flows in the circulation loop, the heat sink 401a may cool the second heat exchange plate 302, to dissipate heat for a power circuit 301.

It should be noted that, in the operating mode shown in FIG. 49, the electric heater 107 is in an off state. In addition, when the ambient temperature is temperate, heat dissipation requirements of the battery 201 and the power circuit 301 can be met only via the heat sink 401a and the heat sink 401b. Therefore, in this operating mode, a compressor 5, a first evaporator 103, and a condenser 105 are all in an off state.

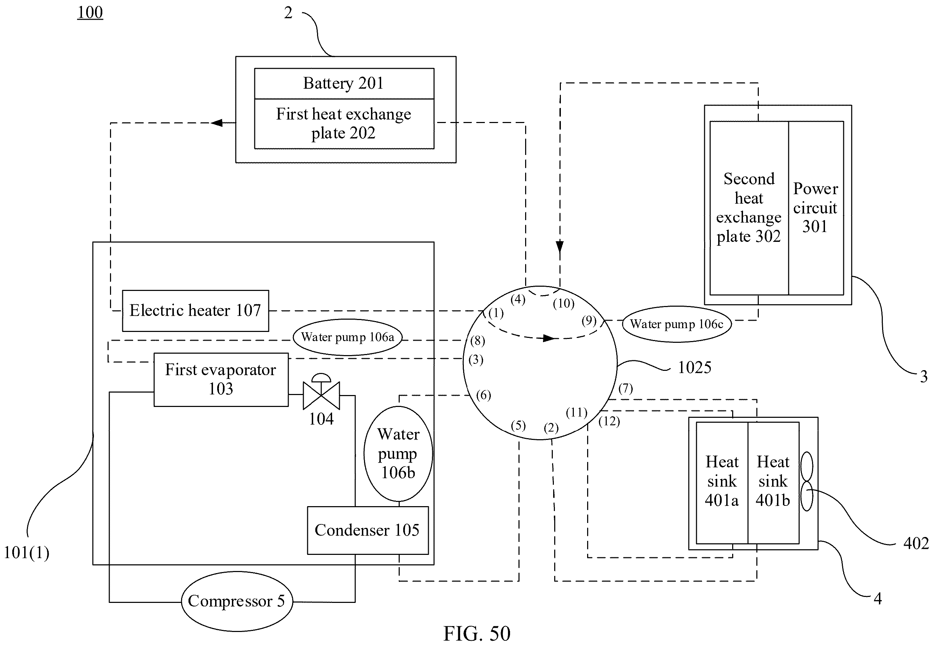

FIG. 50 shows an operating mode of the energy storage device corresponding to a case in which an ambient temperature is low (for example, in case of a low temperature in winter).

In an operating process of the energy storage device 100, a power circuit 301 always generates a large amount of heat. However, in case of a low temperature in winter, to ensure charging and discharging performance of a battery 201, the battery 201 needs to be heated. In view of this, it may be considered that the heat generated by the power circuit 301 is used for heating the battery 201. During specific implementation, as shown in FIG. 50, the 12-way valve 1025 connects a coolant path between a first heat exchange plate 202 and a second heat exchange plate 302, so that the first heat exchange plate 202, an electric heater 107, a water pump 106c, and the second heat exchange plate 302 are sequentially communicated through a coolant channel to form a circulation loop. In this case, when a coolant flows in the circulation loop, the heat generated by the power circuit 301 may be transferred to the first heat exchange plate 202, to heat the battery 201, so as to efficiently use the heat. In this operating mode, the electric heater 107 may be turned on or off as required. Details are not described herein.

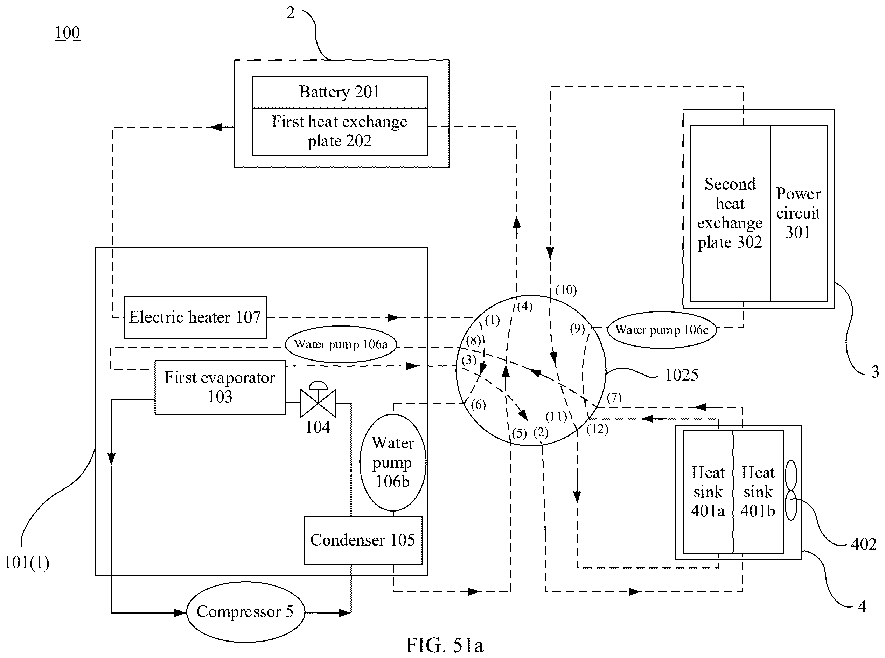

In the operating mode shown in FIG. 50, a compressor 5, a first evaporator 103, and a condenser 105 are all in an off state. In actual application, as shown in FIG. 51a, both a first throttle valve 104 and a compressor 5 may be set to an on state as required, that is, the condenser 105 has a high temperature according to a working principle of a heat pump, to heat a first heat exchange plate 202 via the condenser 105. During specific implementation, FIG. 51a shows four circulation loops.

A first circulation loop includes the compressor 5, the condenser 105, the first throttle valve 104, and a first evaporator 103 that are sequentially communicated through a refrigerant pipe. In this case, when a refrigerant flows in the circulation loop, the condenser 105 may have a high temperature.

In a second circulation loop, the 12-way valve 1025 connects a coolant path between the first heat exchange plate 202, the condenser 105, and a second heat exchange plate 302, so that the first heat exchange plate 202, an electric heater 107, a water pump 106b, and the condenser 105 are sequentially communicated through a coolant channel. In this case, when a coolant flows in the circulation loop, heat generated by the condenser 105 all may be transferred to the first heat exchange plate 202, to heat a battery 201.

In a third circulation loop, the 12-way valve 1025 connects a coolant path between the first evaporator 103 and the heat sink 401b, so that the first evaporator 103, the heat sink 401b, and a water pump 106a are sequentially communicated through a coolant channel. It may be understood that, in a heat pump mode, heat in an environment may be transferred to the condenser 105 via the first evaporator 103. Therefore, a temperature of the first evaporator 103 is low. To dissipate cold of the first evaporator 103, the temperature of the first evaporator 103 is increased. In one aspect, the electric heater 107 may be used to increase the temperature of the first evaporator 103. In another aspect, heat of the first evaporator 103 may be increased through heat exchange between the heat sink 401 and the first evaporator 103.

In a fourth circulation loop, the 12-way valve 1025 connects a coolant path between the second heat exchange plate 302 and the heat sink 401a, so that the second heat exchange plate 302, the heat sink 401a, and a water pump 106c are sequentially communicated through a coolant channel. In this case, when a coolant flows in the circulation loop, the heat sink 401a may cool the coolant, to cool the second heat exchange plate 302, so as to dissipate heat for the power circuit 301.

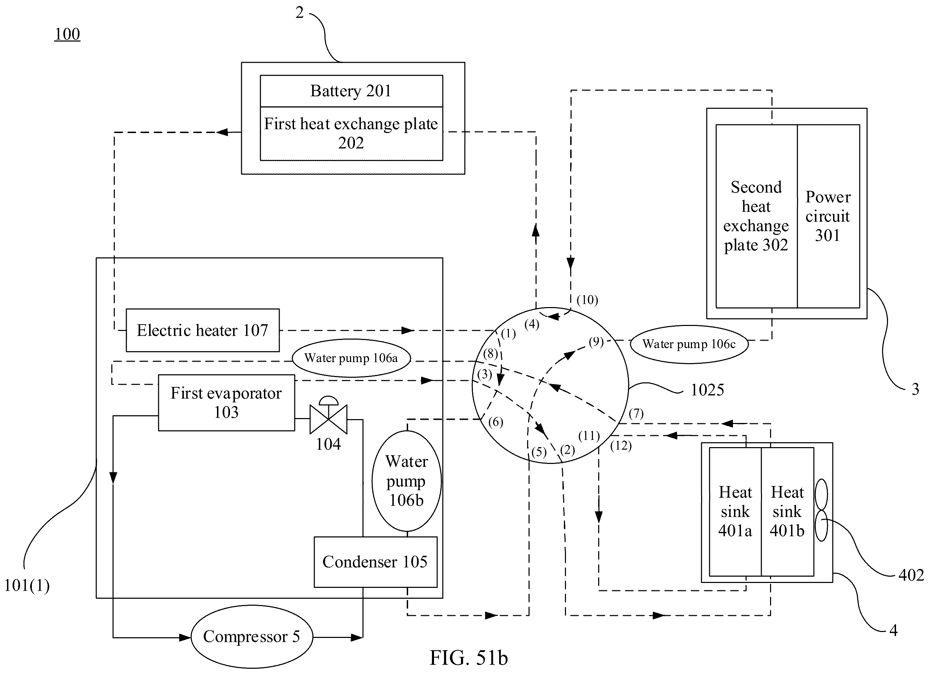

When an energy storage system 100 operates in the heat pump mode, another possible circulation loop may be further formed, provided that the first heat exchange plate 202 and the condenser 105 are connected in series. For example, refer to FIG. 51b. In FIG. 51b, a first heat exchange plate 202, an electric heater 107, a water pump 106a, and a condenser 105 are sequentially communicated through a coolant channel. In this case, when a coolant flows in the circulation loop, heat generated by the condenser 105 all may be transferred to the first heat exchange plate 202, to heat a battery.

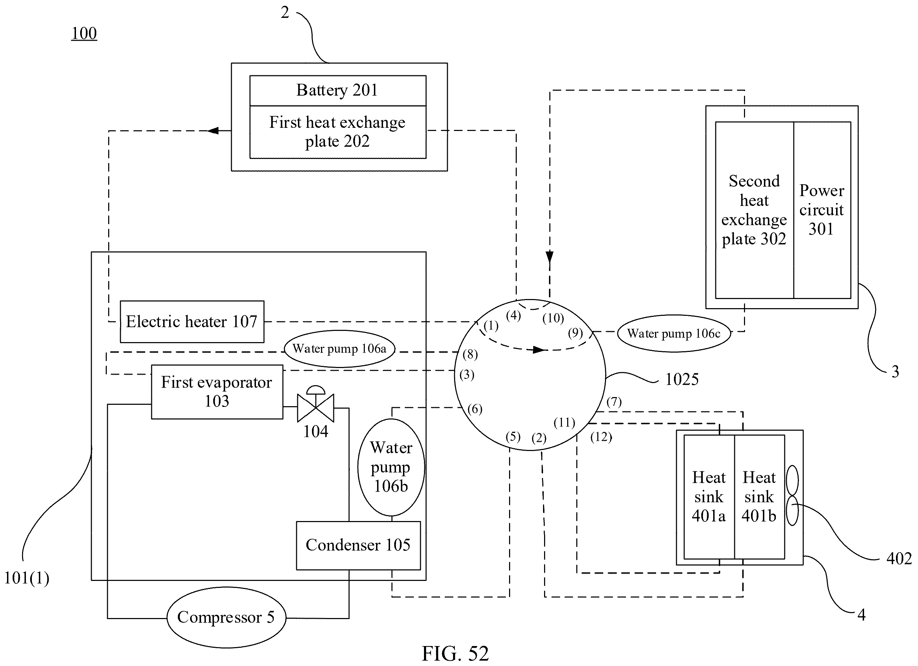

FIG. 52 shows an operating mode of the energy storage device 100 corresponding to a case in which an ambient temperature is low (for example, in case of a low temperature in winter) and neither heat generated by a power circuit 301 nor heat generated by a condenser 105 in a heat pump mode can meet a heating requirement of a battery 201. In this mode, an electric heater 107 is turned on, and a first heat exchange plate 202, the electric heater 107, a water pump 106c, and a second heat exchange plate 302 are sequentially communicated through a coolant pipe to form a circulation loop, so that the electric heater 107 and the second heat exchange plate 302 heat a coolant flowing in the circulation loop, to heat the battery 201.

It should be noted that, in the operating mode shown in FIG. 52, a compressor 5, a first evaporator 103, and the condenser 105 are all in an off state.

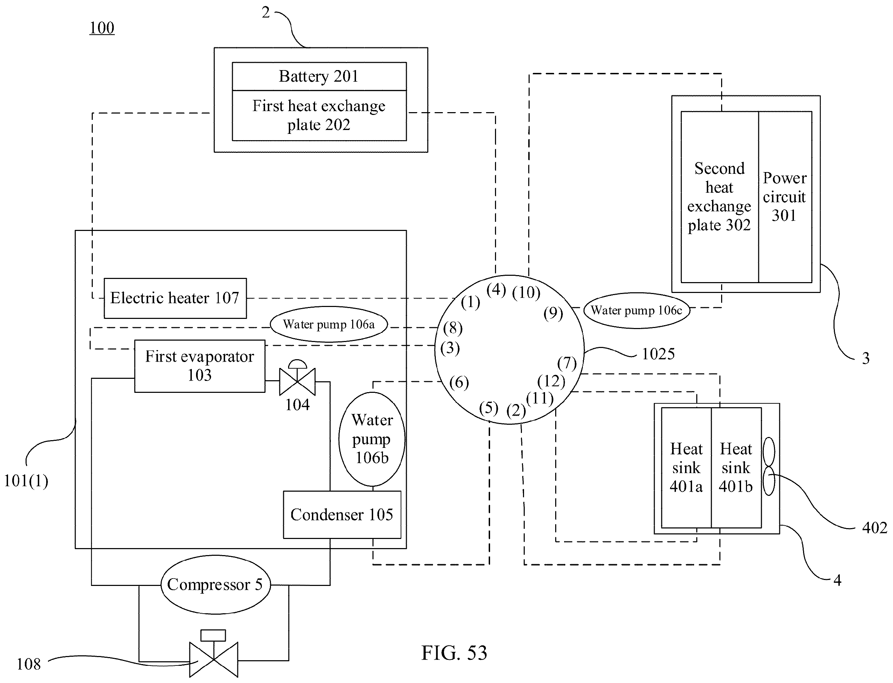

When the energy storage device 100 operates in a working condition with a low ambient temperature, in addition to heating the battery via the electric heater 107, another possible manner may be used. For example, refer to FIG. 53. FIG. 53 is a diagram of another specific structure of an energy storage device 100 according to an embodiment of this application. Compared with the energy storage device 100 shown in FIG. 47, in the energy storage device 100 in FIG. 53, a bypass valve 108 is added to a compressor 5. The bypass valve 108 and the compressor 5 are disposed in parallel. The bypass valve 108 may be, for example, a solenoid valve. In this way, when the compressor 5 operates in a heating state, the bypass valve 108 is turned on, to reduce pressure of the compressor 5, so as to heat a battery 201 through heat generated by the compressor 5. When the compressor operates in a refrigerating state, the bypass valve 108 is turned off. It may be understood that, when the heat generated by the compressor 5 can meet a heating requirement of the battery, an electric heater 107 in the energy storage device 100 may be removed. This helps improve energy efficiency of the energy storage device 100.

For another possible operating mode of the energy storage device 100 provided in FIG. 53, refer to FIG. 48 to FIG. 50, FIG. 51a, FIG. 51b, and FIG. 52. Details are not described herein again.

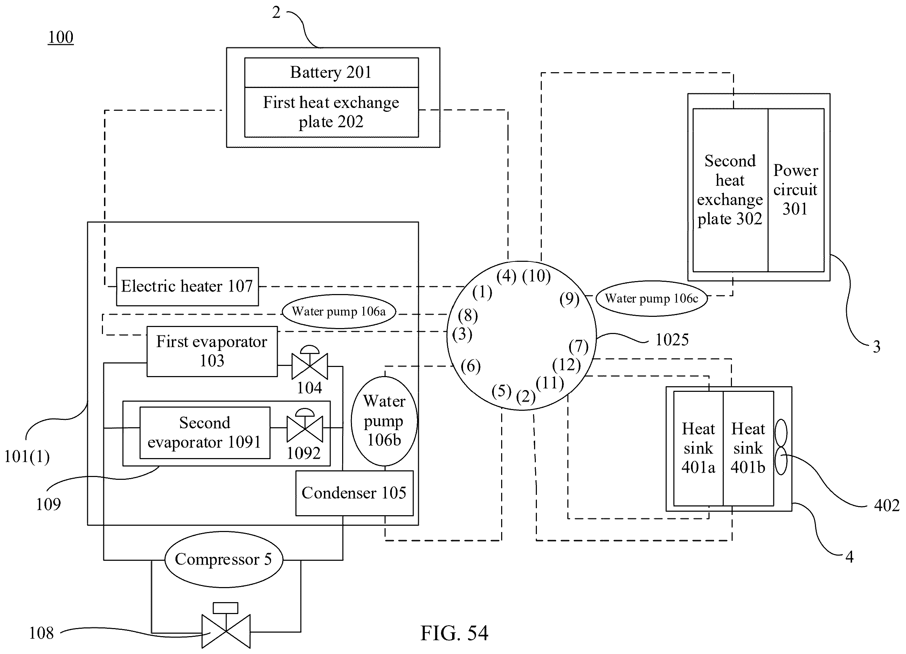

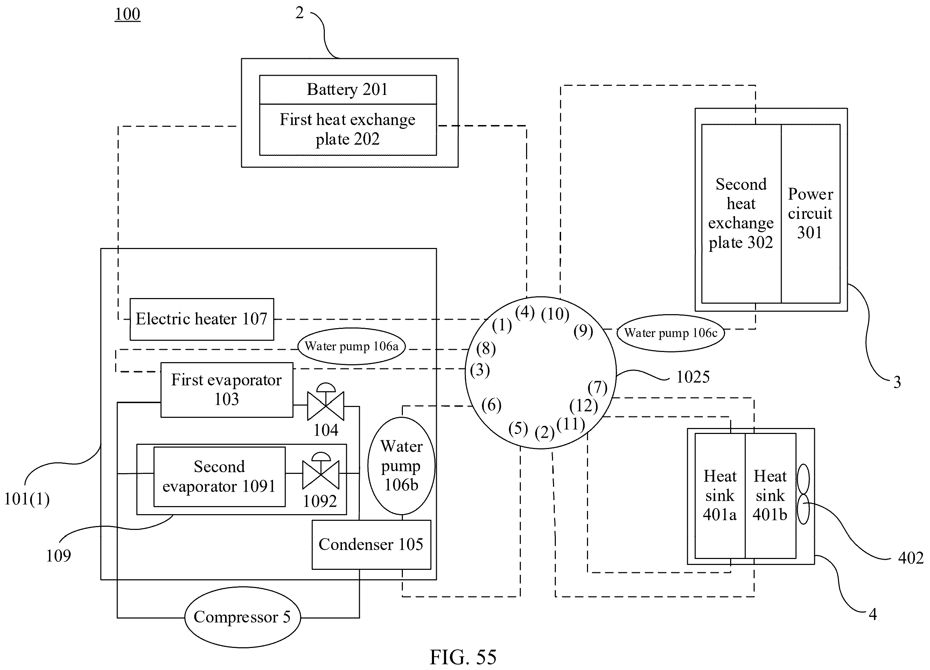

FIG. 54 is a diagram of another specific structure of an energy storage device 100 according to an embodiment of this application. Compared with the energy storage device 100 shown in FIG. 53, in the energy storage device 100 shown in FIG. 55, a dehumidification module 109 is further disposed in a heat management module 1. The dehumidification module 109 may be disposed with reference to the dehumidification module 109 in any one of the foregoing embodiments. Details are not described herein again.

In the energy storage device 100 shown in FIG. 54, a compressor 5, the dehumidification module 109, and a condenser 105 are sequentially communicated through a refrigerant pipe to form a dehumidification circulation loop. Because a temperature of a second evaporator 1091 is low when a refrigerant circulates in the circulation loop formed by the compressor 5, the dehumidification module 109, and the condenser 105, water vapor in air condenses into water drops when ambient humidity is high and the temperature of the second evaporator 1091 is lower than a dew point temperature of the air, and the water drops are discharged through a drainpipe, so as to reduce humidity in the energy storage device 100.

Because the temperature of the second evaporator 1091 is low, the second evaporator 1091 may further reduce a temperature of air in the energy storage device 100, so that a battery is in a low temperature environment. In addition, the dehumidification module 109 may further include a fan. The fan may be disposed near the second evaporator 1091, to accelerate a circulation speed of air flowing through the second evaporator 1091, so as to reduce the temperature of the second evaporator 1091. This helps improve dehumidification effect of the dehumidification module 109.

In the energy storage device 100 provided in FIG. 54, a circulation loop formed by a first heat exchange plate 202 and a heat sink 401 can effectively reduce a temperature of a surface of the battery. In addition, the temperature of the second evaporator 1091 in the dehumidification module 109 is low. Therefore, the temperature of the air in the energy storage device 100 can be further effectively reduced, thereby effectively improving heat dissipation effect on the battery 201. In addition, the second evaporator 1091 in the dehumidification module 109 can further condense water vapor in the energy storage device 100, so that humidity of the air in the energy storage device 100 can be reduced, and the battery 201 can operate in a dry environment. This helps ensure reliability and a service life of the battery 201.

It may be understood that, in the embodiment provided in FIG. 54, a combination of the second evaporator 1091 and a second throttle valve 1092 and a combination of a first evaporator 103 and a first throttle valve 104 are disposed in parallel, so that the two combinations do not affect each other. Specifically, during dehumidification, the second throttle valve 1092 may be turned on and the first throttle valve 104 may be turned off, so that the refrigerant may circulate in a circulation loop formed by the compressor 5, the condenser 105, the second throttle valve 1092, and the second evaporator 1091, and the second evaporator 1091 has a low temperature, to implement a dehumidification function. In addition, both the first throttle valve 104 and the second throttle valve 1092 may be turned on, that is, the refrigerant may circulate in a circulation loop formed by the compressor 5, the condenser 105, the first throttle valve 104, and the first evaporator 103, and may further circulate in the circulation loop formed by the compressor 5, the condenser 105, the second throttle valve 1092, and the second evaporator 1091. Therefore, both the first evaporator 103 and the second evaporator 1091 have a low temperature, that is, a function of cooling the battery can be implemented via the first evaporator 103, and a dehumidification function can be implemented via the second evaporator 1091. Certainly, during specific implementation, the first throttle valve 104 may be turned on and the second throttle valve 1092 may be turned off, so that the refrigerant may circulate in the circulation loop formed by the compressor 5, the condenser 105, the first throttle valve 104, and the first evaporator 103, and the first evaporator 103 has a low temperature, to implement the function of cooling the battery 201.

In summary, in the energy storage device 100 provided in FIG. 54 of this application, the first evaporator 103 and the second evaporator 1091 in the heat management module 1 are decoupled from each other, so that mutual impact between the first evaporator 103 and the second evaporator 1091 can be avoided. In addition, the combination of the first evaporator 103 and the first throttle valve 104 and the combination of the second evaporator 1091 and the second throttle valve 1092 share the same condenser 105 and compressor 5, thereby effectively reducing a quantity of used parts and components. This helps reduce a size and costs of an adjustment apparatus, and facilitates implementation of an integrated design. Certainly, in another possible embodiment, the first evaporator 103 and the second evaporator 1091 may alternatively be disposed in series, so that the first evaporator 103 and the second evaporator 1091 may share one throttle valve. For example, only the first throttle valve 104 or the second throttle valve 1092 may be disposed, so that a quantity of used parts and components can be reduced. This helps reduce manufacturing costs.

For another possible operating mode of the energy storage device 100 provided in FIG. 54, refer to FIG. 48 to FIG. 50, FIG. 51a, FIG. 51b, FIG. 52, and FIG. 53. Details are not described herein again.

It should be noted that, in this embodiment of this application, the dehumidification module 109 is disposed without depending on bypass of the compressor 5, that is, the dehumidification module 109 and a bypass valve 108 at the compressor 5 may not be disposed together. For example, refer to FIG. 55. In an energy storage device 100 shown in FIG. 55, no bypass valve 108 is disposed at a compressor 5, and a dehumidification module 109 is disposed in a heat management system. This can still enable the energy storage device 100 to operate in a plurality of modes, to efficiently regulate and control a temperature of a battery. For an operating mode of the energy storage device 100 shown in FIG. 55, refer to FIG. 48 to FIG. 50, FIG. 51a, FIG. 51b, and FIG. 52 to FIG. 54. Details are not described herein again.

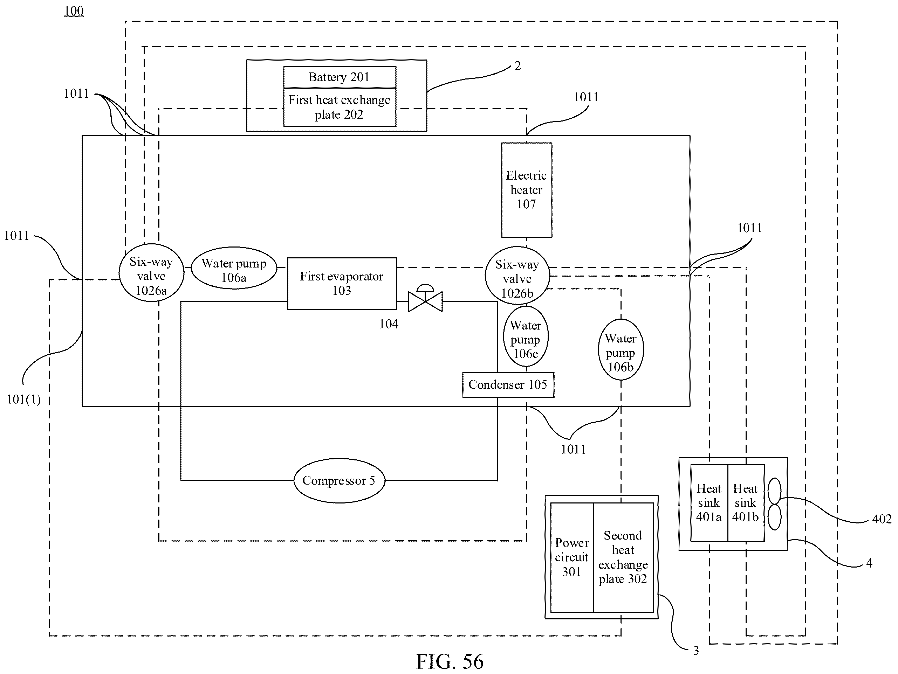

It may be understood from the foregoing description of the manner of disposing the valve body assembly of the heat management module 1 in this application that, in this embodiment of this application, the 12-way valve 1025 may be replaced with two six-way valves. During specific implementation, refer to FIG. 56. FIG. 56 is a diagram of another specific structure of an energy storage device 100 according to an embodiment of this application. A heat management module 1 of the energy storage device 100 includes two six-way valves, and each six-way valve includes six valve interfaces. For ease of distinguishing, the two six-way valves may be denoted as a six-way valve 1026a and a six-way valve 1026b respectively. A first evaporator 103 is connected between the six-way valve 1026a and the six-way valve 1026b, a condenser 105 is connected between the six-way valve 1026b and one coolant interface 1011, and other valve interfaces of the two six-way valves each are connected to one coolant interface 1011. In this case, the six-way valve 1026a and the six-way valve 1026b may be configured to connect or disconnect a path between a first heat exchange plate 202, a second heat exchange plate 302, a heat sink 401a, a heat sink 401b, the condenser 105, and the first evaporator 103.

In actual application, a status of connection between different coolant interfaces may be effectively adjusted via the six-way valve 1026a and the six-way valve 1026b according to an actual requirement, so that the energy storage device 100 shown in FIG. 56 can operate in a corresponding operating mode. For implementations of operating modes of the energy storage device 100 shown in FIG. 56, refer to FIG. 48 to FIG. 50, FIG. 51a, FIG. 51b, FIG. 52, and FIG. 53. Details are not described herein again.

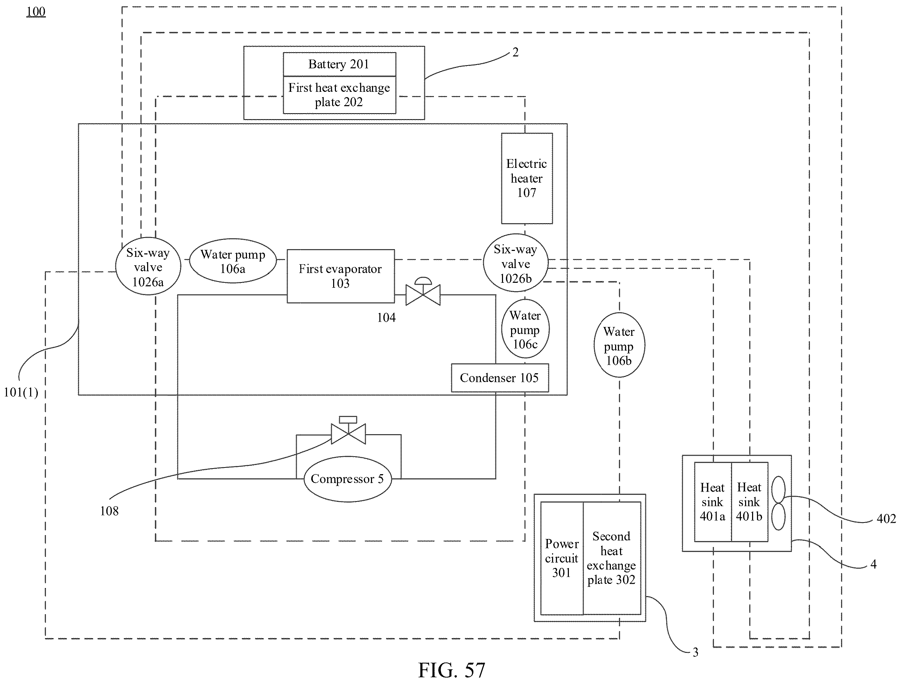

FIG. 57 is a diagram of another specific structure of an energy storage device 100 according to an embodiment of this application. Compared with the energy storage device 100 shown in FIG. 56, in the energy storage device 100 in FIG. 57, a bypass valve 108 is added to a compressor 5. The bypass valve 108 and the compressor 5 are disposed in parallel. The bypass valve 108 may be, for example, a solenoid valve. In this way, when the compressor 5 operates in a heating state, the bypass valve 108 is turned on, to reduce pressure of the compressor 5, so as to heat a battery 201 through heat generated by the compressor 5. When the compressor operates in a refrigerating state, the bypass valve 108 is turned off. It may be understood that, when the heat generated by the compressor 5 can meet a heating requirement of the battery, an electric heater 107 in the energy storage device 100 may be removed. This helps improve energy efficiency of the energy storage device 100.

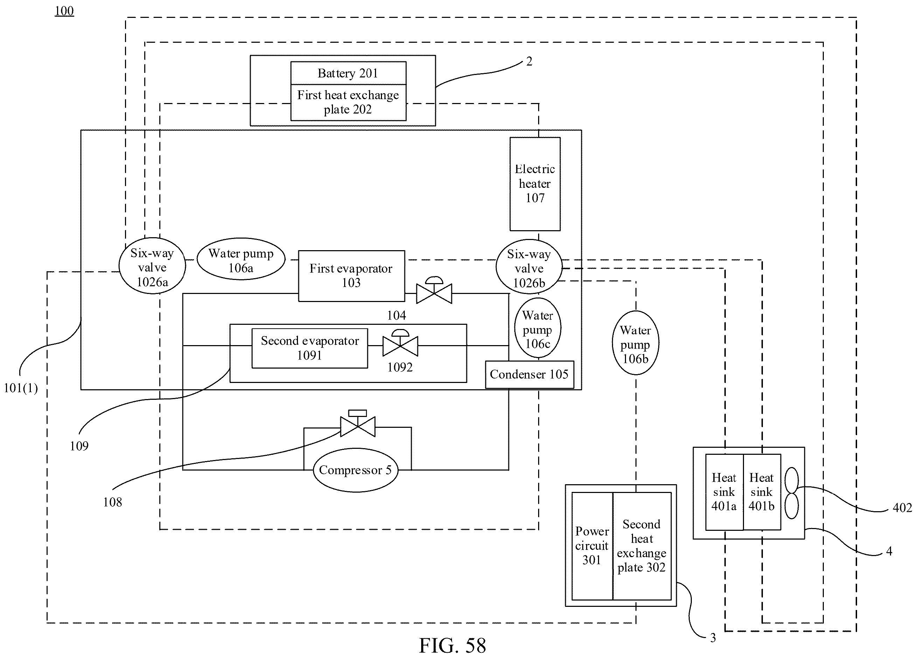

In addition, refer to FIG. 58. FIG. 58 is a diagram of another specific structure of an energy storage device 100 according to an embodiment of this application. Compared with the energy storage device 100 shown in FIG. 57, in the energy storage device 100 shown in FIG. 58, a dehumidification module 109 is further disposed in a heat management module 1. The dehumidification module 109 may be disposed with reference to the dehumidification module 109 in any one of the foregoing embodiments. Details are not described herein again.

In the energy storage device 100 shown in FIG. 58, a compressor 5, the dehumidification module 109, and a condenser 105 are sequentially communicated through a refrigerant pipe to form a dehumidification circulation loop. Because a temperature of a second evaporator 1091 is low when a refrigerant circulates in the circulation loop formed by the compressor 5, the dehumidification module 109, and the condenser 105, water vapor in air condenses into water drops when ambient humidity is high and the temperature of the second evaporator 1091 is lower than a dew point temperature of the air, and the water drops are discharged through a drainpipe, so as to reduce humidity in the energy storage device 100.

Because the temperature of the second evaporator 1091 is low, the second evaporator 1091 may further reduce a temperature of air in the energy storage device 100, so that a battery is in a low temperature environment. In addition, the dehumidification module 109 may further include a fan. The fan may be disposed near the second evaporator 1091, to accelerate a circulation speed of air flowing through the second evaporator 1091, so as to reduce the temperature of the second evaporator 1091. This helps improve dehumidification effect of the dehumidification module 109.

In the energy storage device 100 provided in FIG. 58, a circulation loop formed by a first heat exchange plate 202 and a heat sink 401 can effectively reduce a temperature of a surface of the battery. In addition, the temperature of the second evaporator 1091 in the dehumidification module 109 is low. Therefore, the temperature of the air in the energy storage device 100 can be further effectively reduced, thereby effectively improving heat dissipation effect on the battery 201. In addition, the second evaporator 1091 in the dehumidification module 109 can further condense water vapor in the energy storage device 100, so that humidity of the air in the energy storage device 100 can be reduced, and the battery 201 can operate in a dry environment. This helps ensure reliability and a service life of the battery 201.

It may be understood that, in the embodiment provided in FIG. 58, a combination of the second evaporator 1091 and a second throttle valve 1092 and a combination of a first evaporator 103 and a first throttle valve 104 are disposed in parallel, so that the two combinations do not affect each other. Specifically, during dehumidification, the second throttle valve 1092 may be turned on and the first throttle valve 104 may be turned off, so that the refrigerant may circulate in a circulation loop formed by the compressor 5, the condenser 105, the second throttle valve 1092, and the second evaporator 1091, and the second evaporator 1091 has a low temperature, to implement a dehumidification function. In addition, both the first throttle valve 104 and the second throttle valve 1092 may be turned on, that is, the refrigerant may circulate in a circulation loop formed by the compressor 5, the condenser 105, the first throttle valve 104, and the first evaporator 103, and may further circulate in the circulation loop formed by the compressor 5, the condenser 105, the second throttle valve 1092, and the second evaporator 1091. Therefore, both the first evaporator 103 and the second evaporator 1091 have a low temperature, that is, a function of cooling the battery can be implemented via the first evaporator 103, and a dehumidification function can be implemented via the second evaporator 1091. Certainly, during specific implementation, the first throttle valve 104 may be turned on and the second throttle valve 1092 may be turned off, so that the refrigerant may circulate in the circulation loop formed by the compressor 5, the condenser 105, the first throttle valve 104, and the first evaporator 103, and the first evaporator 103 has a low temperature, to implement the function of cooling the battery 201.

In summary, in the energy storage device 100 provided in FIG. 58 of this application, the first evaporator 103 and the second evaporator 1091 in the heat management module 1 are decoupled from each other, so that mutual impact between the first evaporator 103 and the second evaporator 1091 can be avoided. In addition, the combination of the first evaporator 103 and the first throttle valve 104 and the combination of the second evaporator 1091 and the second throttle valve 1092 share the same condenser 105 and compressor 5, thereby effectively reducing a quantity of used parts and components. This helps reduce a size and costs of an adjustment apparatus, and facilitates implementation of an integrated design. Certainly, in another possible embodiment, the first evaporator 103 and the second evaporator 1091 may alternatively be disposed in series, so that the first evaporator 103 and the second evaporator 1091 may share one throttle valve. For example, only the first throttle valve 104 or the second throttle valve 1092 may be disposed, so that a quantity of used parts and components can be reduced. This helps reduce manufacturing costs.

For another possible operating mode of the energy storage device 100 provided in FIG. 58, refer to FIG. 48 to FIG. 53. Details are not described herein again.

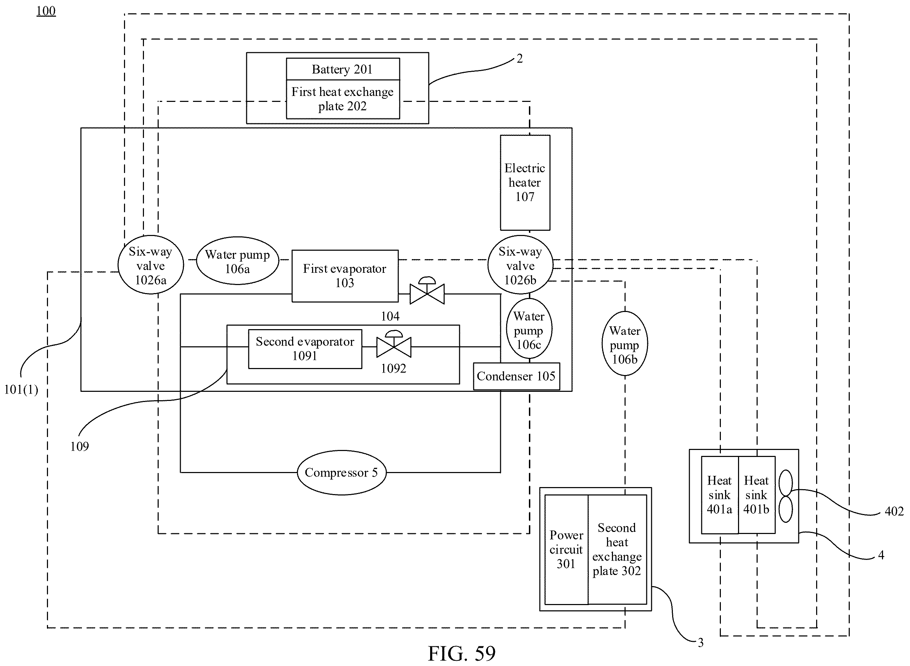

It should be noted that, in this embodiment of this application, the dehumidification module 109 is disposed without depending on bypass of the compressor 5, that is, the dehumidification module 109 and a bypass valve 108 at the compressor 5 may not be disposed together. For example, refer to FIG. 59. In an energy storage device 100 shown in FIG. 59, no bypass valve 108 is disposed at a compressor 5, and a dehumidification module 109 is disposed in a heat management system. This can still enable the energy storage device 100 to operate in a plurality of modes, to efficiently regulate and control a temperature of a battery.

In the energy storage device 100 provided in embodiments of this application, the valve body assembly 102 may be connected between the first heat exchange plate 202 and the first evaporator 103, and is configured to connect or disconnect the path between the first heat exchange plate 202 and the first evaporator 103. In this case, when the energy storage device 100 operates in a high-temperature mode, the valve body assembly 102 may connect the path between the first heat exchange plate 202 and the first evaporator 103, to cool the first heat exchange plate 202 via the first evaporator 103, so as to dissipate heat for the battery 201. The valve body assembly 102 is further connected between the first heat exchange plate 202 and the heat sink 401, and is configured to connect or disconnect the path between the first heat exchange plate 202 and the heat sink 401. In this case, when the energy storage device 100 operates in a temperate-temperature mode, the valve body assembly 102 may connect the path between the first heat exchange plate 202 and the heat sink 401, to cool the first heat exchange plate 202 via the heat sink 401, so as to dissipate heat for the battery 201. The valve body assembly 102 is further connected between the first heat exchange plate 202 and the second heat exchange plate 302, and is configured to connect or disconnect the path between the first heat exchange plate 202 and the second heat exchange plate 302. In this case, when the energy storage device 100 operates in a low-temperature mode, the valve body assembly 102 may connect the path between the first heat exchange plate 202 and the second heat exchange plate 302, to heat the first heat exchange plate 202 through the heat generated by the power circuit 301, so as to recycle heat. The valve body assembly 102 is further connected between the first heat exchange plate 202 and the condenser 105, and is configured to connect or disconnect the path between the first heat exchange plate 202 and the condenser 105. In this case, the path between the first heat exchange plate 202 and the condenser 105 may be connected via the valve body assembly 102, to heat the first heat exchange plate 202 through the heat generated by the condenser 105, so that the energy storage device operates in a heat pump mode. The valve body assembly 102 is further connected between the second heat exchange plate 302 and the heat sink 401, and is configured to connect or disconnect the path between the second heat exchange plate 302 and the heat sink 401. When the valve body assembly 102 connects the path between the second heat exchange plate 302 and the heat sink 401, the second heat exchange plate 302 may be cooled via the heat sink 401, to dissipate heat for the power circuit 301. In addition, the valve body assembly 102 is further connected between the heat sink 401 and the condenser 105, and is configured to connect or disconnect the path between the heat sink 401 and the condenser 105. When the valve body assembly 102 connects the path between the heat sink 401 and the condenser 105, the condenser 105 may be cooled via the heat sink 401. It can be learned that, in embodiments of this application, a status of connection between different coolant interfaces 1011 and a connection status between each coolant interface 1011 and the first evaporator 103 or the condenser 105 may be adaptively adjusted via the valve body assembly 102, that is, the operating mode of the energy storage device 100 may be switched, so that the energy storage device 100 can operate in a plurality of modes. In addition, when the energy storage device 100 operates in the modes, the temperature of the battery 201 can be regulated and controlled through circulating heat exchange of the coolant between modules communicated through the coolant pipe. This can effectively improve efficiency of regulating and controlling the temperature of the battery 201, thereby helping improve operating energy efficiency of the energy storage device 100.

It may be understood that, according to the energy storage device provided in the foregoing embodiments of this application, in actual application, according to an actual requirement, a quantity of valve bodies of the valve body assembly 102, a quantity of valve interfaces, and a connection status between each valve interface and a coolant interface may be adaptively adjusted, and quantities of water pumps and heat sinks and specific disposing positions of the water pumps and the heat sinks may be adaptively adjusted. It should be understood that the adaptive adjustments fall within the protection scope of this application.

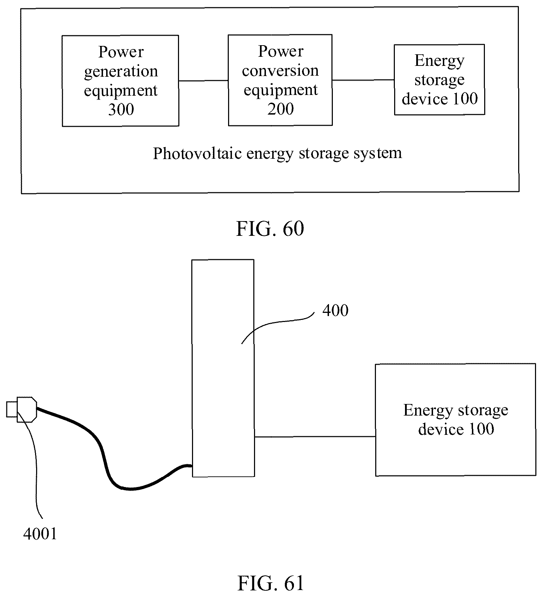

The energy storage device provided in the foregoing embodiments of this application may be used in various energy storage scenarios. FIG. 60 is a diagram of a structure of a photovoltaic energy storage system according to an embodiment of this application. The photovoltaic energy storage system may include power conversion equipment 200, power generation equipment 300, and the foregoing energy storage device 100. The power conversion equipment 200 is connected between the power generation equipment 300 and the energy storage device 100. The power generation equipment 300 is configured to store generated electric energy into a battery of the energy storage device 100 via the power conversion equipment 200. The photovoltaic energy storage system applies the energy storage device 100 provided in the foregoing embodiments, so that operating safety of the photovoltaic energy storage system can be effectively improved.

In addition, the energy storage device 100 provided in embodiments of this application may be further used in a charging network. For example, refer to FIG. 61. FIG. 61 is a diagram of a structure of a charging network according to an embodiment of this application. The charging network includes a charging pile 400 and the foregoing energy storage device 100. The charging pile 400 is electrically connected to a battery in the energy storage device 100 through a cable, and the battery may supply electric energy stored in the battery to the charging pile 400. The charging pile 400 has a connector 4001, and the connector 4001 may be connected to a powered device (for example, a vehicle), so as to supplement energy to the powered device. The charging network applies the energy storage device 100 provided in the foregoing embodiments, so that safety of the charging network can be effectively improved, and flexibility of deploying the charging network can be further improved.

During specific disposing, the charging network may include a plurality of charging piles 400, and each energy storage device 100 may supply electric energy to the plurality of charging piles 400, thereby effectively improving flexibility of deployment.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An energy storage device, comprising a heat management module, a battery module, a power module, and a heat sink module, wherein
the heat management module comprises a housing, and a valve body assembly, a first evaporator, and a condenser that are disposed in the housing, the housing comprises a plurality of coolant interfaces, two coolant ports of the first evaporator are connected to the valve body assembly, and two coolant ports of the condenser are connected between the valve body assembly and one coolant interface;
the battery module comprises a first heat exchange plate, and the first heat exchange plate is connected to the valve body assembly through two coolant interfaces;
the power module comprises a second heat exchange plate, the second heat exchange plate is connected to the valve body assembly through two coolant interfaces, and the two coolant interfaces connected to the second heat exchange plate are different from the two coolant interfaces connected to the first heat exchange plate, or the second heat exchange plate and the first heat exchange plate are connected in series and connected between two coolant interfaces; and
the heat sink module comprises a heat sink, the heat sink is connected to the valve body assembly through two coolant interfaces, the two coolant interfaces connected to the heat sink are different from the two coolant interfaces connected to the first heat exchange plate, and are different from the two coolant interfaces connected to the second heat exchange plate.

2. The energy storage device according to claim 1, wherein the heat management module further comprises a first throttle valve, and the first throttle valve is disposed in the housing; the energy storage device further comprises a compressor, and the compressor is disposed in the housing; or the compressor is disposed outside the housing, the housing further comprises two refrigerant interfaces, and the compressor is connected between the two refrigerant interfaces; and the compressor, the first evaporator, the first throttle valve, and the condenser are sequentially connected.

3. The energy storage device according to claim 2, wherein the heat management module further comprises a dehumidification module, and the dehumidification module is disposed in the housing, or the dehumidification module is disposed outside the housing; and the dehumidification module comprises a second evaporator and a second throttle valve, and the compressor, the second evaporator, the second throttle valve, and the condenser are sequentially connected.

4. The energy storage device according to claim 2 or 3, wherein the energy storage device further comprises a bypass valve, and the bypass valve and the compressor are disposed in parallel.

5. The energy storage device according to any one of claims 1 to 4, wherein the valve body assembly is connected between the first heat exchange plate and the first evaporator, and is configured to connect or disconnect a path between the first heat exchange plate and the first evaporator.

6. The energy storage device according to any one of claims 1 to 5, wherein the valve body assembly is further connected between the first heat exchange plate and the heat sink, and is configured to connect or disconnect a path between the first heat exchange plate and the heat sink.

7. The energy storage device according to any one of claims 1 to 6, wherein the valve body assembly is further connected between the first heat exchange plate and the second heat exchange plate, and is configured to connect or disconnect a path between the first heat exchange plate and the second heat exchange plate.

8. The energy storage device according to any one of claims 1 to 7, wherein the valve body assembly is further connected between the first heat exchange plate and the condenser, and is configured to connect or disconnect a path between the first heat exchange plate and the condenser.

9. The energy storage device according to any one of claims 1 to 8, wherein the valve body assembly is further connected between the second heat exchange plate and the heat sink, and is configured to connect or disconnect a path between the second heat exchange plate and the heat sink.

10. The energy storage device according to any one of claims 1 to 9, wherein the valve body assembly is further connected between the heat sink and the condenser, and is configured to connect or disconnect a path between the heat sink and the condenser.

11. The energy storage device according to any one of claims 1 to 10, wherein the heat management module further comprises an electric heater, and the electric heater is connected in series to a path connected to the first heat exchange plate.

12. The energy storage device according to any one of claims 1 to 11, wherein the valve body assembly comprises one valve body, the valve body comprises a plurality of valve interfaces, and each valve interface is configured to connect to the first evaporator, the condenser, or at least one coolant interface.

13. The energy storage device according to any one of claims 1 to 12, wherein the valve body assembly comprises at least two valve bodies, each valve body comprises a plurality of valve interfaces, and each valve interface is configured to connect to the first evaporator, the condenser, or at least one coolant interface.

14. A photovoltaic energy storage system, comprising power generation equipment, power conversion equipment, and the energy storage device according to any one of claims 1 to 13, wherein the power conversion equipment is connected between the power generation equipment and the energy storage device, and the power generation equipment is configured to store generated electric energy into a battery of the energy storage device via the power conversion equipment.

15. A charging network, comprising a charging pile and the energy storage device according to any one of claims 1 to 13, wherein the charging pile is electrically connected to the energy storage device, and the energy storage device is configured to supply electric energy to the charging pile.
